# EUROPEAN PATENT APPLICATION

(11) **EP 2 182 039 A2**
(43) Date of publication of application: **05.05.2010**
(21) Application number: 09156591.1
(22) Date of filing: 30.03.2009
(51) Int. Cl.: C09K 11/06

(54) **Aromatic electroluminescent compounds and organic electroluminescent device using the same**

(30) Priority: 30.10.2008 KR 20080107256
(71) Applicant: Gracel Display Inc., Seoul 133-833 (KR)
(72) Inventor: Yoon, Seung Soo, 135-884 Seoul (KR); Kim, Sung Min, 157-886 Seoul (KR); Kim, Bong Ok, 135-090 Seoul (KR); Kwon, Hyuck Joo, 130-100 Seoul (KR); Cho, Young Jun, 136-060 Seoul (KR)
(74) Representative: Kent, Venetia Katherine

(57) **Abstract**

Provided are novel organic electroluminescent compounds, and organic electroluminescent devices and organic solar cells comprising the same. Specifically, the organic electroluminescent compounds according to the invention are **characterized in that** they are represented by Chemical Formula (1) : 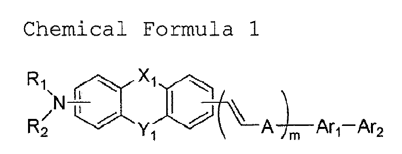 wherein, A represents a chemical bond, (C6-C60)arylene or (C2-C60)heteroarylene; provided that total number of carbon atoms in 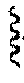 -Ar₁-Ar₂ is from 19 to 60.

The organic electroluminescent compounds according to the present invention exhibit high luminous efficiency in blue color, and excellent life property of the material, so that OLED's having very good operation life can be manufactured therefrom.

## Description

### FIELD OF THE INVENTION

The present invention relates to novel organic electroluminescent compounds, and organic electroluminescent devices and organic solar cells comprising the same. More specifically, the invention relates to novel organic electroluminescent compounds to be employed as blue electroluminescent material, and organic electroluminescent devices employing the same as dopant.

### BACKGROUND OF THE INVENTION

Among display devices, electroluminescence devices (EL devices) are self-luminescent display devices showing the advantage of wide angle of view, excellent contrast and rapid response rate. Eastman Kodak developed in 1987 an organic electroluminescent device which employs a low molecular weight aromatic diamine and an aluminum complex as material for forming an electroluminescent layer, for the first time [Appl. Phys. Lett. 51, 913, 1987].

The most important factor to determine the performances such as luminous efficiency, lifetime or the like in an organic EL device is electroluminescent material. Several properties required for such electroluminescent materials include that the material should have high fluorescent quantum yield in solid state and high mobility of electrons and holes, is not easily decomposed during vapor-deposition in vacuo, and forms uniform and stable thin film.

Organic electroluminescent materials can be generally classified into high-molecular materials and low-molecular materials. The low-molecular materials include metal complexes and thoroughly organic electroluminescent materials which do not contain metal, from the aspect of molecular structure. Such electroluminescent materials include chelate complexes such as tris(8-quinolinolato)aluminum complexes, coumarin derivatives, tetraphenylbutadiene derivatives, bis(styrylarylene) derivatives and oxadiazole derivatives. From those materials, it is reported that light emission of visible region from blue to red can be obtained; and realization of full-colored display devices is expected thereby.

In the meanwhile, for conventional blue materials, a number of materials have been developed and commercialized since the development of diphenylvinyl-biphenyl (DPVBi) (Compound a) by Idemitsu-Kosan. In addition to the blue material system from Idemitsu-Kosan, dinaphthylanthracene (DNA) (Compound b), tetra(t-butyl)perylene (Compound c) system or the like have been known. However, extensive research and development should be performed with respect to these materials. The distryl compound system of Idemitsu-Kosan, which is known to have highest efficiency up to now, has 6 lm/W of power efficiency and beneficial device lifetime of more than 30,000 hr. However, when it is applied to a full-colored display, the lifetime is merely several thousand hours, owing to decrease of color purity over operation time. In case of blue electroluminescence, it becomes advantageous from the aspect of the luminous efficiency, if the electroluminescent wavelength is shifted a little toward longer wavelength. However, it is not easy to apply the material to a display of high quality because of unsatisfactory color purity in blue. Furthermore, the research and development of such materials are urgent because of the problems in color purity, efficiency and thermal stability.

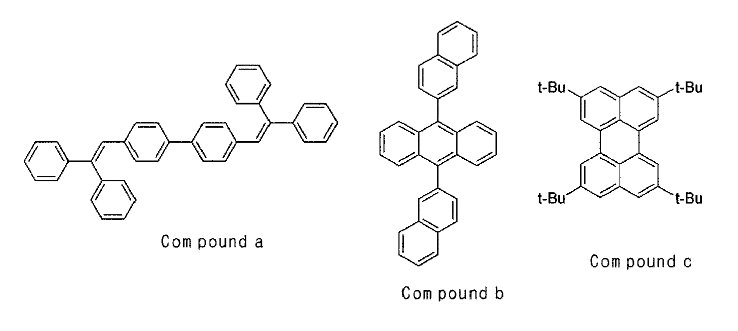

### SUMMARY OF THE INVENTION

With intensive efforts to overcome the problems of conventional techniques as described above, the present inventors have invented novel electroluminescent compounds to realize an organic electroluminescent device having excellent luminous efficiency and noticeably improved lifetime.

The object of the present invention is to provide organic electroluminescent compounds having the backbone to give more excellent electroluminescent properties, longer device life and appropriate color coordinate, as compared to those of conventional dopant materials, with overcoming disadvantages of them.

Another object of the invention is to provide organic electroluminescent devices of high efficiency and long life, which employ said organic electroluminescent compounds as electroluminescent material.

Still another object of the invention is to provide organic solar cells comprising said organic electroluminescent compounds.

The present invention relates to organic electroluminescent compounds represented by Chemical Formula (1), and organic electroluminescent devices comprising the same. Since the organic electroluminescent compounds according to the invention show good luminous efficiency and excellent color purity and life property of material, OLED's having very good operation life can be manufactured therefrom. 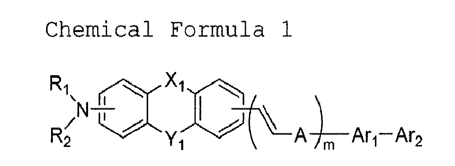 wherein,
A represents a chemical bond, (C6-C60)arylene or (C2-C60)heteroarylene;
Ar₁ represents (C6-C40)arylene, (C2-C40)heteroarylene or 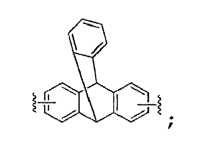 Ar₂ represents hydrogen, (C1-C20)alkyl, (C6-C20)aryl, (C2-C20)heteroaryl, (C2-C20)alkenyl, (C2-C20)alkynyl, (C3-C20)cycloalkyl or 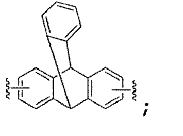 R₁ and R₂ independently represent (C1-C60)alkyl, (C6-C60)aryl, (C2-C60)heteroaryl, morpholino, thiomorpholino, piperidino, 5- or 6-membered heterocycloalkyl containing one or more heteroatom(s) selected from N, O and S, (C3-C60)cycloalkyl or adamantyl, or they may be linked via (C3-C60)alkylene or (C3-C60)alkenylene with or without a fused ring to form a fused ring, and the carbon atom of the alkylene may be substituted by O, S or NR₃;
R₃ represents hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, (C1-C60)trialkylsilyl, di(C1-C60)alkyl(C6-C60)arylsilyl or tri(C6-C60)arylsilyl;
X₁ and Y₁ independently represent a chemical bond, - (CR₄R₅)ₙ-, -N(R₆)-, -Si(R₇)(R₈)-, -O-, -S-, -Se- or - (R₉)C=C(R₁₀)-;
R₄ through R₁₀ independently represent hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, tri(C1-C60)alkylsilyl, di(C1-C60)alkyl(C6-C60)arylsilyl or tri(C6-C60)arylsilyl, or R₄ and R₅, R₇ and R₈, and R₉ and R₁₀ are linked via (C3-C12)alkylene or (C3-C12)alkenylene with or without a fused ring to form a fused ring;
the arylene or heteroarylene of A and Ar₁; the alkyl, aryl, heteroaryl, alkenyl, alkynyl, cycloalkyl of Ar₂; or the alkyl, aryl, heteroaryl, heterocycloalkyl, cycloalkyl or adamantyl of R₁ through R₁₀ may be further substituted by one or more substituent(s) selected from (C1-C60)alkyl, halo(C1-C60)alkyl, (C1-C60)alkoxy, piperidino, morpholino, thiomorpholino, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, (C1-C60)alkyl(C6-C60)aryl, tri(C1-C60)alkylsilyl, di(C1-C60)alkyl(C6-C60)arylsilyl, tri(C6-C60)arylsilyl, and substituent(s) represented by one of the following structural formulas: 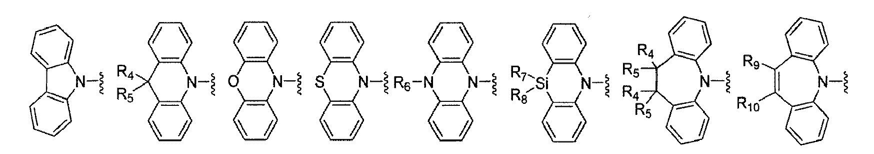 m is an integer from 1 to 3; and
n is an integer from 1 to 4;
provided that total number of carbon atoms in 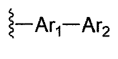 is from 19 to 60.

### BRIEF DESCRIPTION OF THE DRAWINGS

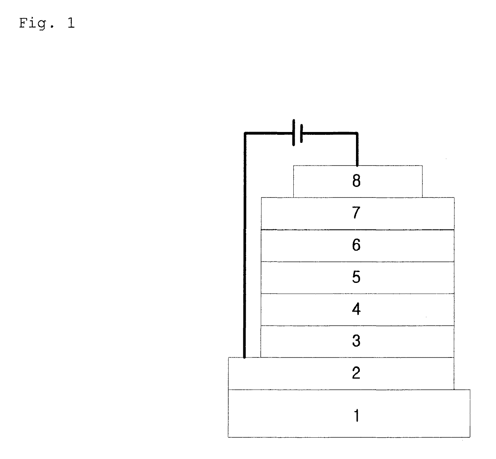

Fig. 1 is a cross-sectional view of an organic light emitting diode (OLED).

### DETAILED DESCRIPTION OF THE INVENTION

Referring now to the Drawings, Fig. 1 illustrates a cross-sectional view of an OLED of the present invention comprising a Glass 1, Transparent electrode 2, Hole injecting layer 3, Hole transport layer 4, Electroluminescent layer 5, Electron transport layer 6, Electron injecting layer 7 and Al cathode 8.

The term "alkyl", "alkoxy" and other subsituents containing "alkyl" moiety described herein include both linear and branched species.

The term "aryl" described herein means an organic radical derived from aromatic hydrocarbon via elimination of one hydrogen atom. Each ring suitably comprises a monocyclic or fused ring system containing from 4 to 7, preferably from 5 to 6 cyclic atoms. Specific examples include phenyl, naphthyl, biphenyl, anthryl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O and S for the aromatic cyclic backbone atoms, and carbon atom(s) for remaining aromatic cyclic backbone atoms. The heteroaryl may be 5- or 6-membered monocyclic heteroaryl or a polycyclic heteroaryl which is fused with one or more benzene ring(s), and may be partially saturated. The heteroaryl groups include bivalent aryl group of which the heteroatom in the ring is oxidized or quarternized to form an N-oxide or a quaternary salt. Specific examples include monocyclic heteroaryl groups such as furyl, thienyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; and polycyclic heteroaryl groups such as benzofuryl, benzothienyl, isobenzofuryl, benzimidazolyl, benzothiazolyl, benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinolizinyl, quinoxalinyl, carbazolyl, phenanthridinyl and benzodioxolyl; and corresponding N-oxides (for example, pyridyl N-oxide, quinolyl N-oxide) or quaternary salt thereof, but they are not restricted thereto.

The substituents comprising "(C1-C60)alkyl" moiety described herein may contain 1 to 60 carbon atoms, 1 to 20 carbon atoms, or 1 to 10 carbon atoms. The substituents comprising "(C6-C60)aryl" moiety may contain 6 to 60 carbon atoms, 6 to 20 carbon atoms, or 6 to 12 carbon atoms. The substituents comprising "(C3-C60)heteroaryl" moiety may contain 3 to 60 carbon atoms, 4 to 20 carbon atoms, or 4 to 12 carbon atoms. The substituents comprising "(C3-C60)cycloalkyl" moiety may contain 3 to 60 carbon atoms, 3 to 20 carbon atoms, or 3 to 7 carbon atoms. The substituents comprising "(C2-C60)alkenyl or alkynyl" moiety may contain 2 to 60 carbon atoms, 2 to 20 carbon atoms, or 2 to 10 carbon atoms.

The organic electroluminescent compounds according to the present invention include the compounds represented by Chemical Formula (2): 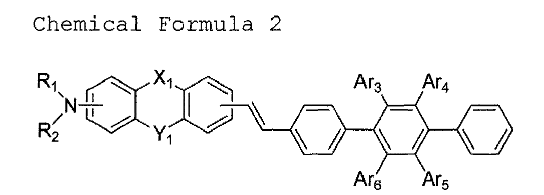 wherein, R₁, R₂, X₁ and Y₁ are defined as in Chemical Formula (1); and
Ar₃ through Ar₆ independently represent hydrogen, (C1-C60)alkyl, halo(C1-C60)alkyl, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, (C1-C60)alkyl(C6-C60)aryl, tri(C1-C60)alkylsilyl, di(C1-C60)alkyl(C6-C60)arylsilyl or tri(C6-C60)arylsilyl, or a substituent selected from the following structures, excluding the case wherein Ar₃ through Ar₆ are hydrogen all at the same time: 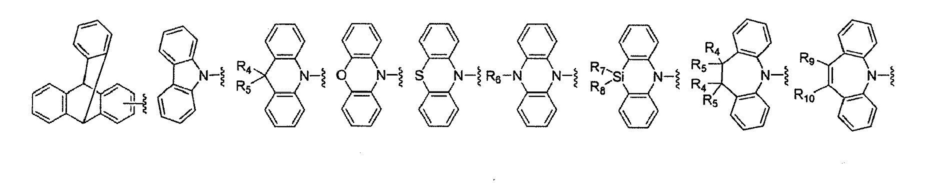 wherein, R₄ through R₁₀ are defined as in Chemical Formula (1).

In the Chemical Formulas, 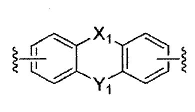 may be selected from the structures shown below, without restriction: 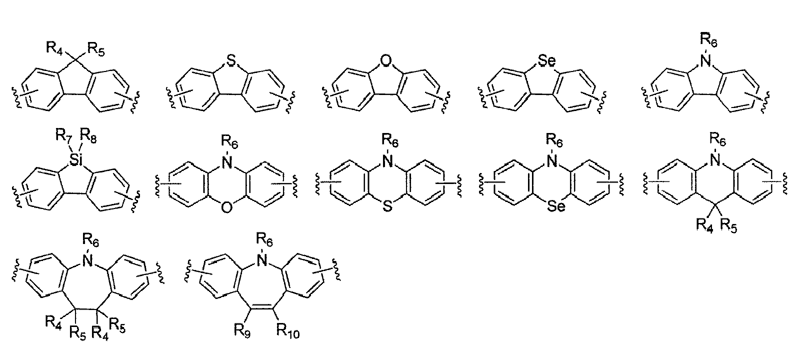 wherein, R₄ through R₁₀ independently represent hydrogen, (C1-C60)alkyl, halo(C1-C60)alky, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, tri(C1-C60)alkylsilyl, di(C1-C60)alkyl(C6-C60)arylsilyl or tri(C6-C60)arylsilyl, or R₄ and R₅, R₇ and R₈, or R₉ and R₁₀ may be linked via (C3-C12)alkylene or (C3-C12)alkenylene with or without a fused ring to form a fused ring; and
the alkyl, aryl or heteroaryl of R₄ through R₁₀ may be further substituted by one or more substituent(s) selected from (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, tri(C1-C60)alkylsilyl, di(C1-C60)alkyl(C6-C60)arylsilyl and tri(C6-C60)arylsilyl.

In Chemical Formula (1), A represents a chemical bond, or arylene or heteroarylene selected from the following structures, without restriction: 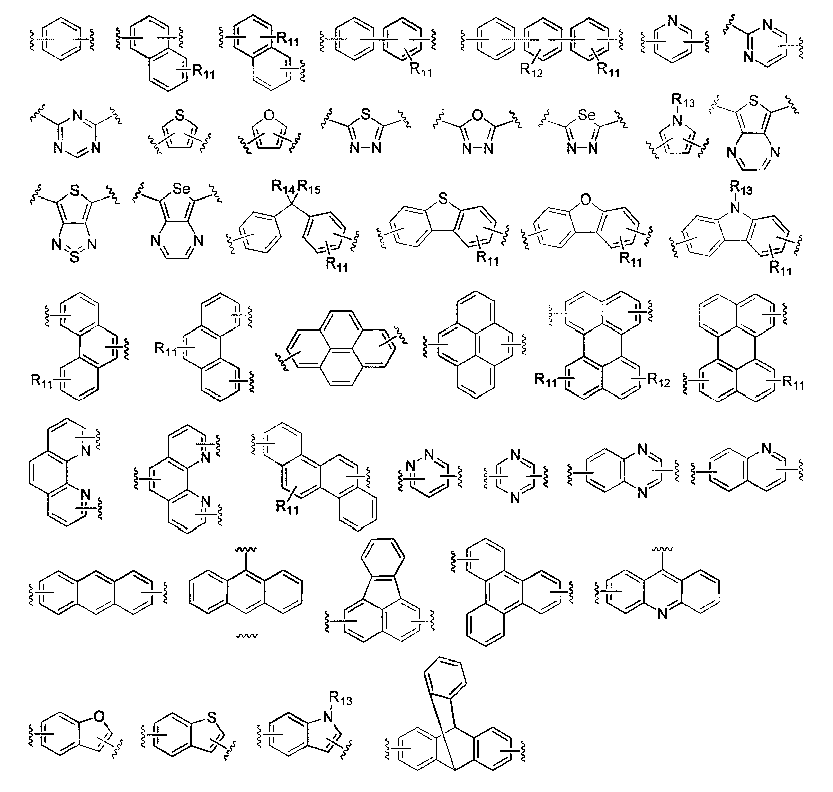 wherein, R₁₁ through R₁₅ independently represent hydrogen, (C1-C60)alkyl, halo(C1-C60)alkyl, (C1-C60)alkoxy, piperidino, morpholino, thiomorpholino, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, tri(C1-C60)alkylsilyl, di(C1-C60)alkyl(C6-C60)arylsilyl or tri(C6-C60)arylsilyl, or a substituent selected from the following structures, 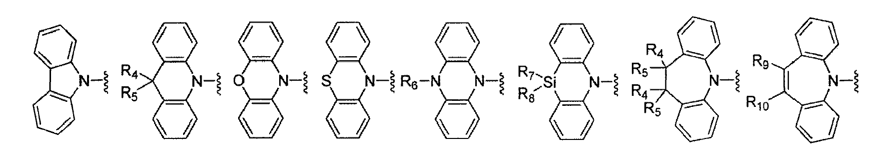 wherein, R₄ through R₁₀ are defined as in Chemical Formula (1).

The substituents R₁ and R₂ independently represent a cycloalkyl, aryl or heteroaryl selected from cyclopropyl, cyclobutyl, cyclopentyl, cyclohexyl, cycloheptyl, cyclooctyl, cyclononyl, cyclodecyl, adamantyl, phenyl, naphthyl, biphenyl, fluorenyl, phenanthryl, anthryl, fluoranthenyl, triphenylenyl, pyrenyl, chrysenyl, naphthacenyl, perylenyl, spirobifluorenyl, tetrahydronaphthyl, acenaphthenyl, indenyl, pyridyl, bipyridyl, pyrrolyl, furyl, thienyl, imidazolyl, benzimidazolyl, pyrazinyl, pyrimidinyl, pyridazinyl, quinolyl, triazinyl, benzofuryl, dibenzofuryl, benzothienyl, dibenzothienyl, pyrazolyl, indolyl, carbazolyl, thiazolyl, oxazolyl, benzotriazolyl, benzothiazolyl, benzoxazolyl, phenanthridinyl, phenanthrolinyl, piperidinyl or quinazolinyl, or they are selected from the following structures: 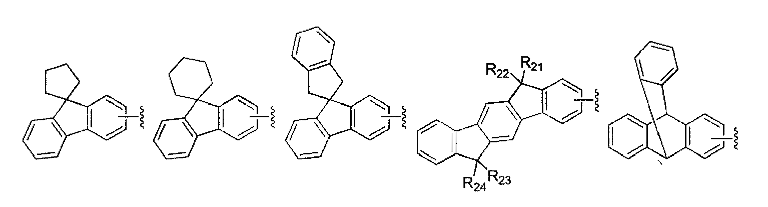 the aryl or heteroaryl of R₁ and R₂ may be further substituted by one or more substituent(s) selected from a group consisting of (C1-C60)alky, halogen, tri(C1-C60)alkylsilyl, (C1-C60)alkoxy, tri(C6-C60)arylsilyl and (C6-C60)aryl;
R₂₁ through R₂₄ independently represent hydrogen, (C1-C60)alkyl or (C6-C60)aryl;
Ar₁ represents arylene or heteroarylene selected from phenylene, naphthylene, biphenylene, fluorenylene, phenanthrylene, anthrylene, fluoranthenylene, triphenylenylene, pyrenylene, chrysenylene, naphthacenylene, perylenylene, spirobifluorenylene, tetrahydronaphthalene, acenaphthenylene, indenylene, pyridylene, bipyridylene, pyrrolylene, furylene, thienylene, imidazolylene, benzimidazolylene, pyrazinylene, pyrimidinylene, pyridazinylene, quinolylene, triazinylene, benzofurylene, dibenzofurylene, benzothienylene, dibenzothienylene, pyrazolylene, indolylene, carbazolylene, indenocarbazolylene, thiazolylene, oxazolylene, benzothiazolylene, benzoxazolylene, phenanthridinylene, phenanthrolinylene, piperidinylene, quinazolinylene, 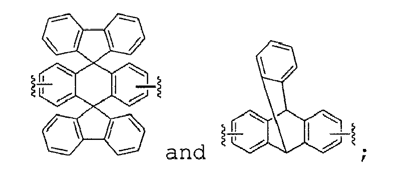 Ar₂ represents hydrogen, (C1-C20)alkyl, (C6-C20)aryl, (C6-C20)ar(C1-C20)alkyl, (C2-C20)heteroaryl, (C6-C20)ar(C2-C20)alkenyl or (C6-C20)ar(C2-C20)alkynyl;
the arylene or heteroarylene of Ar₁, or the alkyl, aryl or heteroaryl of Ar₂ may be further substituted by one or more substituent(s) selected from (C1-C60)alkyl, piperidino, morpholino, thiomorpholino, halogen, tri(C1-C60)alkylsilyl, (C1-C60)alkoxy, tri(C6-C60)arylsilyl, (C6-C60)ar(C1-C60)alkyl, (C6-C60)aryl, (C2-C60)heteroaryl, 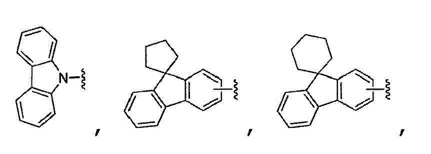 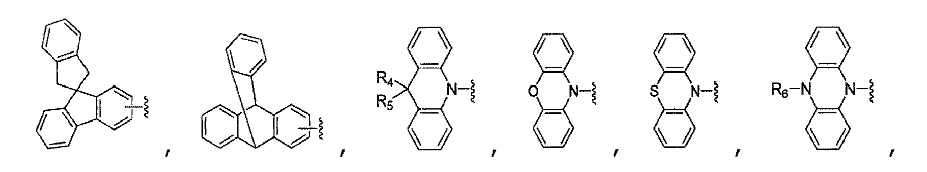 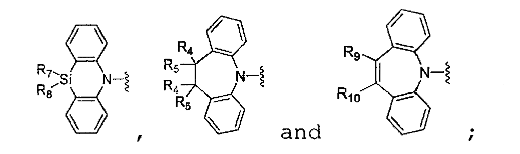 R₄ through R₁₀ independently represent hydrogen, (C1-C60)alkyl or (C6-C60)aryl, or R₄ and R₅, R₇ and R₈, or R₉ and R₁₀ may be linked via (C3-C12)alkylene or (C3-C12)alkenylene with or without a fused ring to form a fused ring;
provided that the number of carbon atoms in 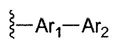 is from 19 to 60.

In the Chemical Formulas, 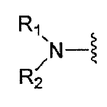 formed from R₁ and R₂ by linkage via alkylene or alkenylene is selected from the following structures, without restriction: 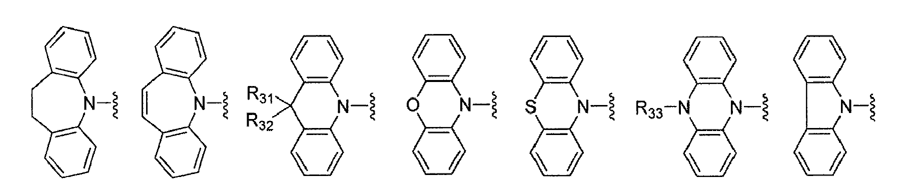 wherein, R₃₁ through R₃₃ independently represent hydrogen, (C1-C60)alkyl or (C6-C60)aryl, or R₃₁ and R₃₂ may be linked via (C3-C12)alkylene or (C3-C12)alkenylene with or without a fused ring to form a fused ring.

The organic electroluminescent compounds according to the present invention can be more specifically exemplified by the following compounds, without restriction.

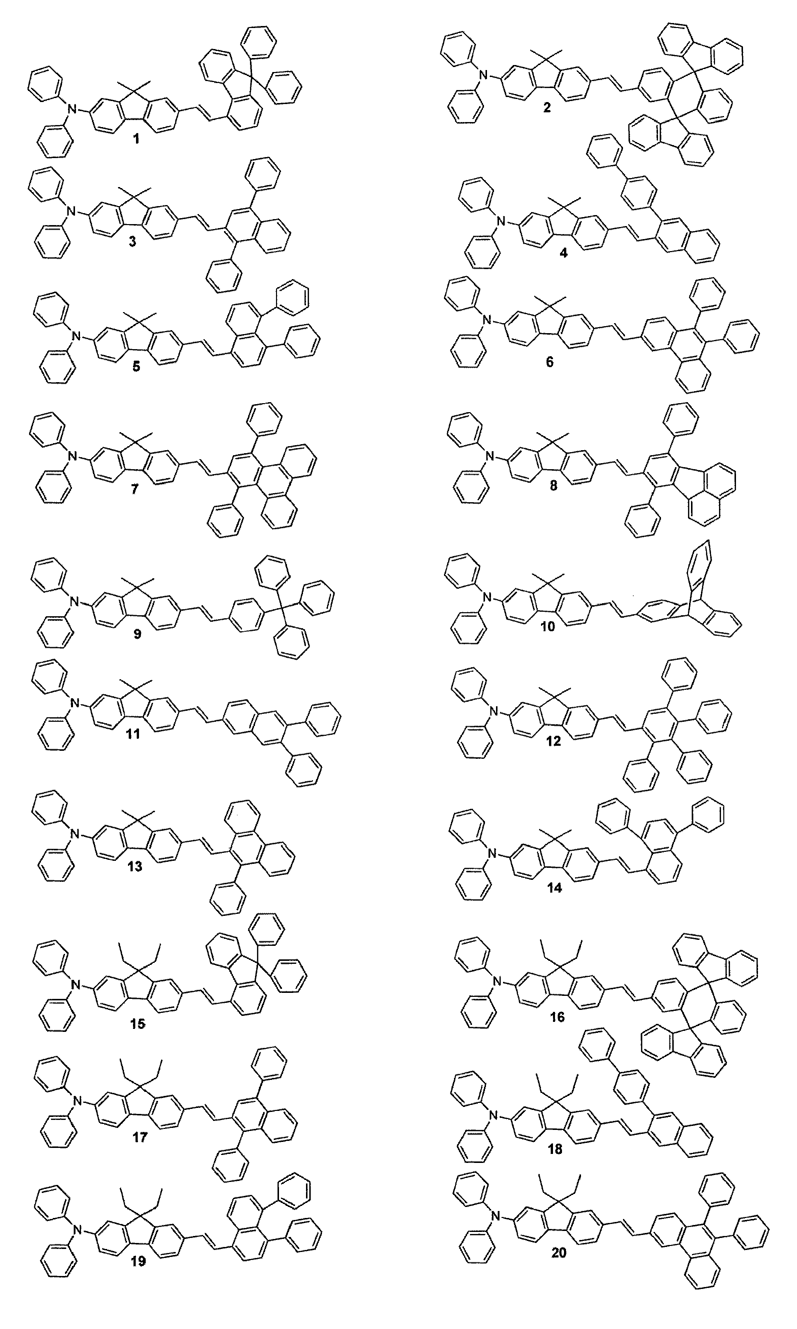

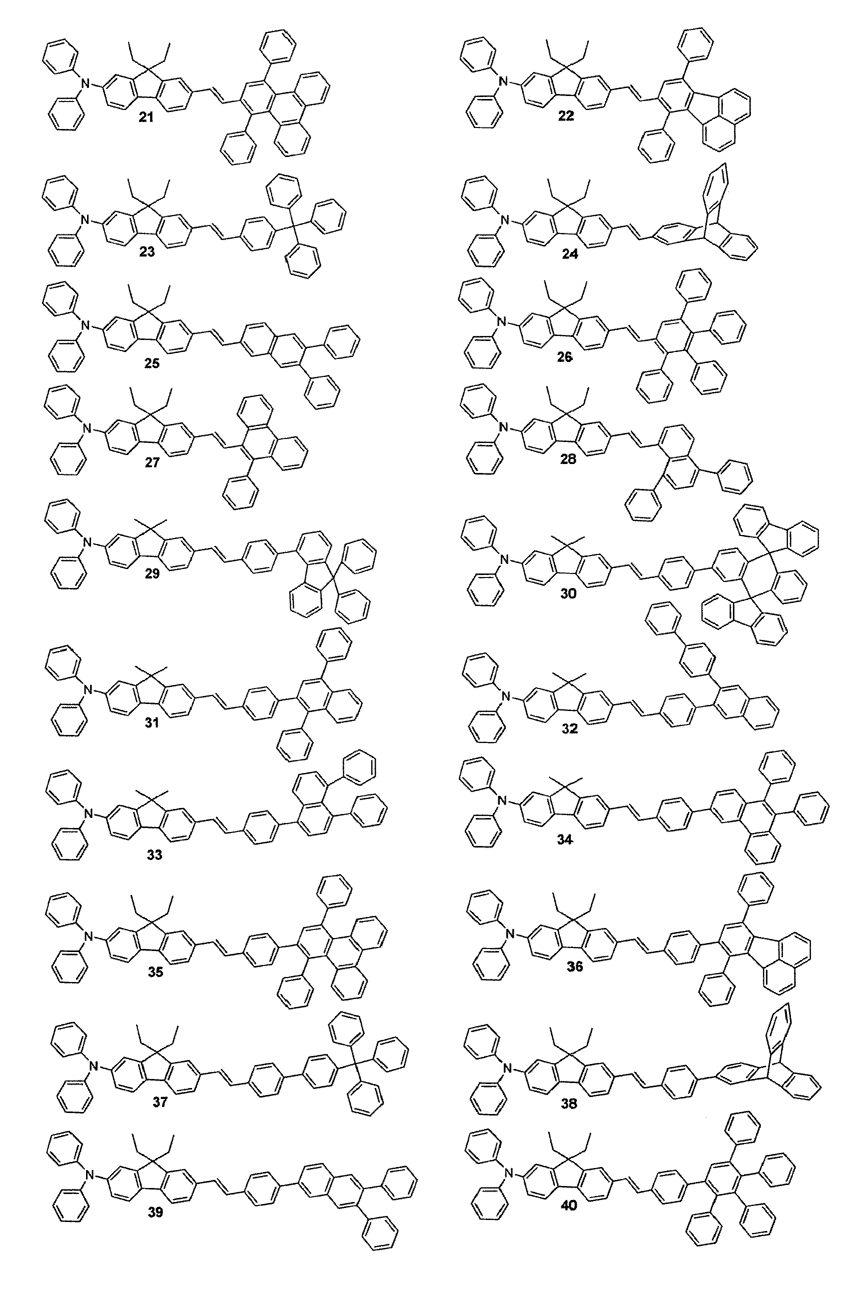

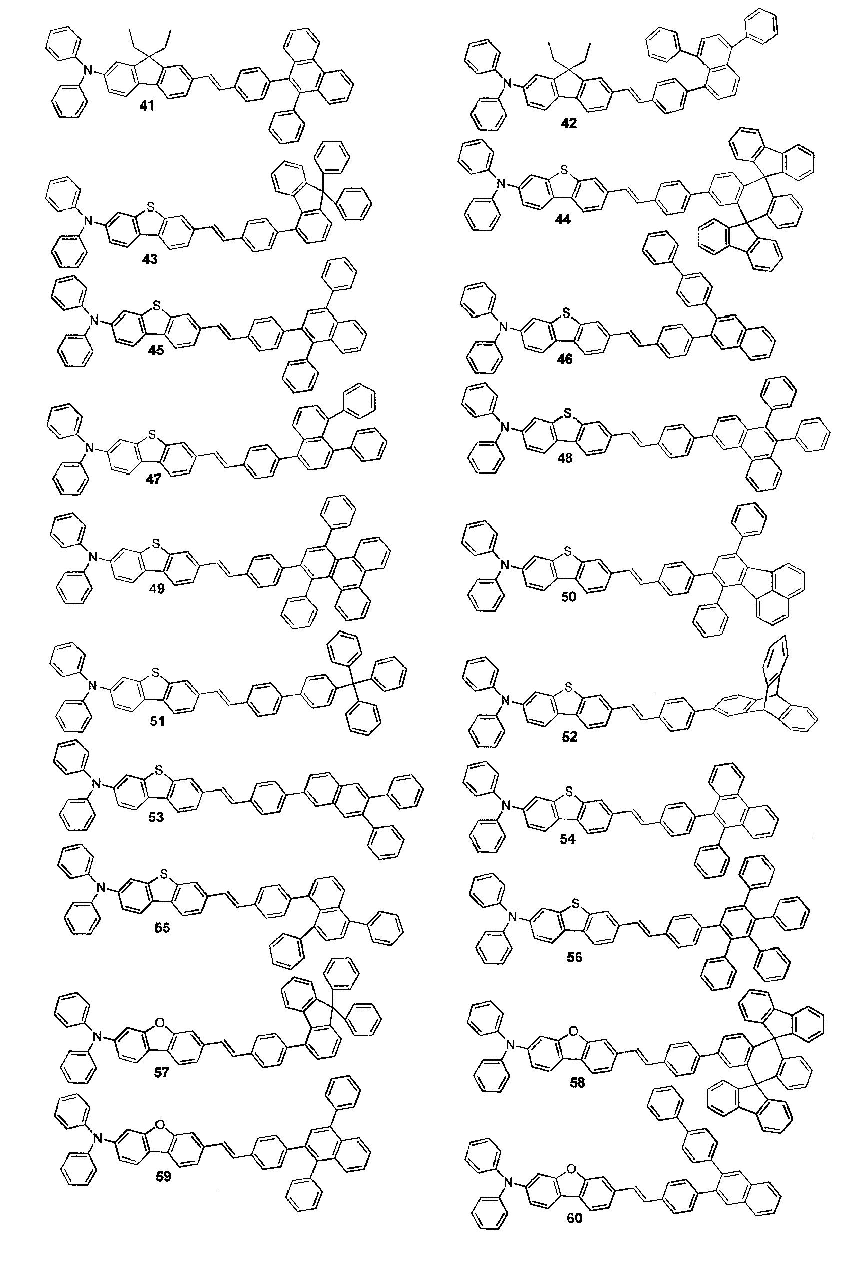

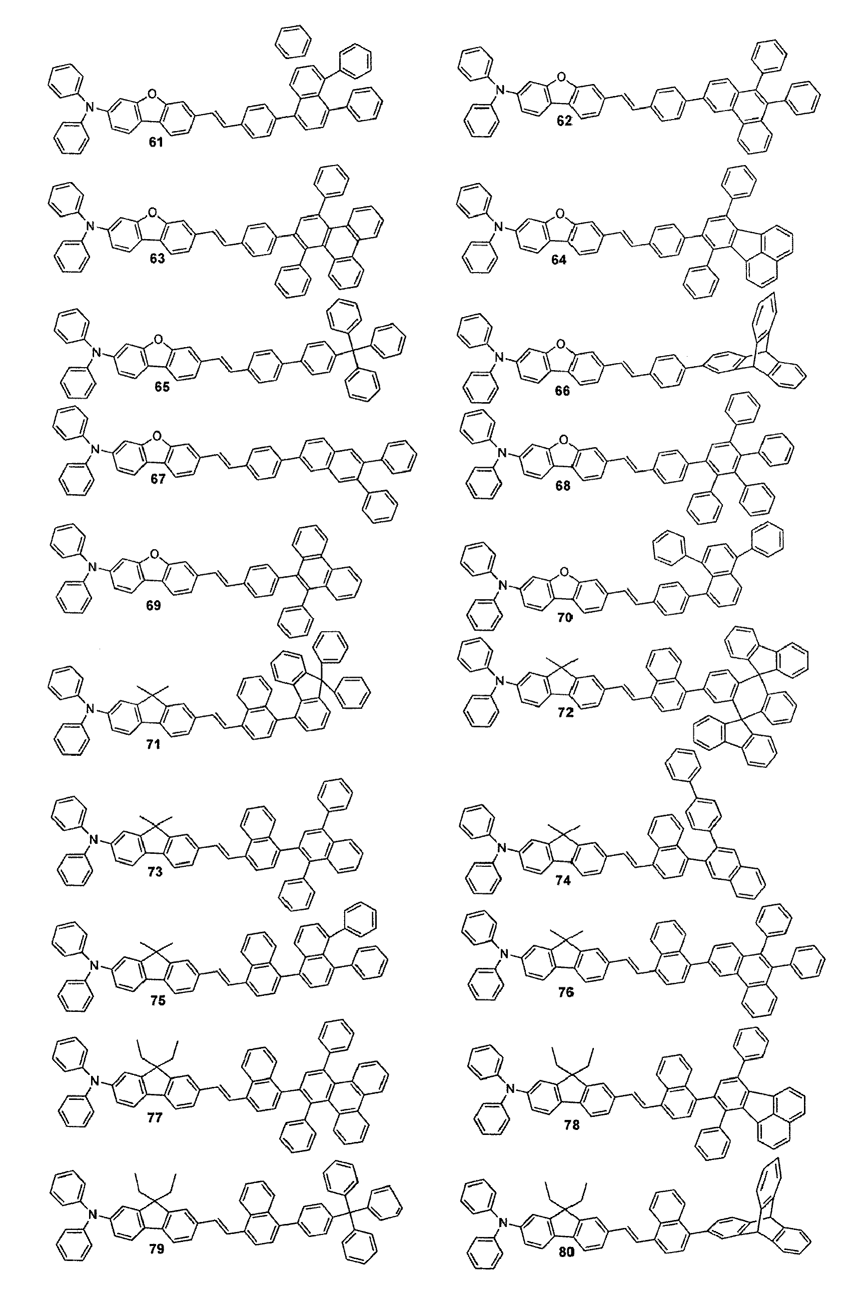

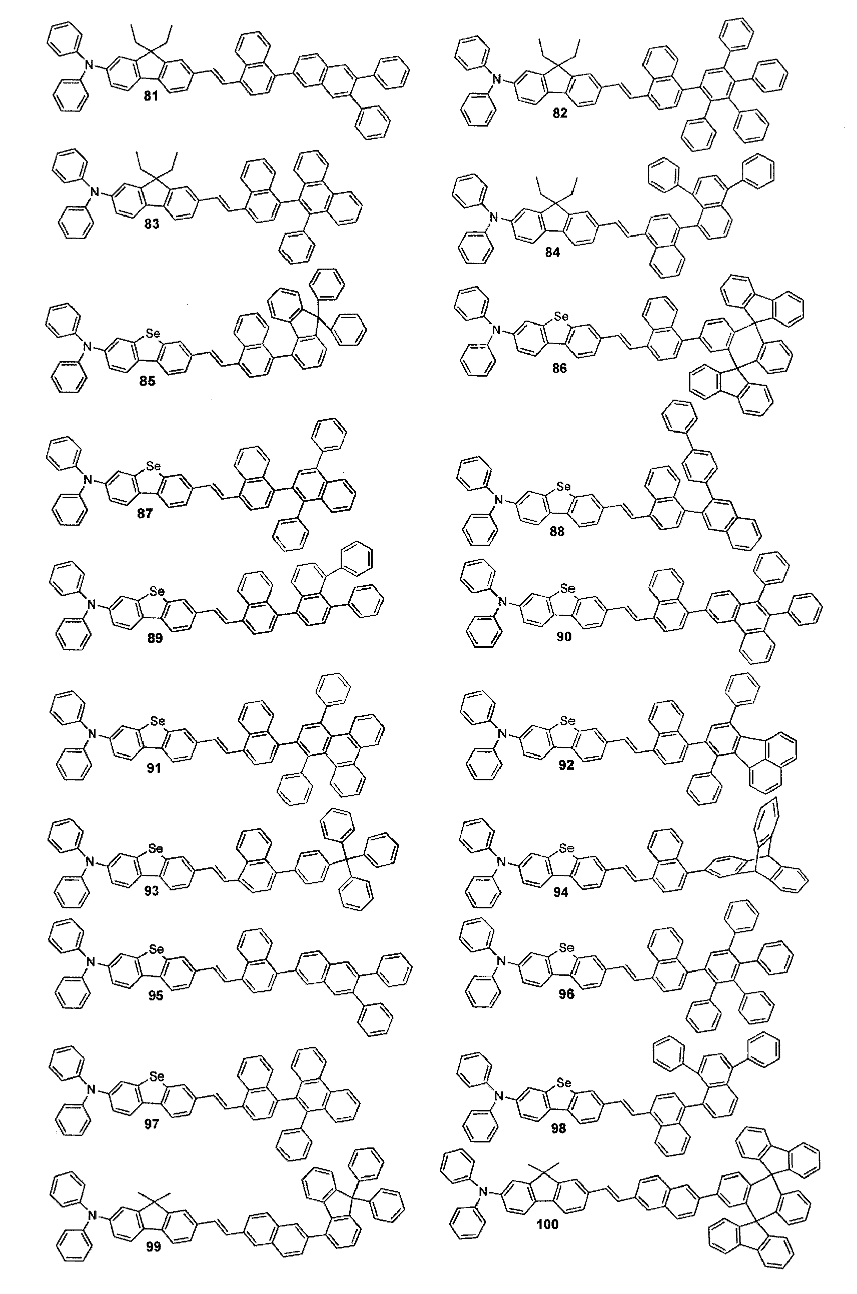

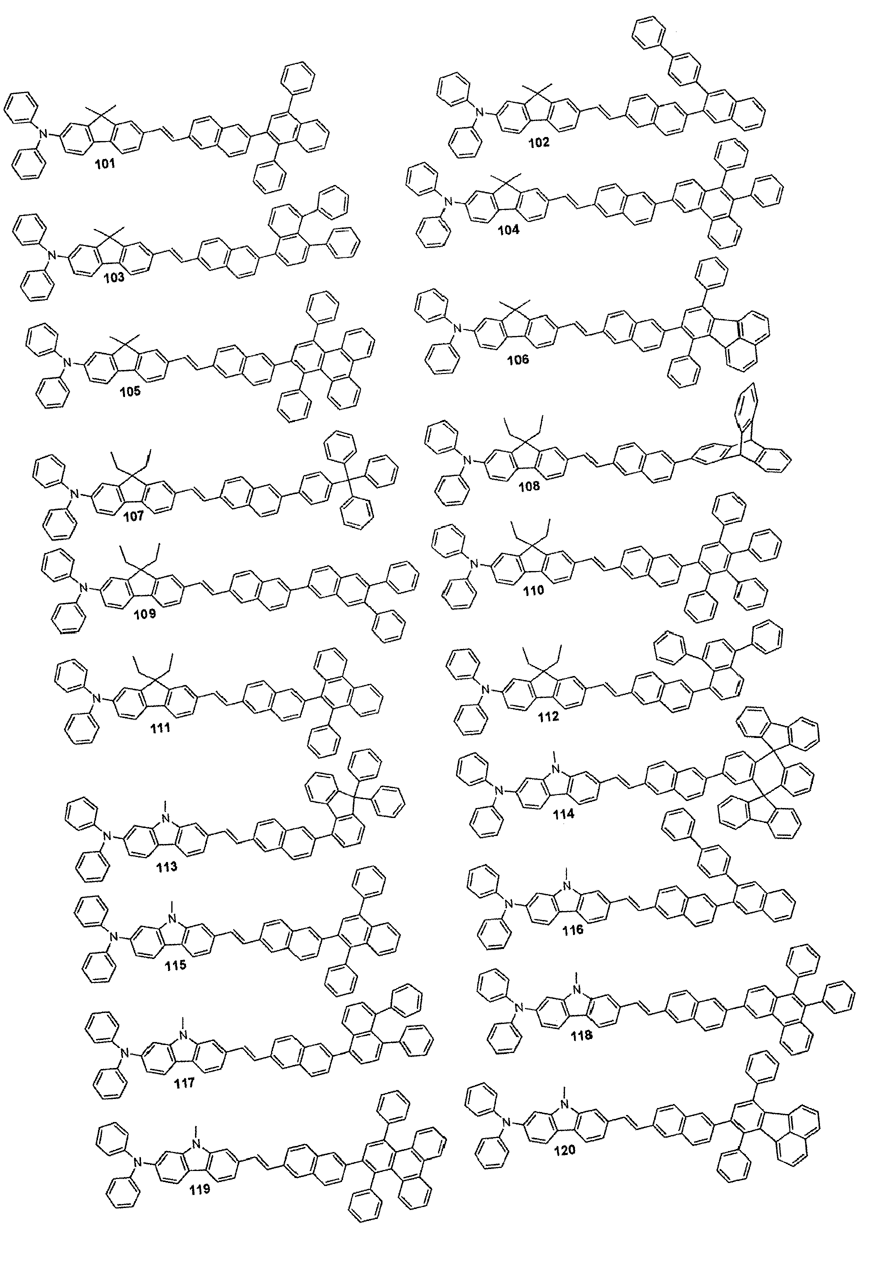

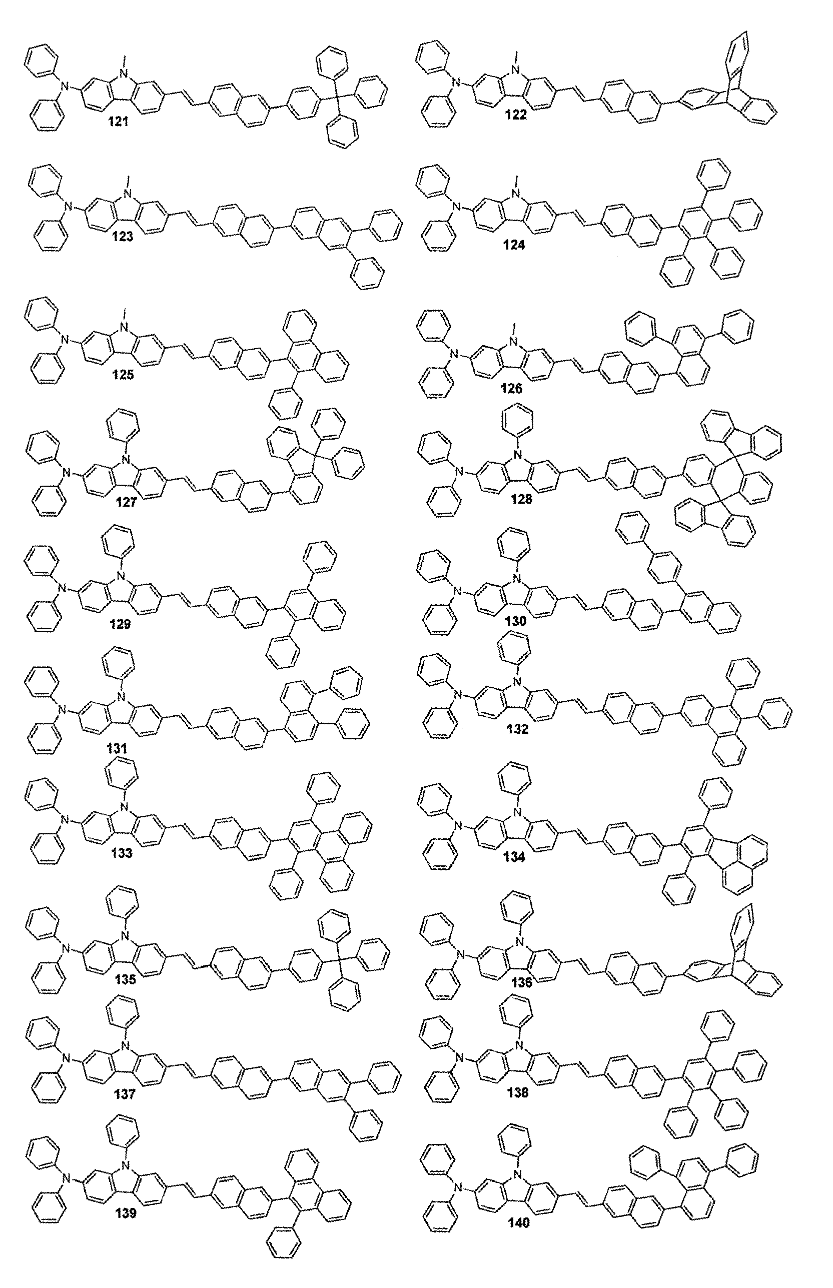

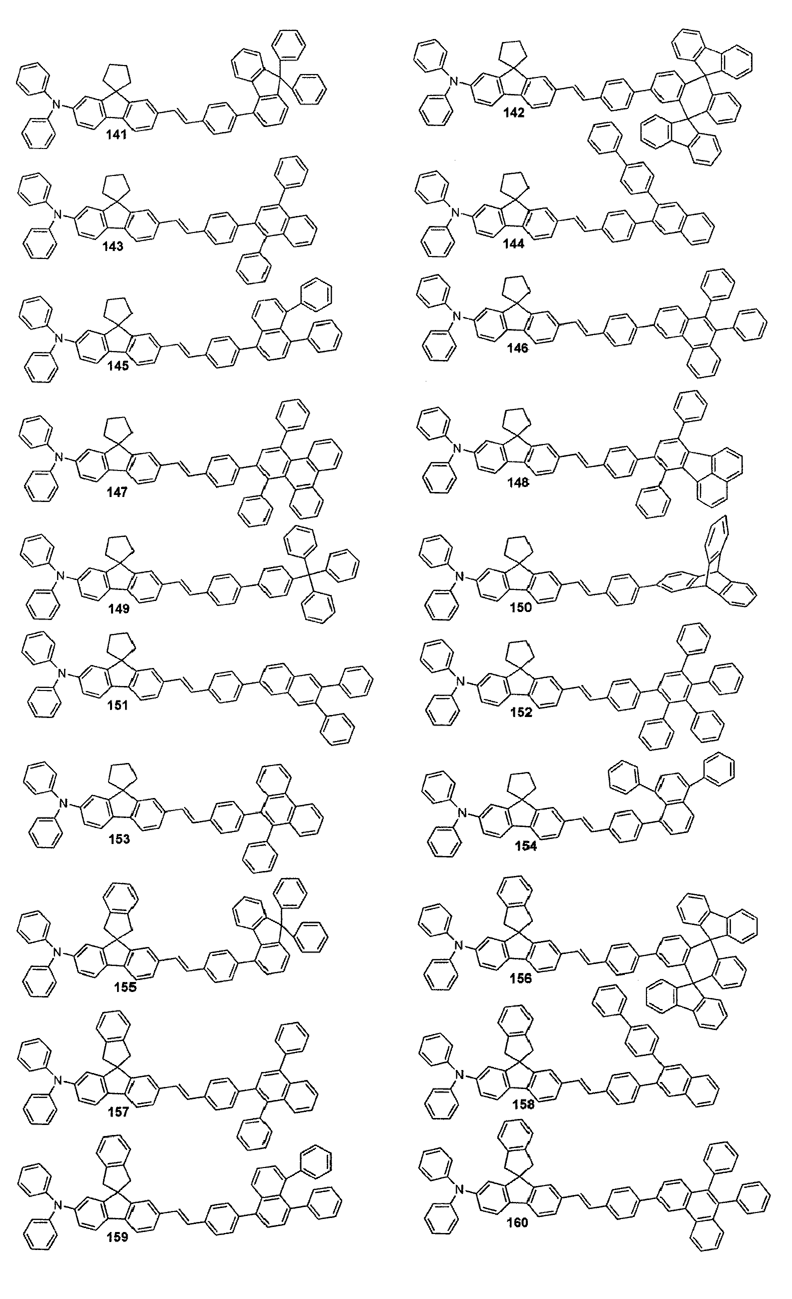

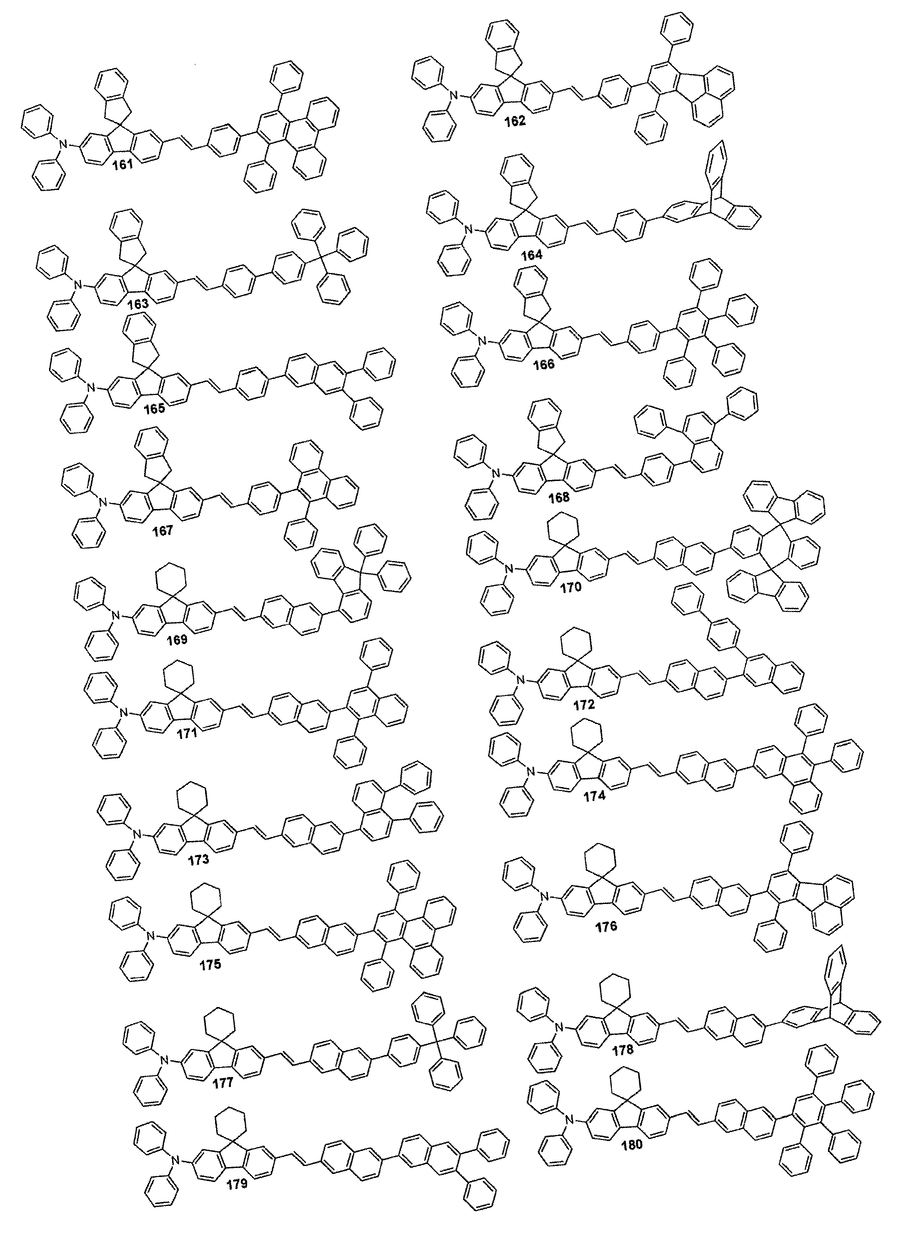

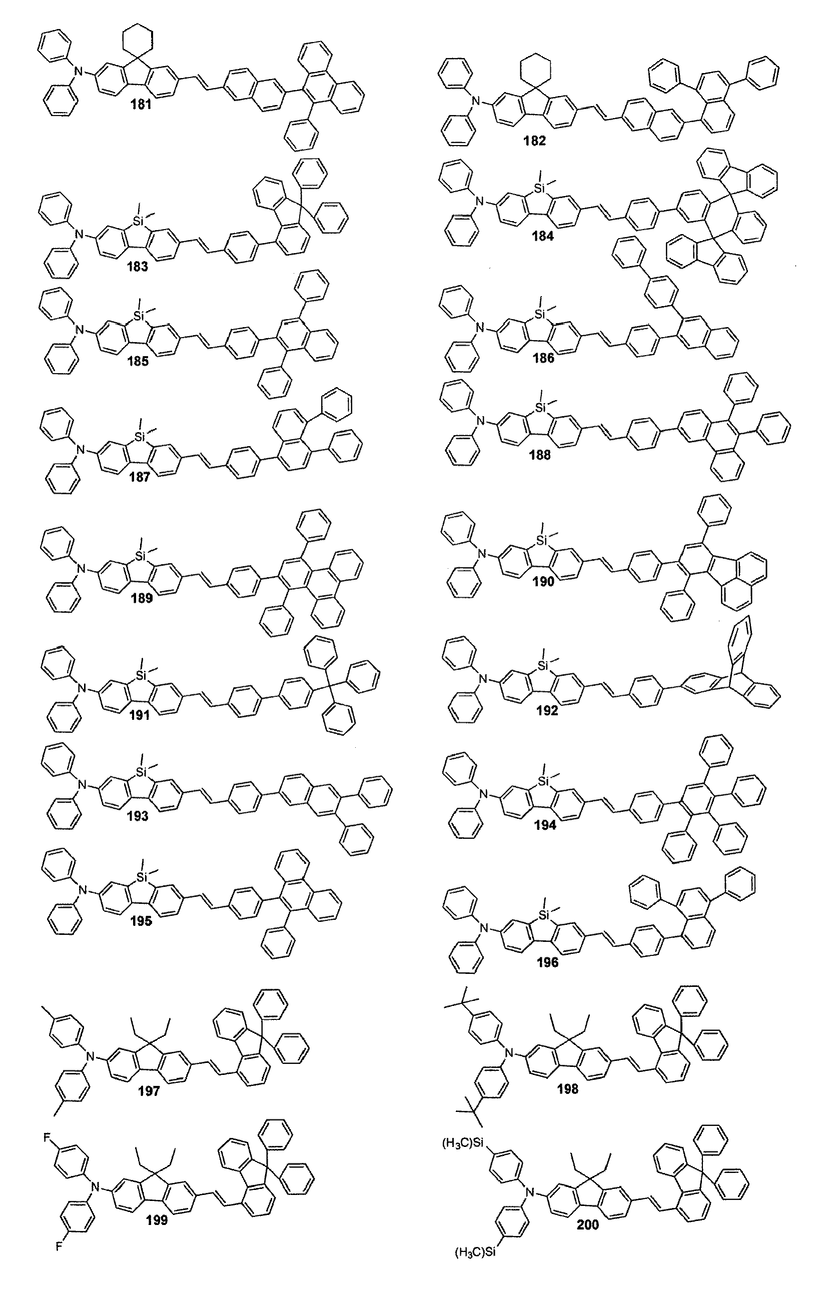

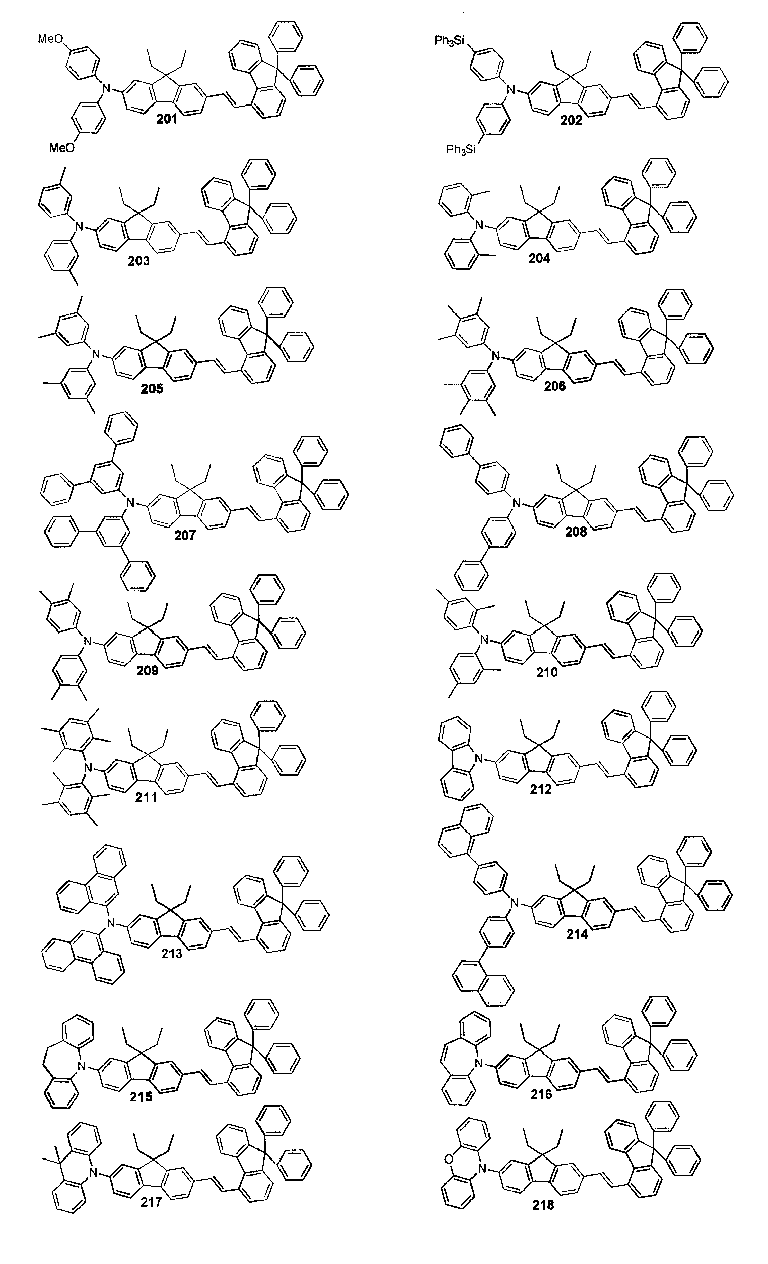

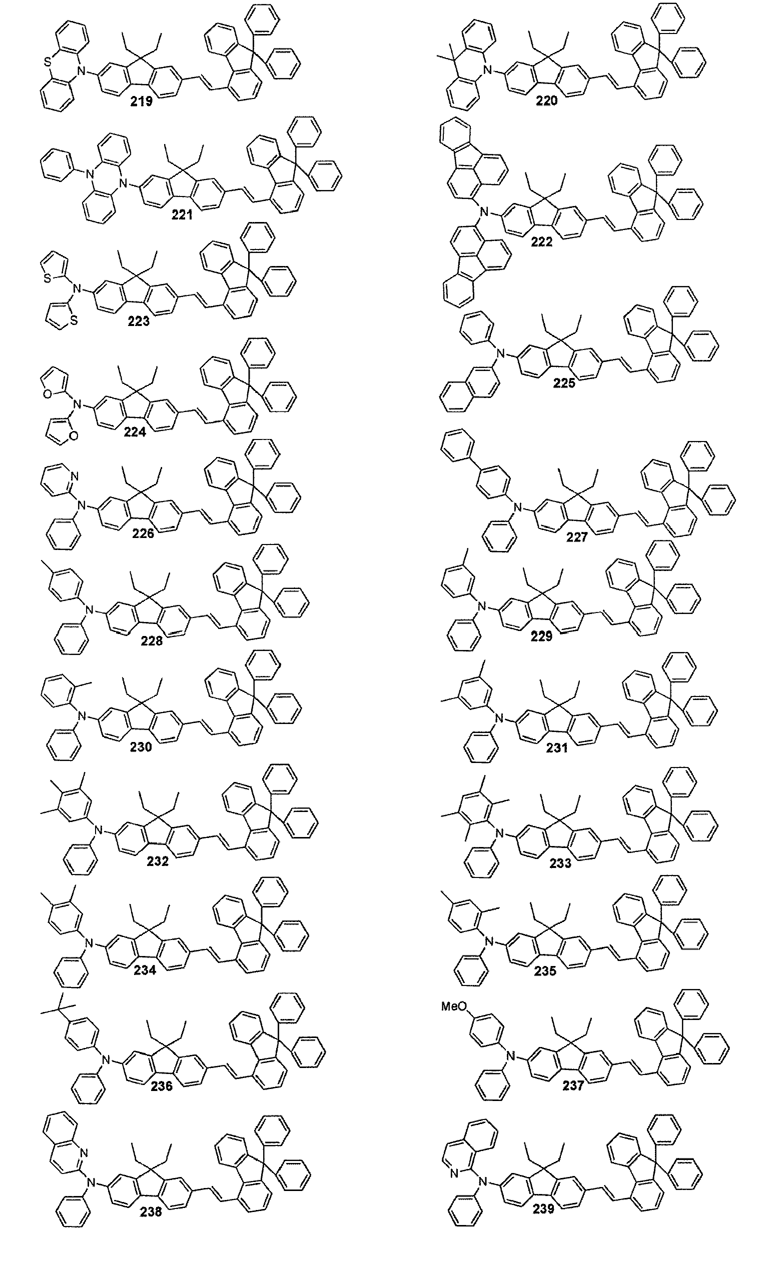

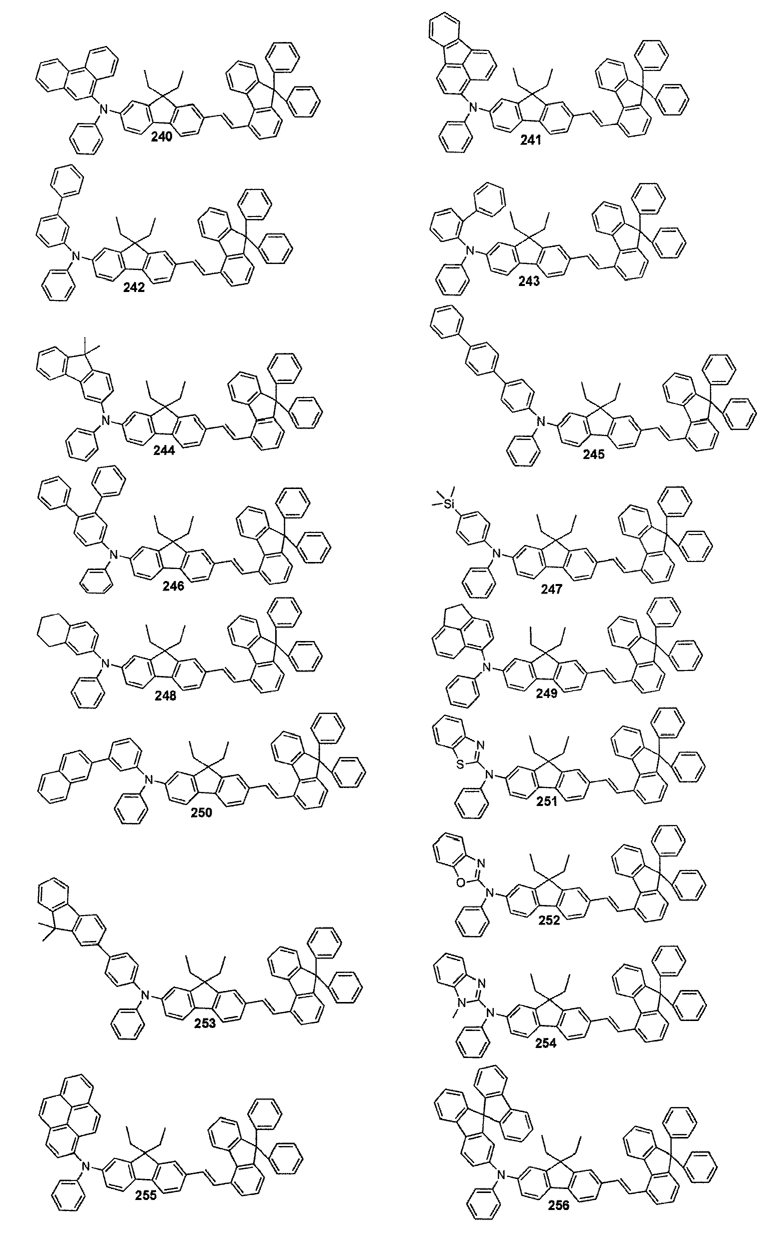

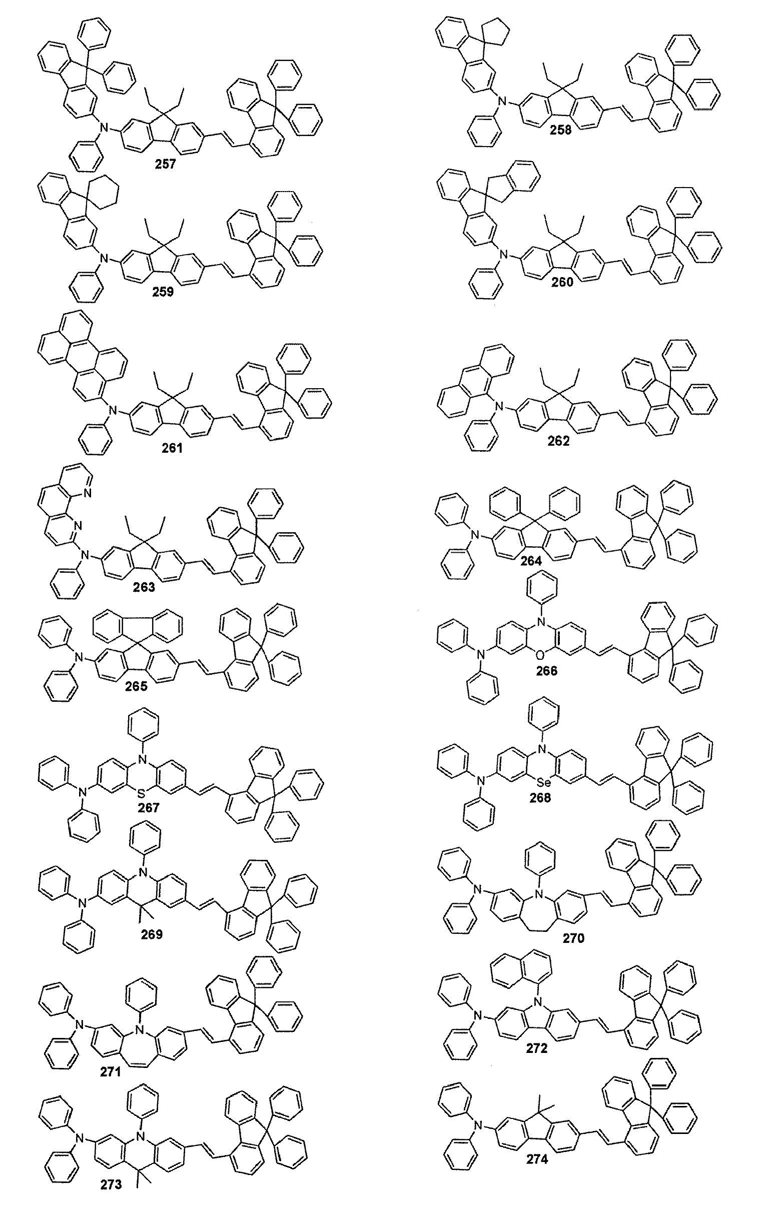

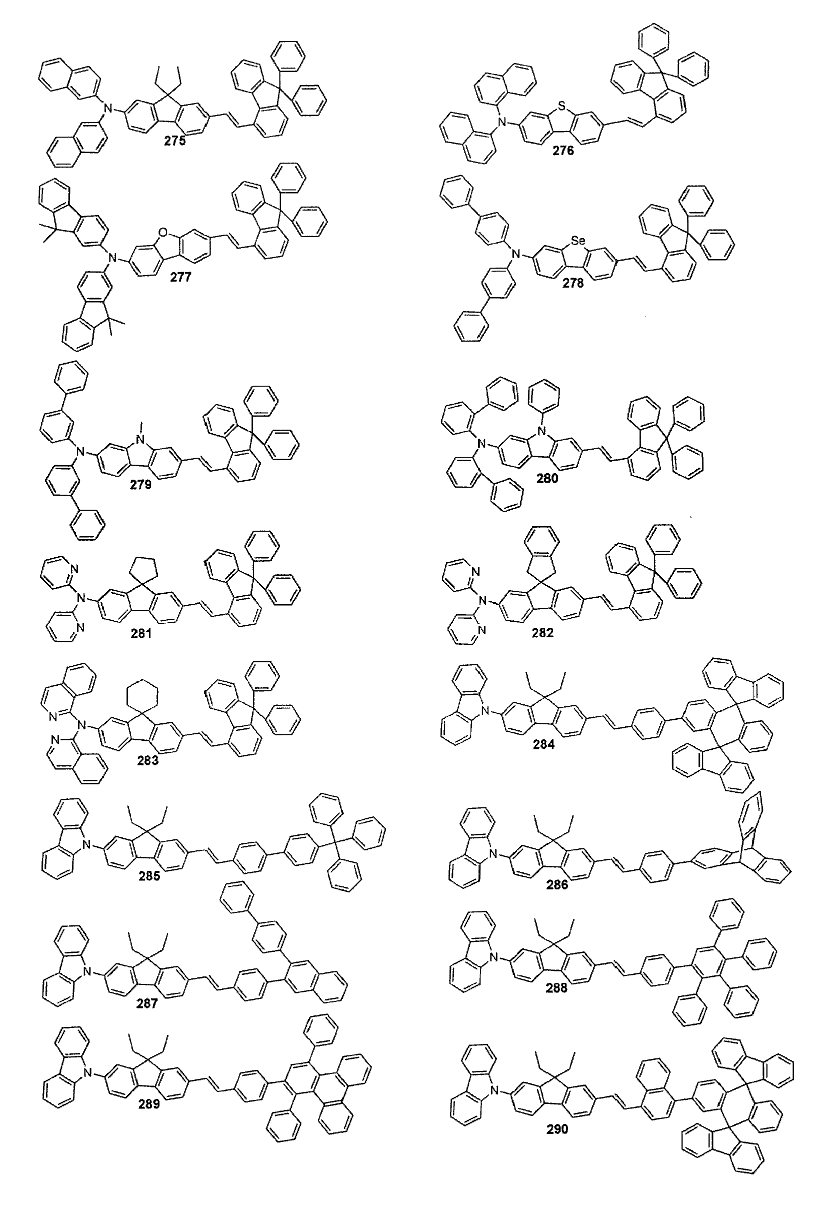

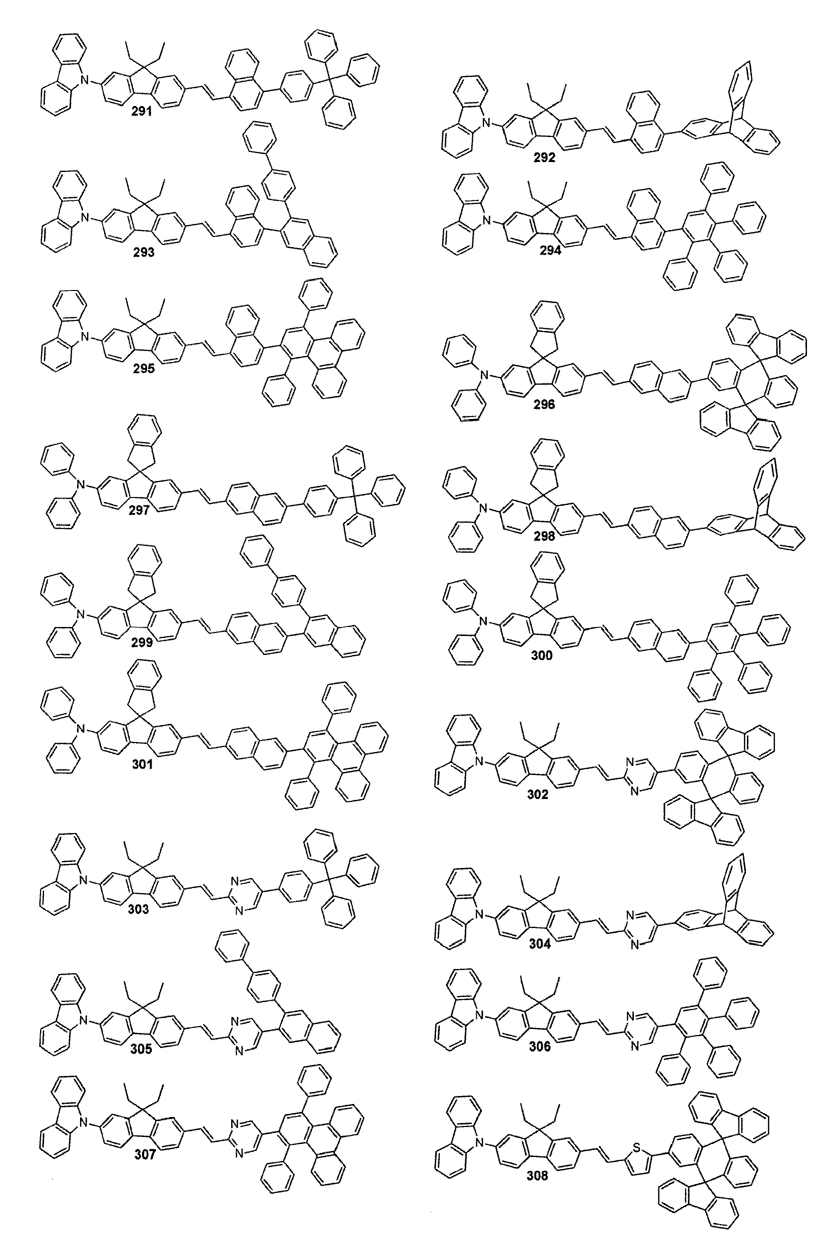

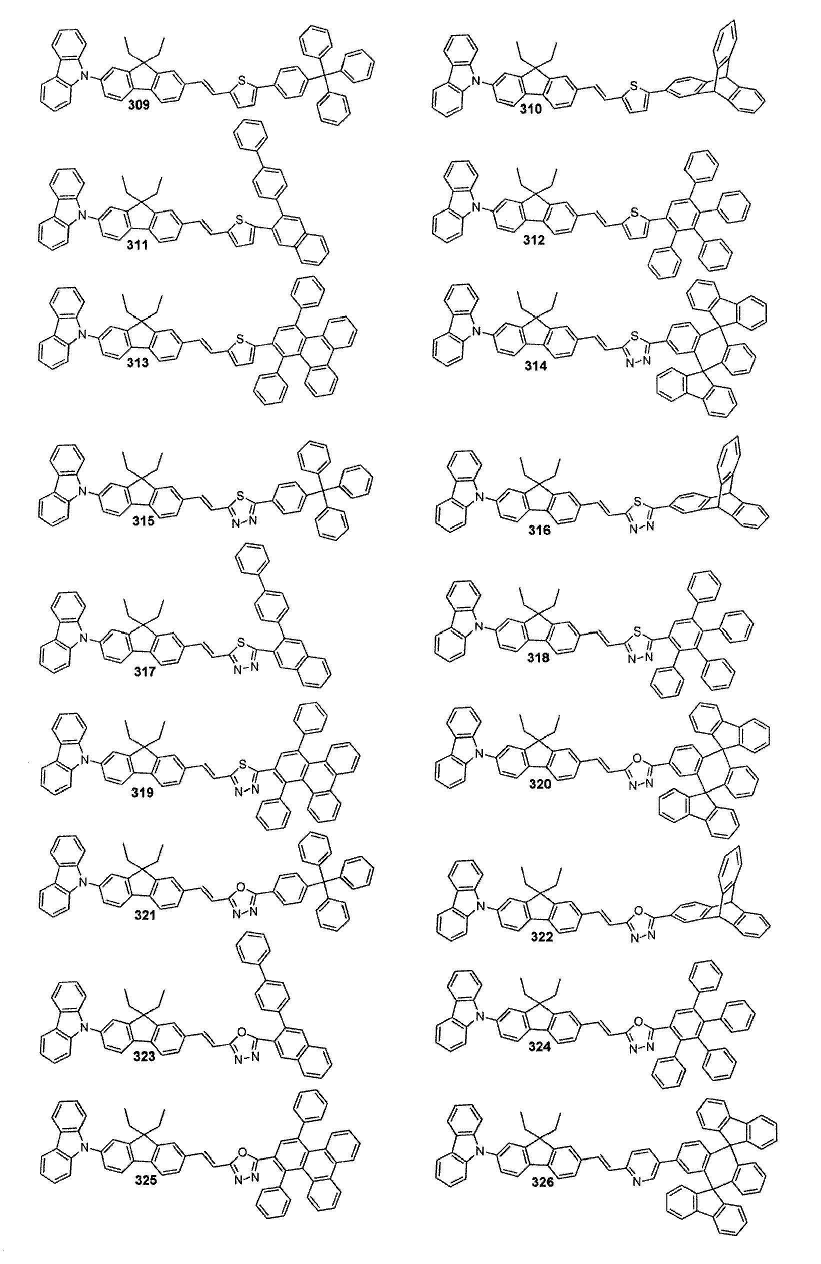

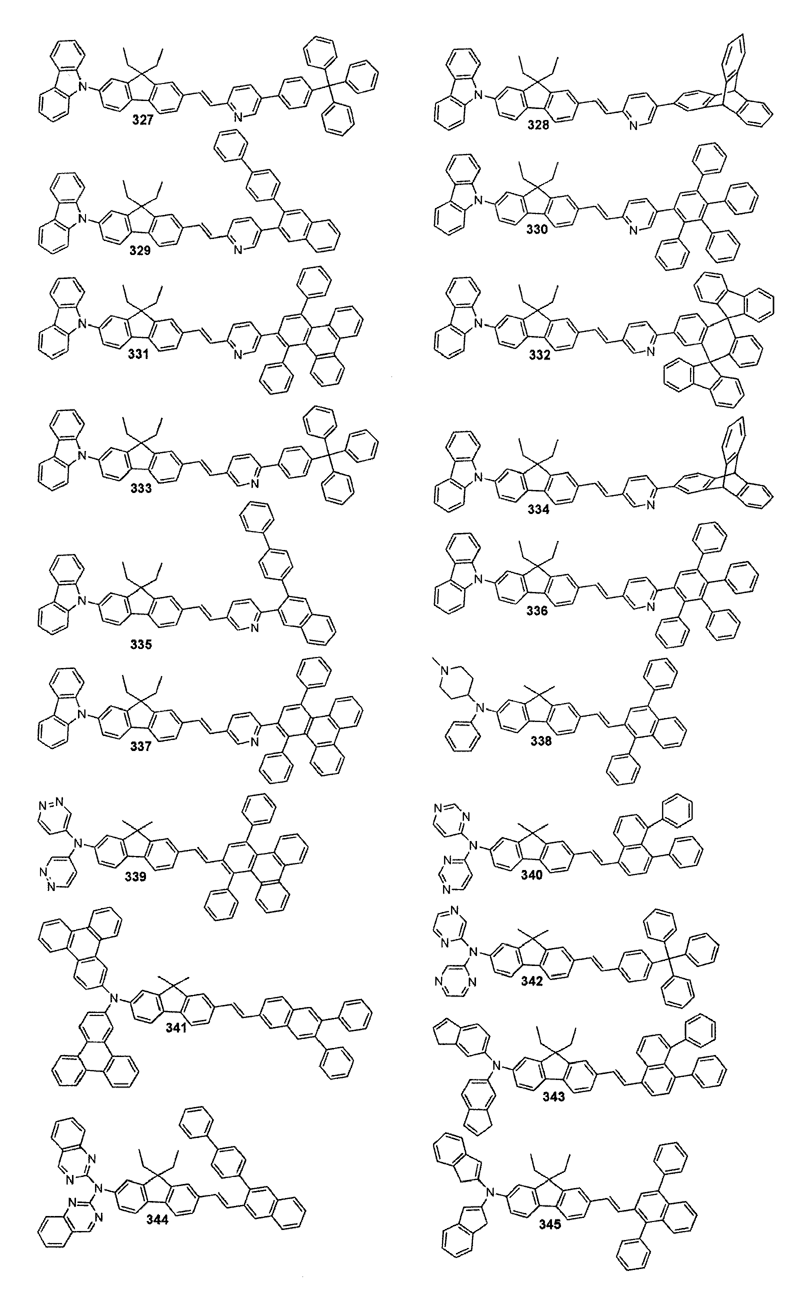

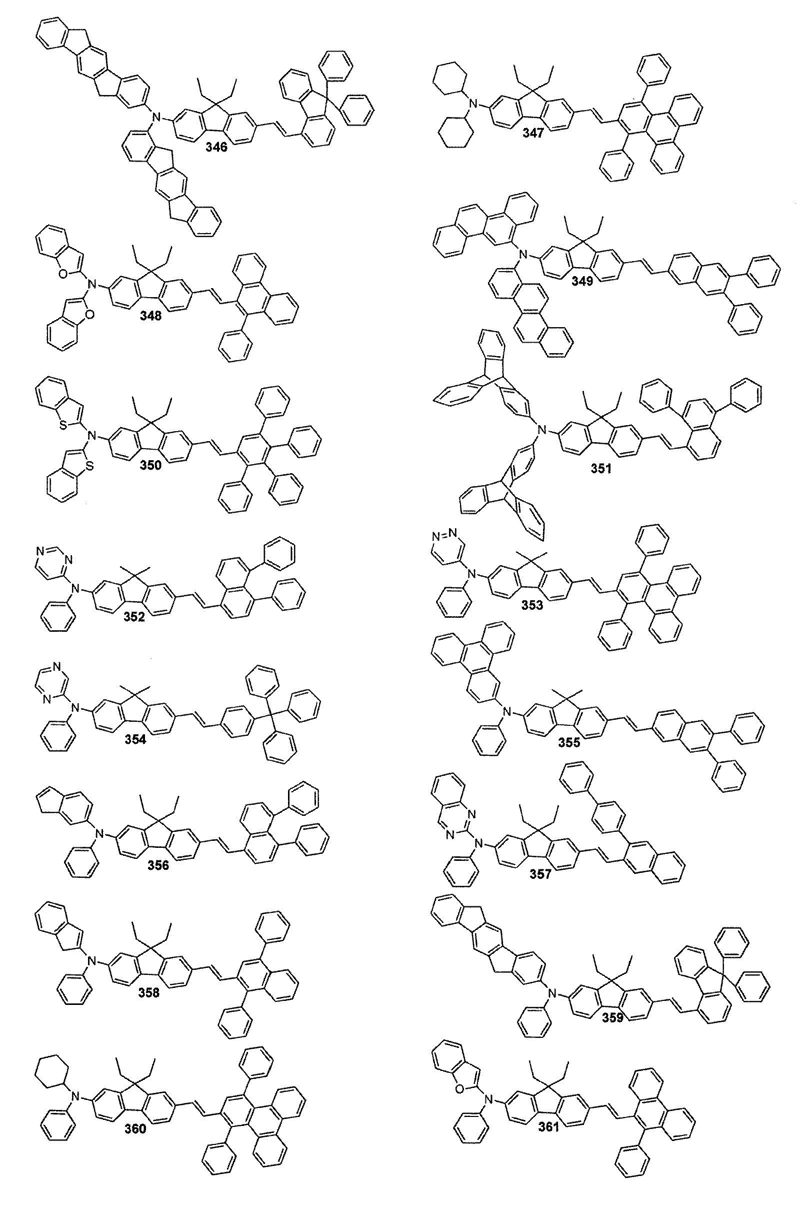

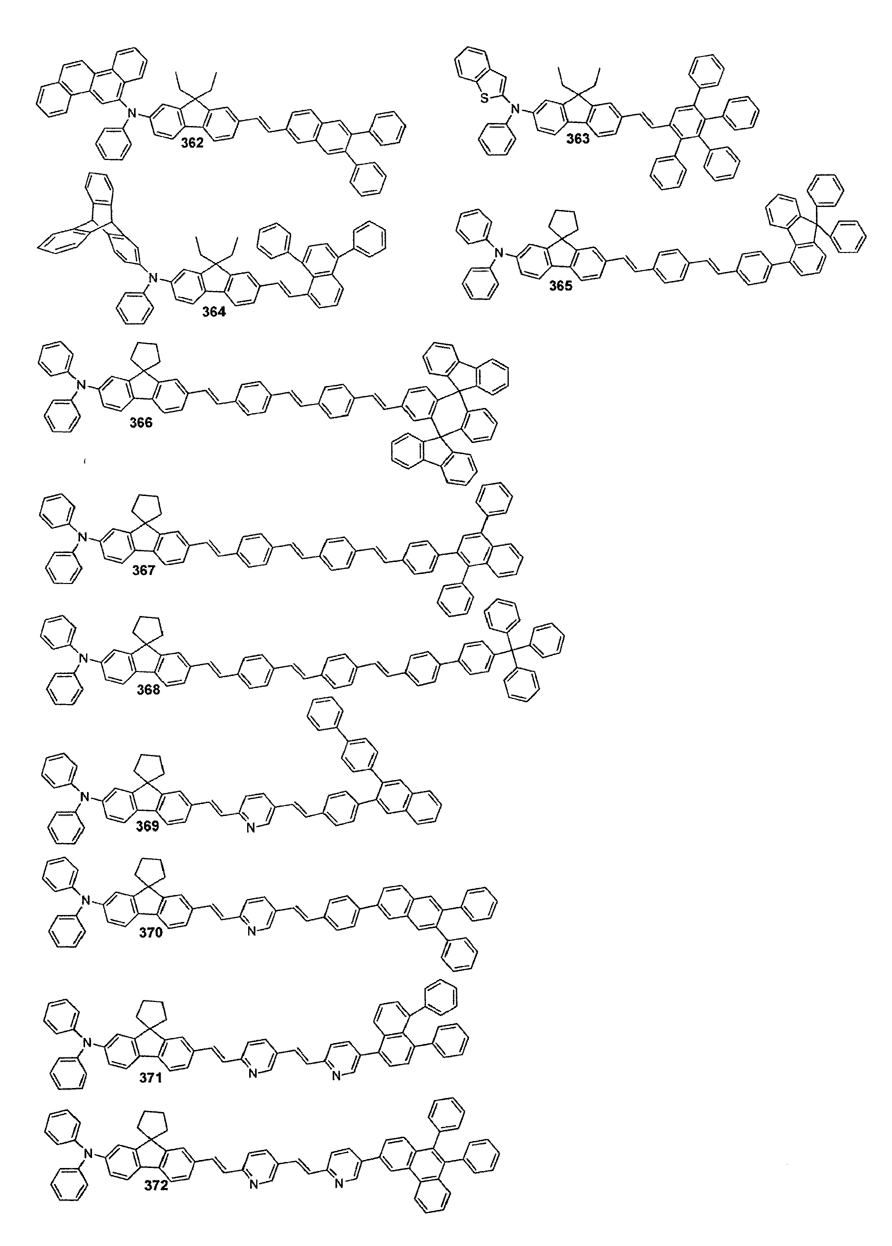

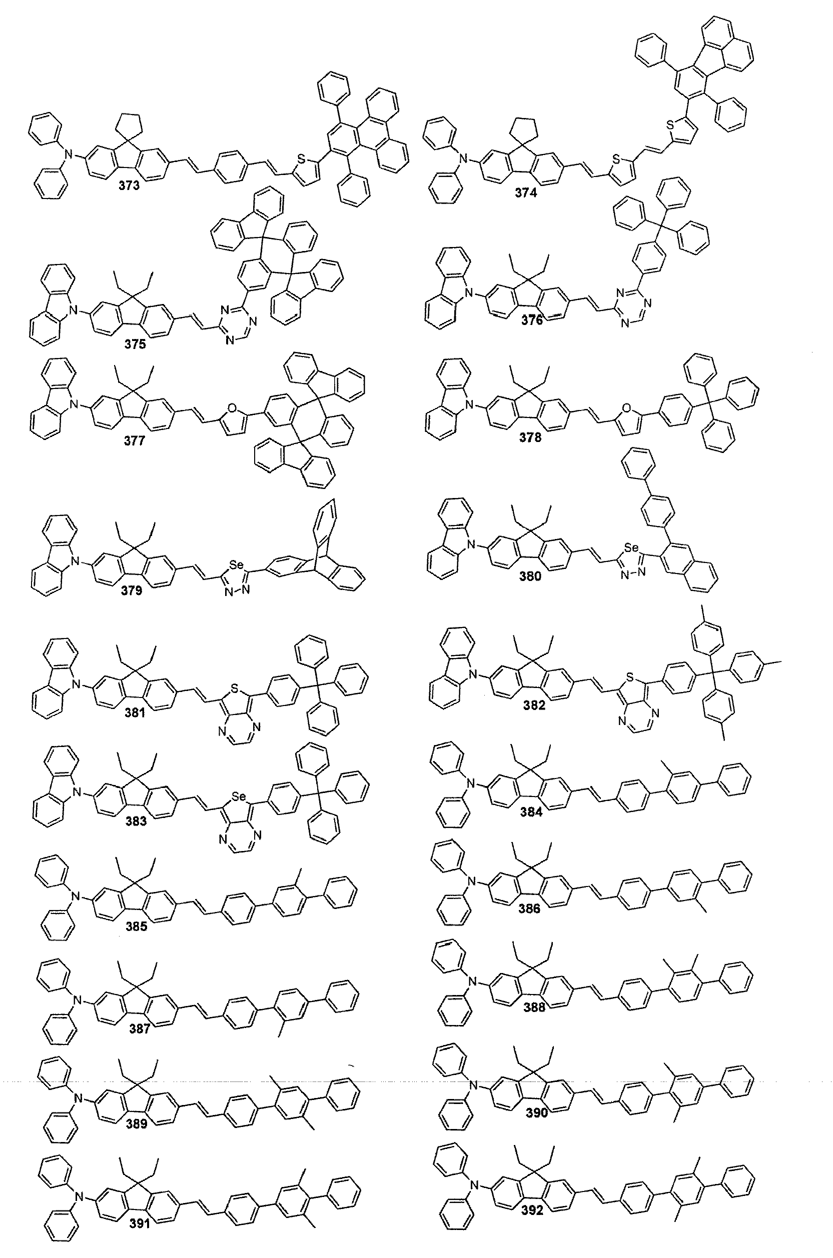

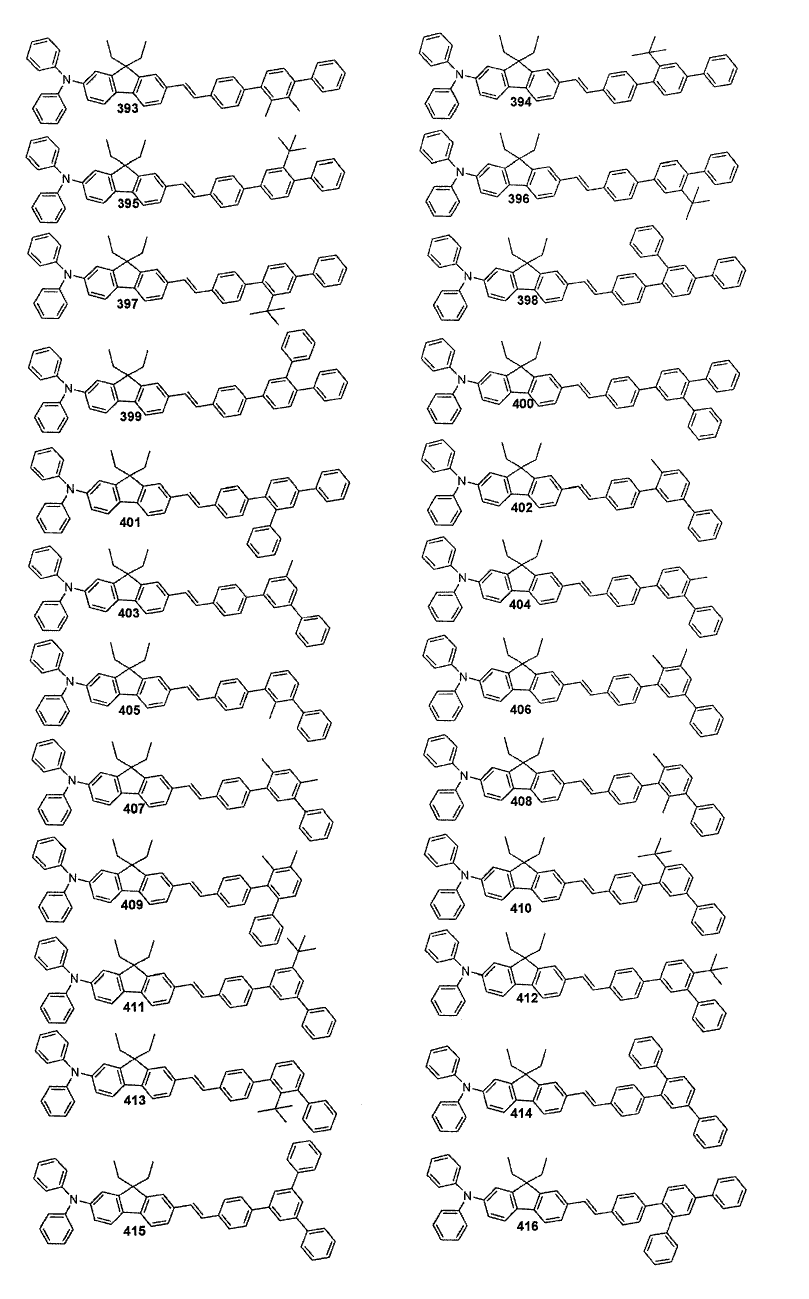

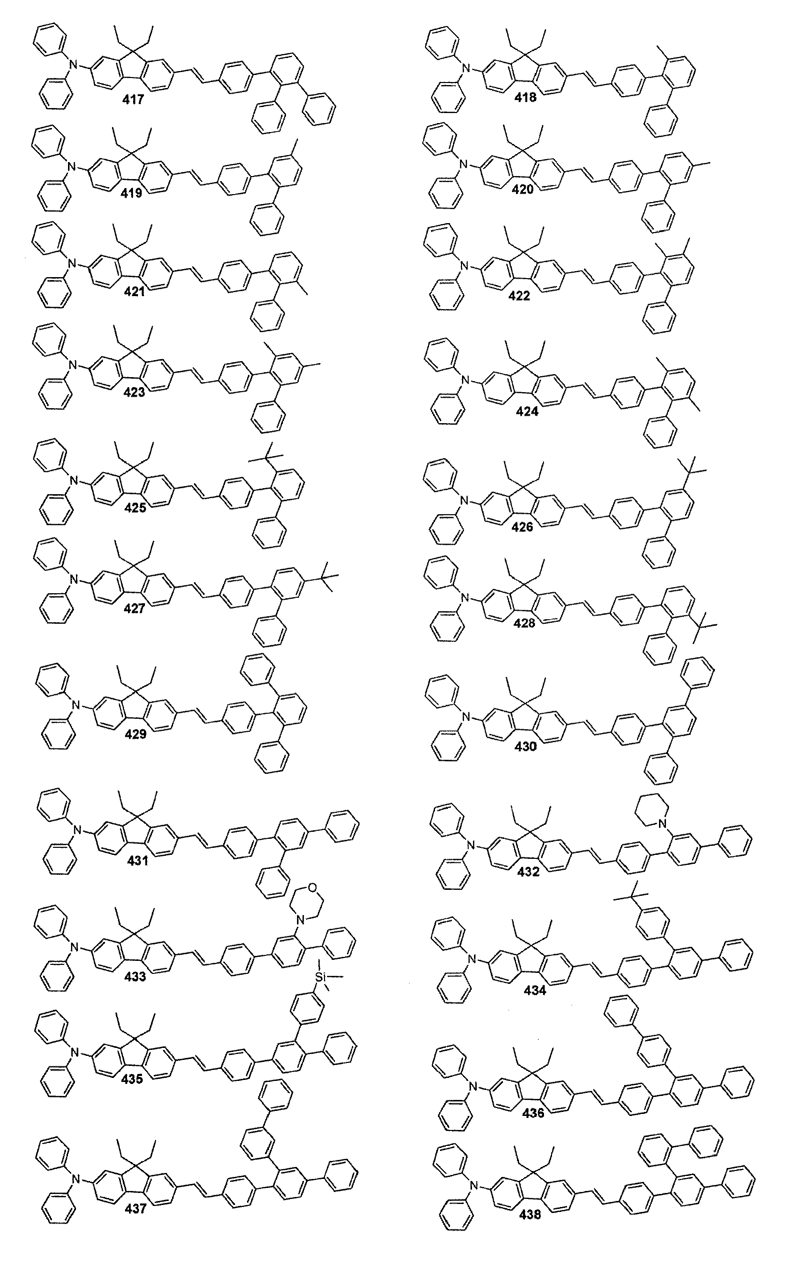

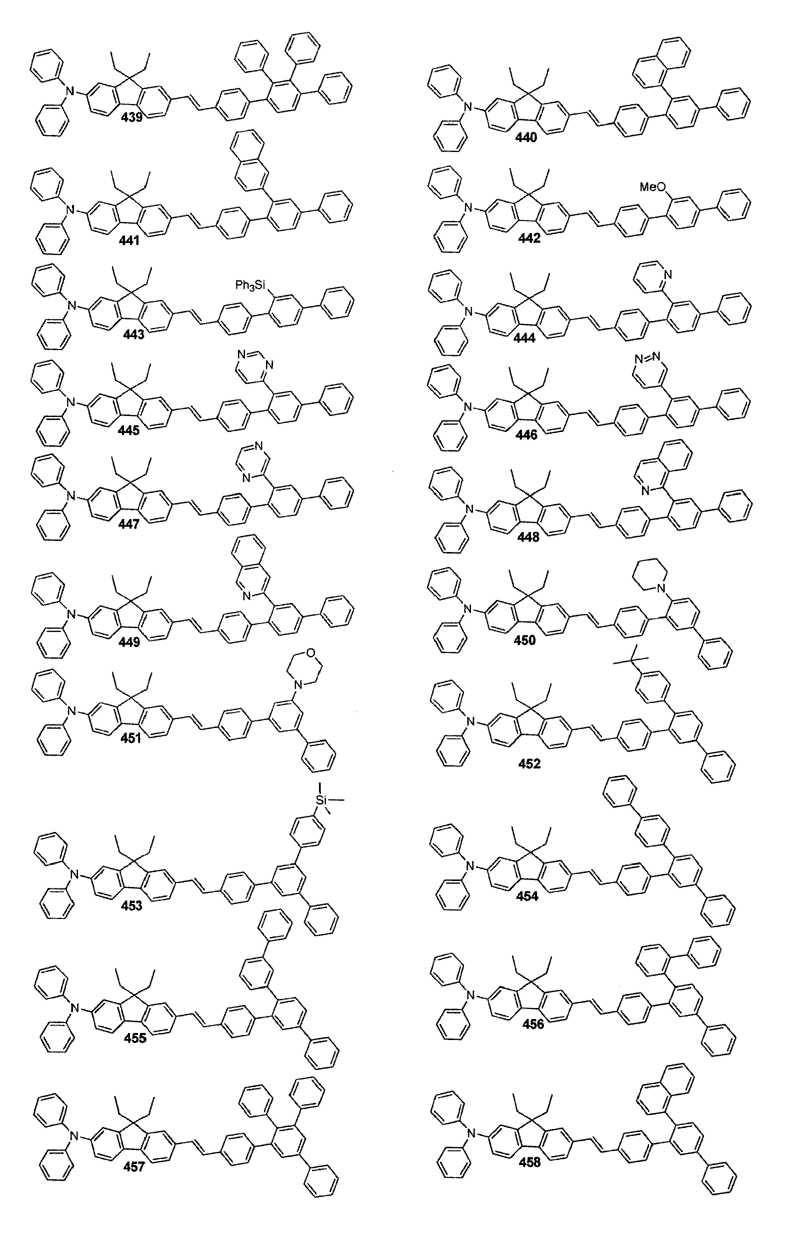

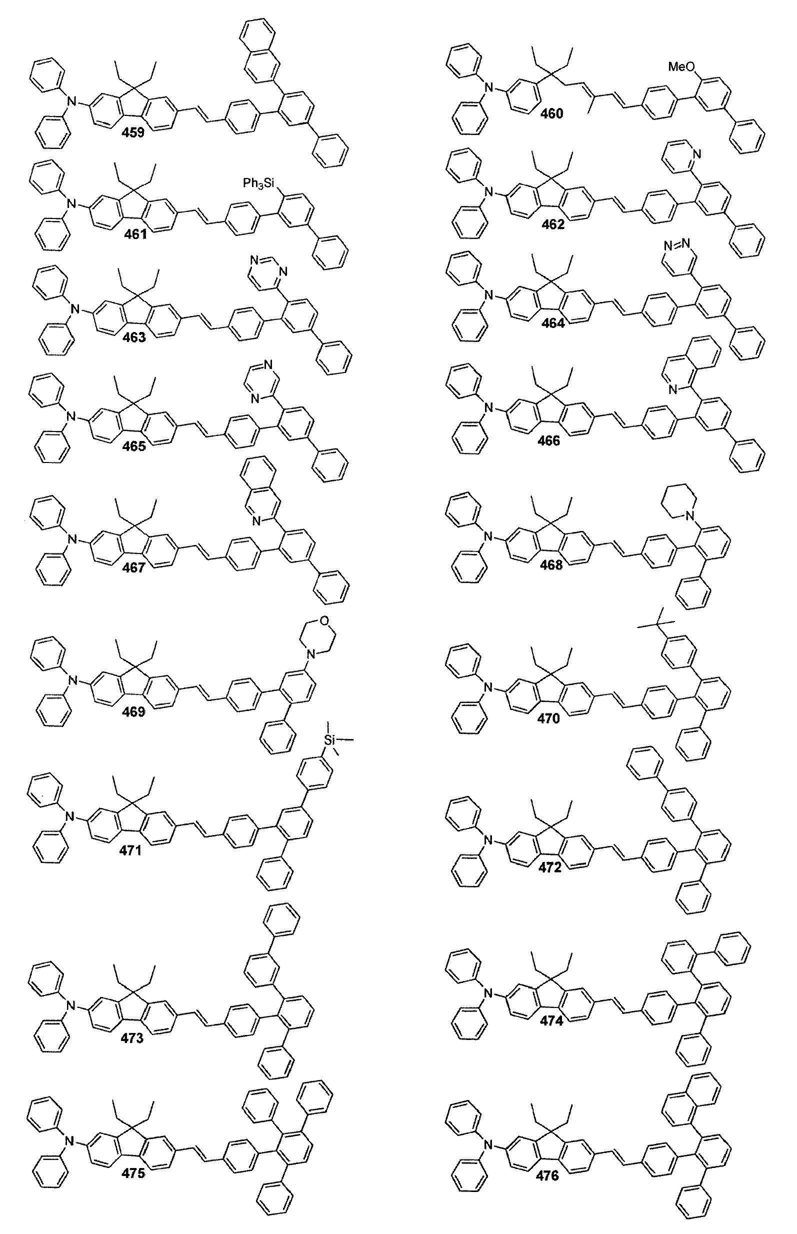

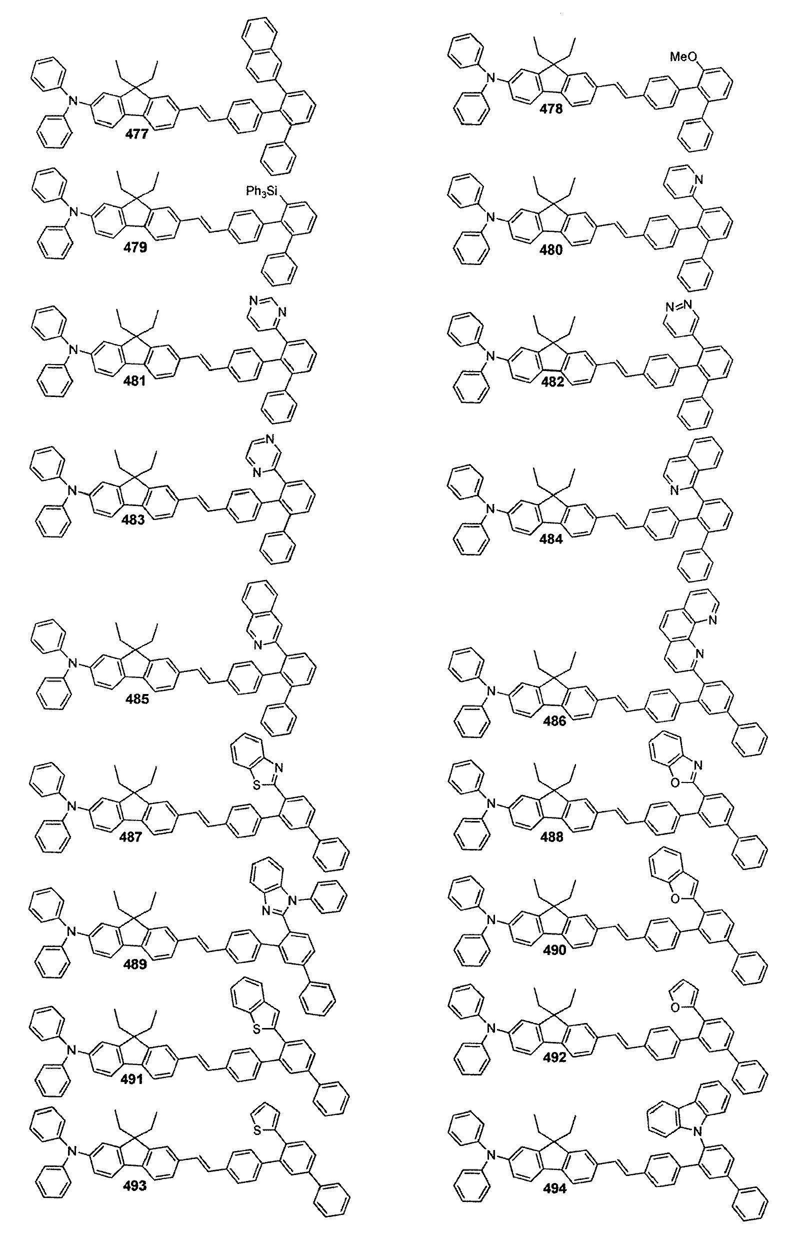

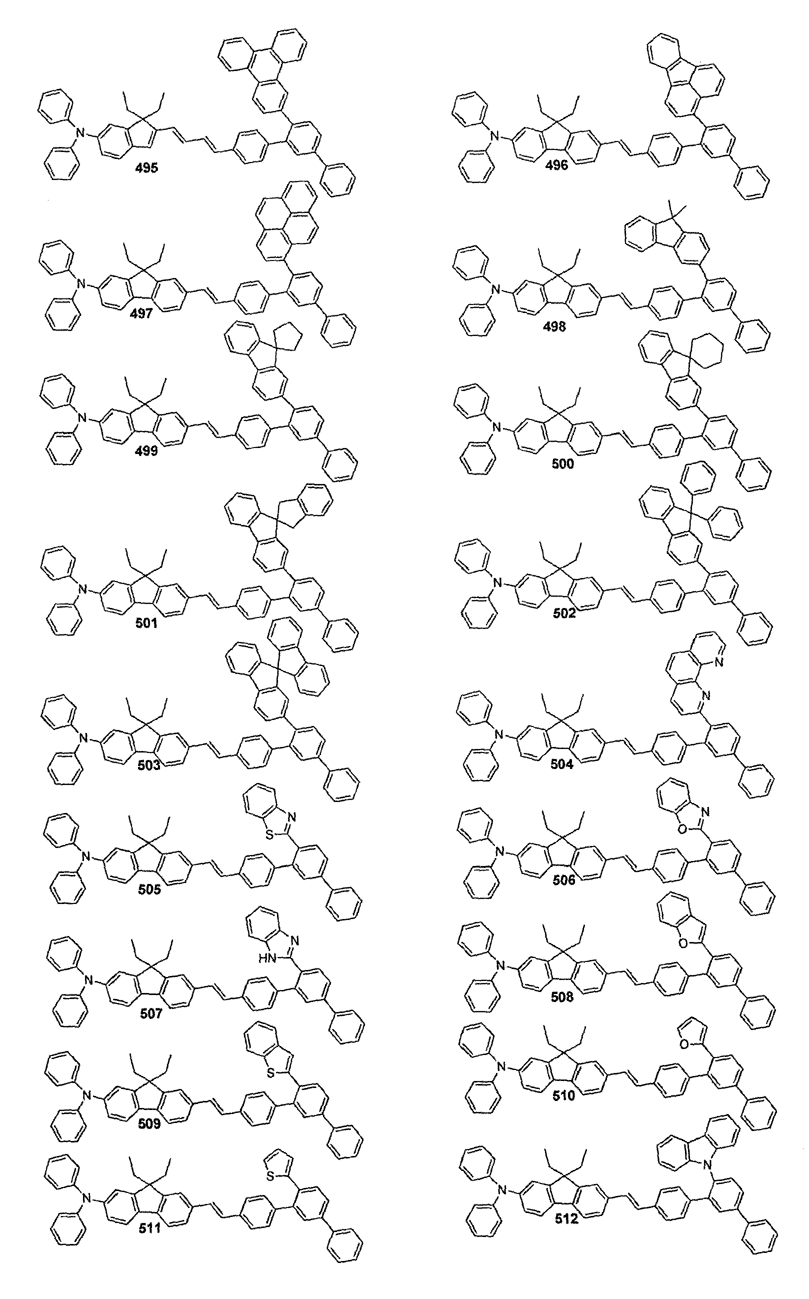

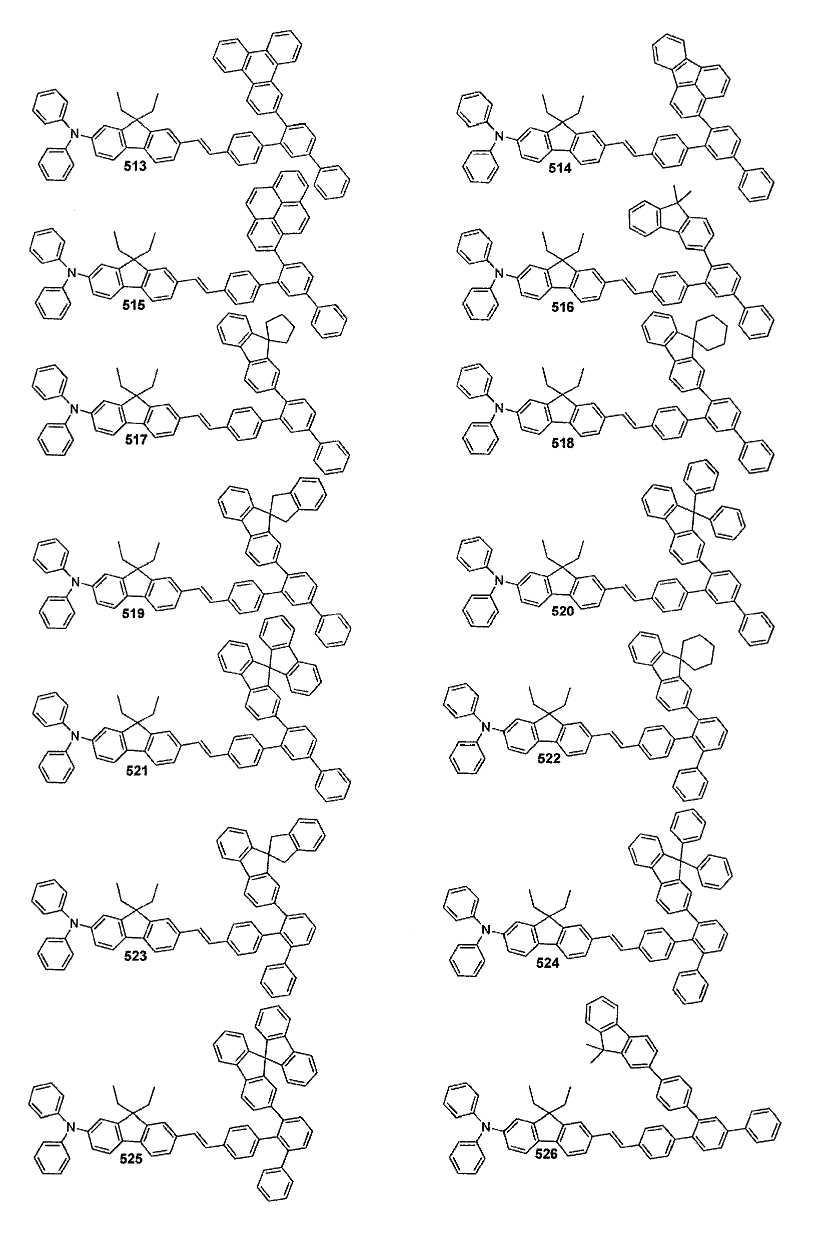

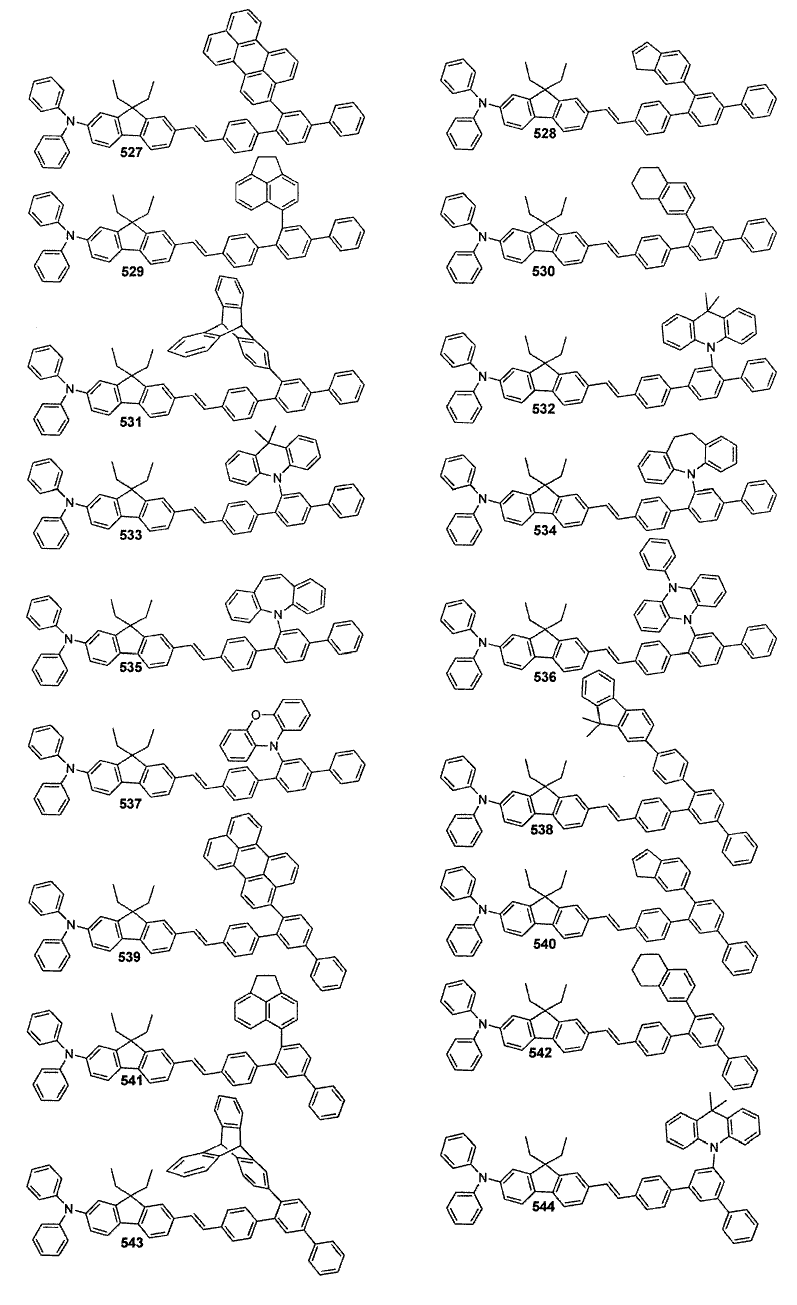

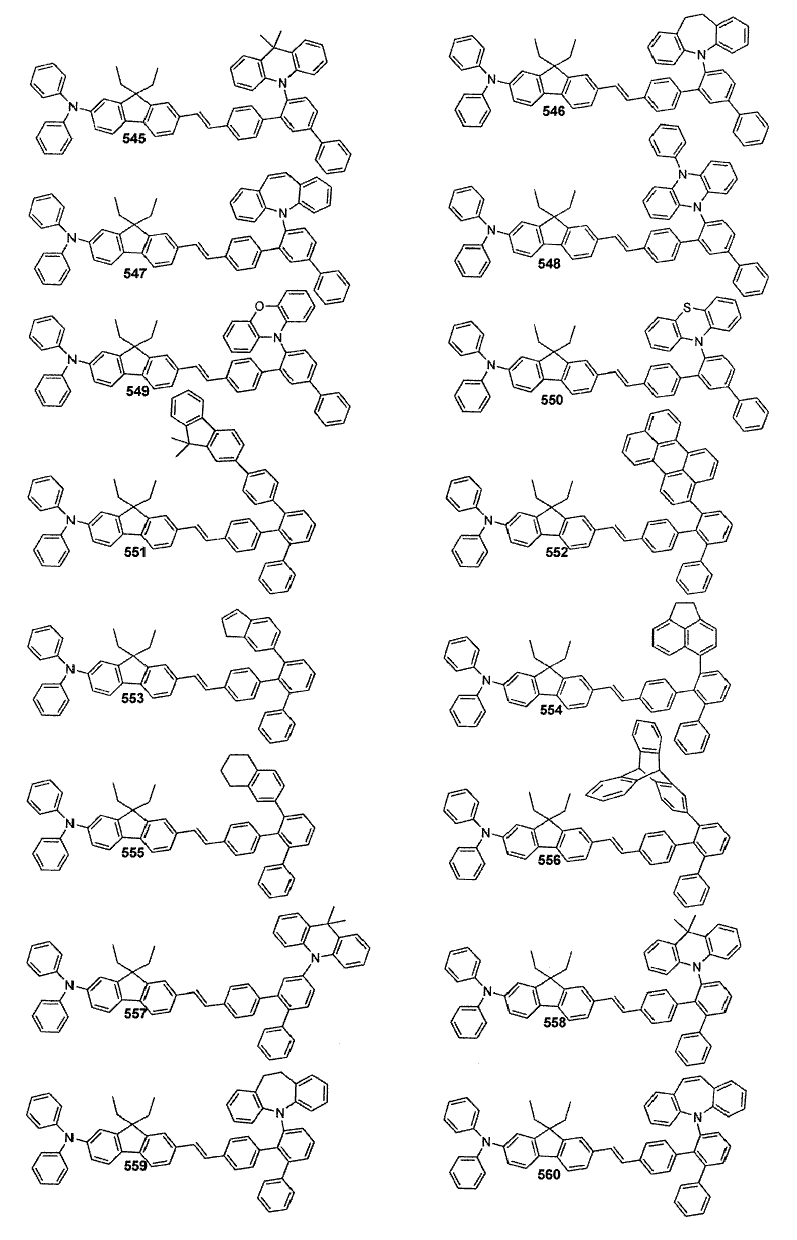

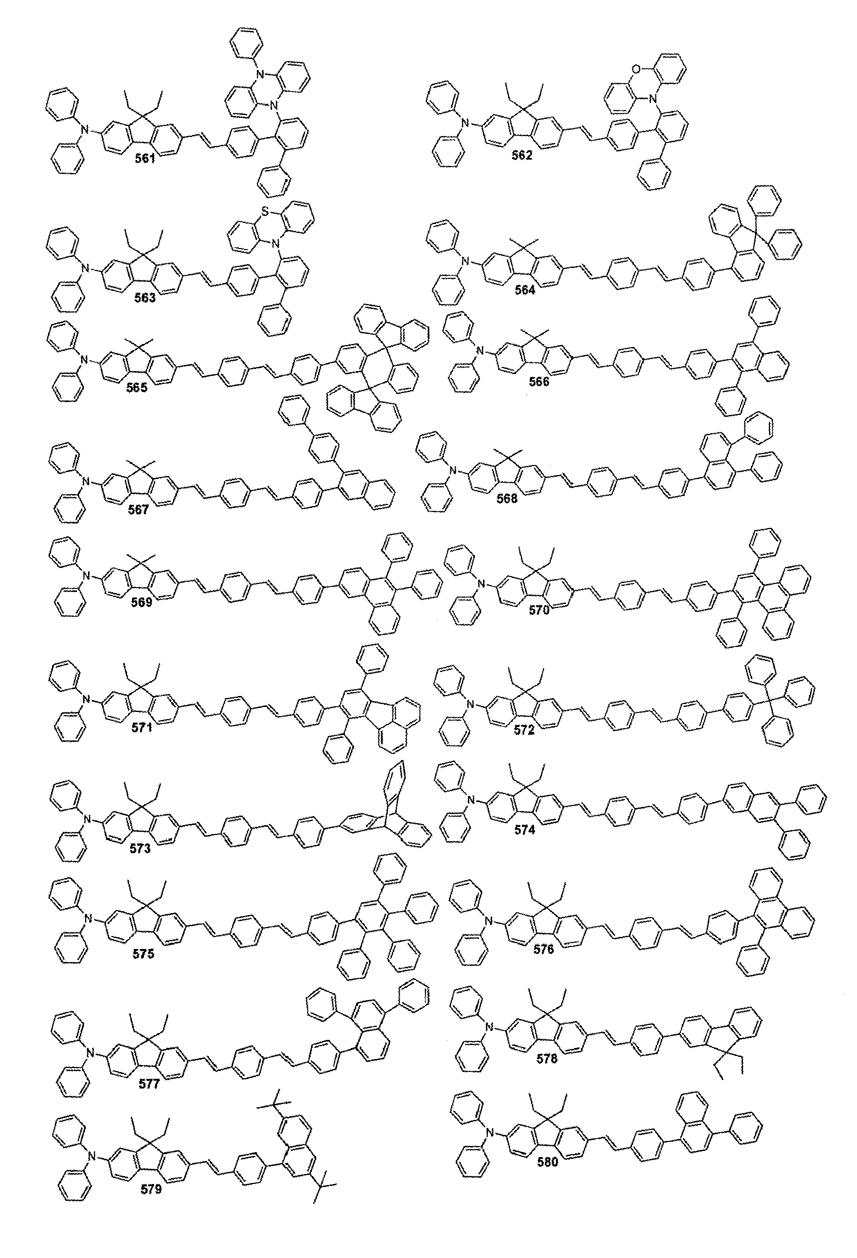

The organic electroluminescent compounds according to the present invention can be prepared, for example, according to the procedure illustrated by Reaction Scheme (1), without restriction.

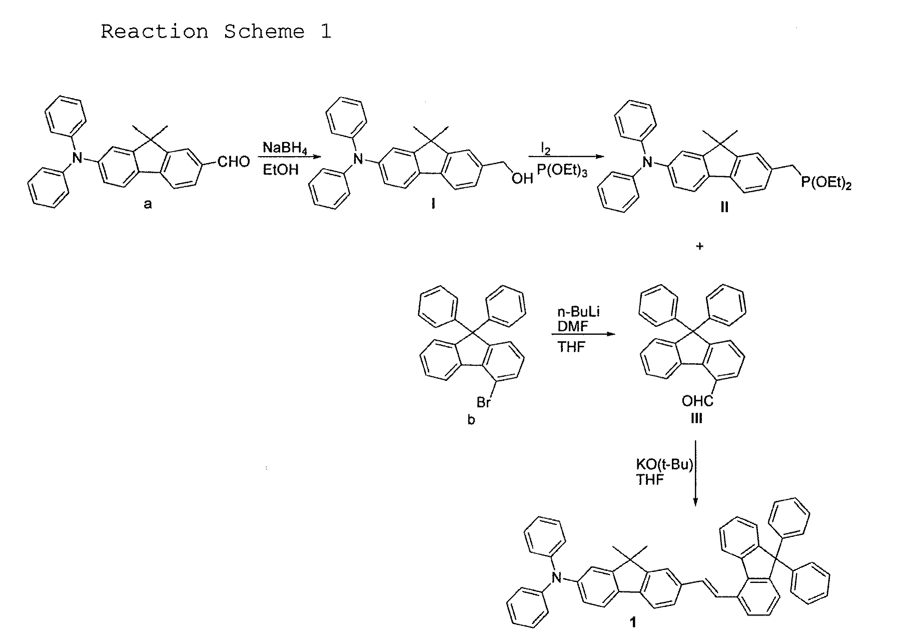

Further, the present invention provides organic solar cells, which comprise one or more organic electroluminescent compound(s) represented by Chemical Formula (1).

The present invention also provides an organic electroluminescent device which is comprised of a first electrode; a second electrode; and at least one organic layer(s) interposed between the first electrode and the second electrode; wherein the organic layer comprises one or more organic electroluminescent compound(s) represented by Chemical Formula (1).

The organic electroluminescent device according to the present invention is **characterized in that** the organic layer comprises an electroluminescent layer, which contains one or more organic electroluminescent compound(s) represented by Chemical Formula (1) as electroluminescent dopant, and one or more host(s). The host to be applied to an organic electroluminescent device according to the present invention is not particularly restrictive, but preferably selected from the compounds represented by Chemical Formula (3) or (4):

(Ar₁₁)ₐ-L₁-(Ar₁₂)_{b} Chemical Formula 3

(Ar₁₃)_{c}-L₂-(Ar₁₄)_{d} Chemical Formula 4

wherein, L₁ represents (C6-C60)arylene or (C4-C60)heteroarylene;
L₂ represents anthracenylene;
Ar₁₁ through Ar₁₄ are independently selected from hydrogen, (Cl-C60)alkyl, (C1-C60)alkoxy, halogen, (C4-C60)heteroaryl, (C5-C60)cycloalkyl and (C6-C60)aryl; the cycloalkyl, aryl or heteroaryl of Ar₁₁ through Ar₁₄ may be further substituted by one or more substituent(s) selected from a group consisting of (C6-C60)aryl or (C4-C60)heteroaryl with or without one or more substituent(s) selected from a group consisting of (C1-C60)alkyl, halo(C1-C60)alkyl, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
a, b, c and d independently represent an integer from 0 to 4.

The host of Chemical Formula (3) or (4) can be exemplified by anthracene derivatives and benz[a]anthracene derivatives represented by one of Chemical Formulas (5) to (7) : 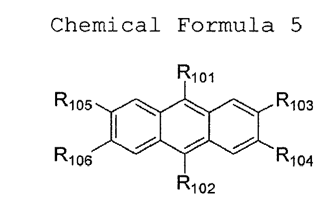 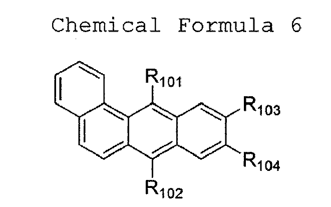 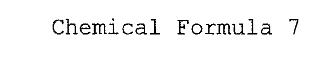 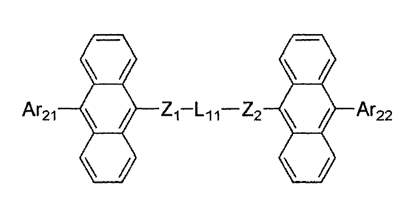 wherein, R₁₀₁ and R₁₀₂ independently represent hydrogen, (C1-C60)alkyl, halogen, (C6-C60)aryl, (C4-C60)heteroaryl, 5- or 6-membered heterocycloalkyl containing one or more heteroatom(s) selected from N, O and S, or (C3-C60)cycloalkyl; the aryl or heteroaryl of R₁₀₁ and R₁₀₂ may be further substituted by one or more substituent(s) selected from a group consisting of (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsily, di(C1-C60)alkyl(C6-C60)arylsilyl and tri(C6-C60)arylsilyl;
R₁₀₃ through R₁₀₆ independently represent hydrogen, (C1-C60)alkyl, (C1-C60)alkoxy, halogen, (C4-C60)heteroaryl, (C5-C60)cycloalkyl or (C6-C60)aryl; the heteroaryl, cycloalkyl or aryl of R₁₀₃ through R₁₀₆ may be further substituted by one or more substituent(s) selected from a group consisting of (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
Z₁ and Z₂ independently represent a chemical bond, or (C6-C60)arylene with or without one or more substituent(s) selected from (C1-C60)alkyl, (C1-C60)alkoxy, (C6-C60)aryl, (C4-C60)heteroaryl and halogen;
Ar₂₁ and Ar₂₂ independently represent (C4-C60)heteroaryl or aryl selected from the following structures; 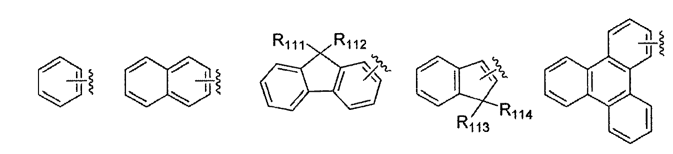 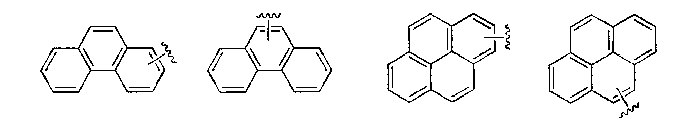 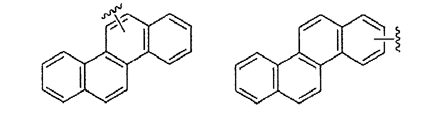 the aryl or heteroaryl of Ar₂₁ and Ar₂₂ may be substituted by one or more substituent(s) selected from (C1-C60)alkyl, (C1-C60)alkoxy, (C6-C60)aryl and (C4-C60)heteroaryl;
L₁₁ represents (C6-C60)arylene, (C4-C60)heteroarylene or a compound having the following structure; 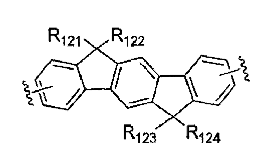 the arylene or heteroarylene of L₁₁ may be substituted by one or more substituent(s) selected from (C1-C60)alkyl, (C1-C60)alkoxy, (C6-C60)aryl, (C4-C60)heteroaryl and halogen;
R₁₁₁, R₁₁₂, R₁₁₃ and R₁₁₄ independently represent hydrogen, (C1-C60)alkyl or (C6-C60)aryl, or they may be linked to an adjacent substituent via (C3-C60)alkylene or (C3-C60)alkenylene with or without a fused ring to form an alicyclic ring, or a monocyclic or polycyclic aromatic ring; and
R₁₂₁, R₁₂₂, R₁₂₃ and R₁₂₄ independently represent hydrogen, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

The electroluminescent layer means the layer where electroluminescence occurs, and it may be a single layer or a multi-layer consisting of two or more layers laminated. When a mixture of host-dopant is used according to the constitution of the present invention, noticeable improvement in luminous efficiency by the electroluminescent host according to the invention may be confirmed. Those results can be achieved by doping concentration of 0.5 to 10% by weight. The host according to the present invention exhibits higher hole and electron conductivity, and excellent stability of the material as compared to other conventional host materials, and provides improved device life as well as luminous efficiency.

Thus, it can be described that use of the compound represented by one of Chemical Formulas (5) to (7) as electroluminescent host significantly supplements electronic drawback of the organic electroluminescent compounds of Chemical Formula (1) according to the present invention.

The host compounds represented by one of Chemical Formulas (5) to (7) can be exemplified by the following compounds, but are not restricted thereto.

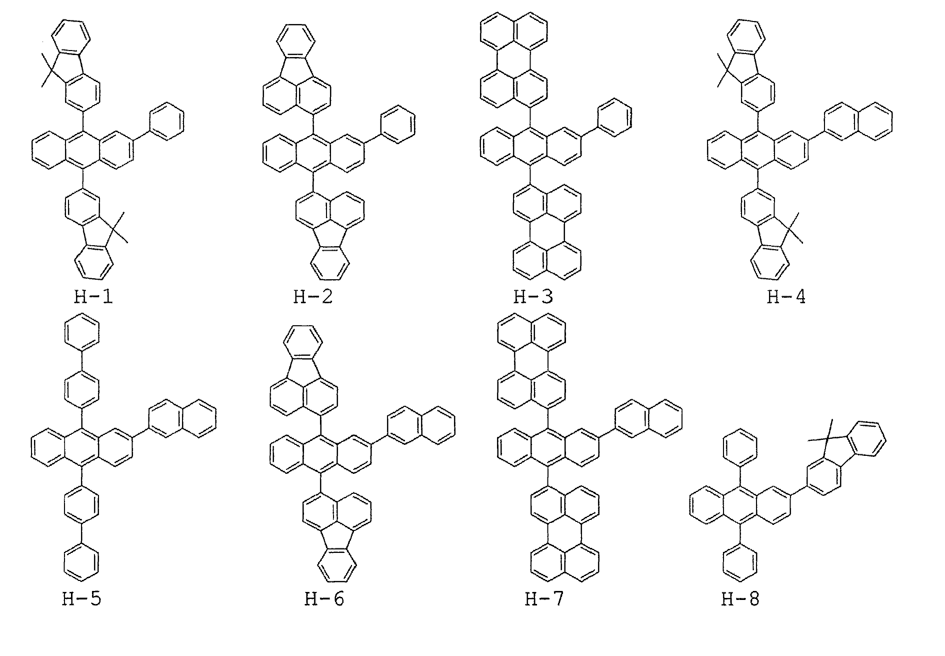

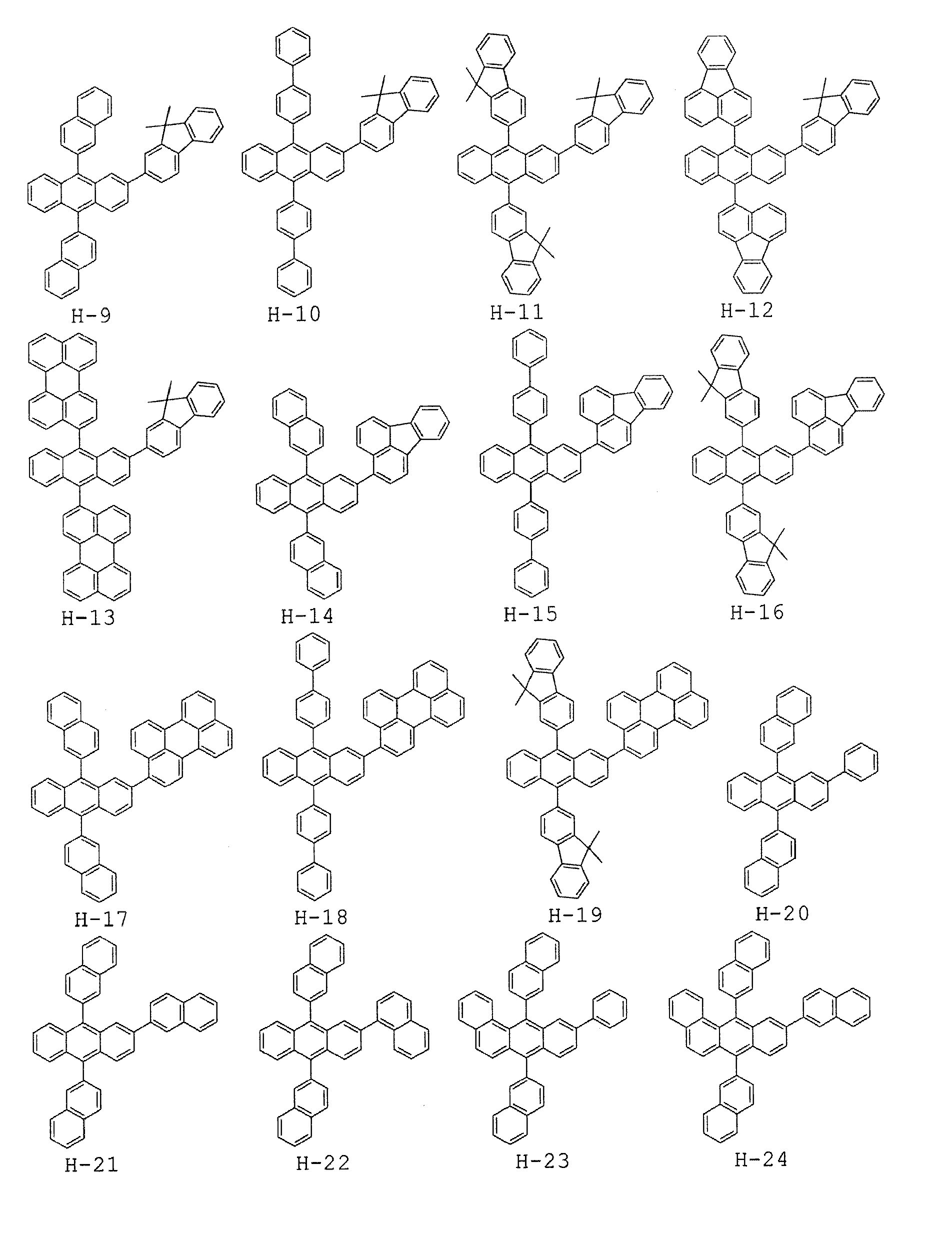

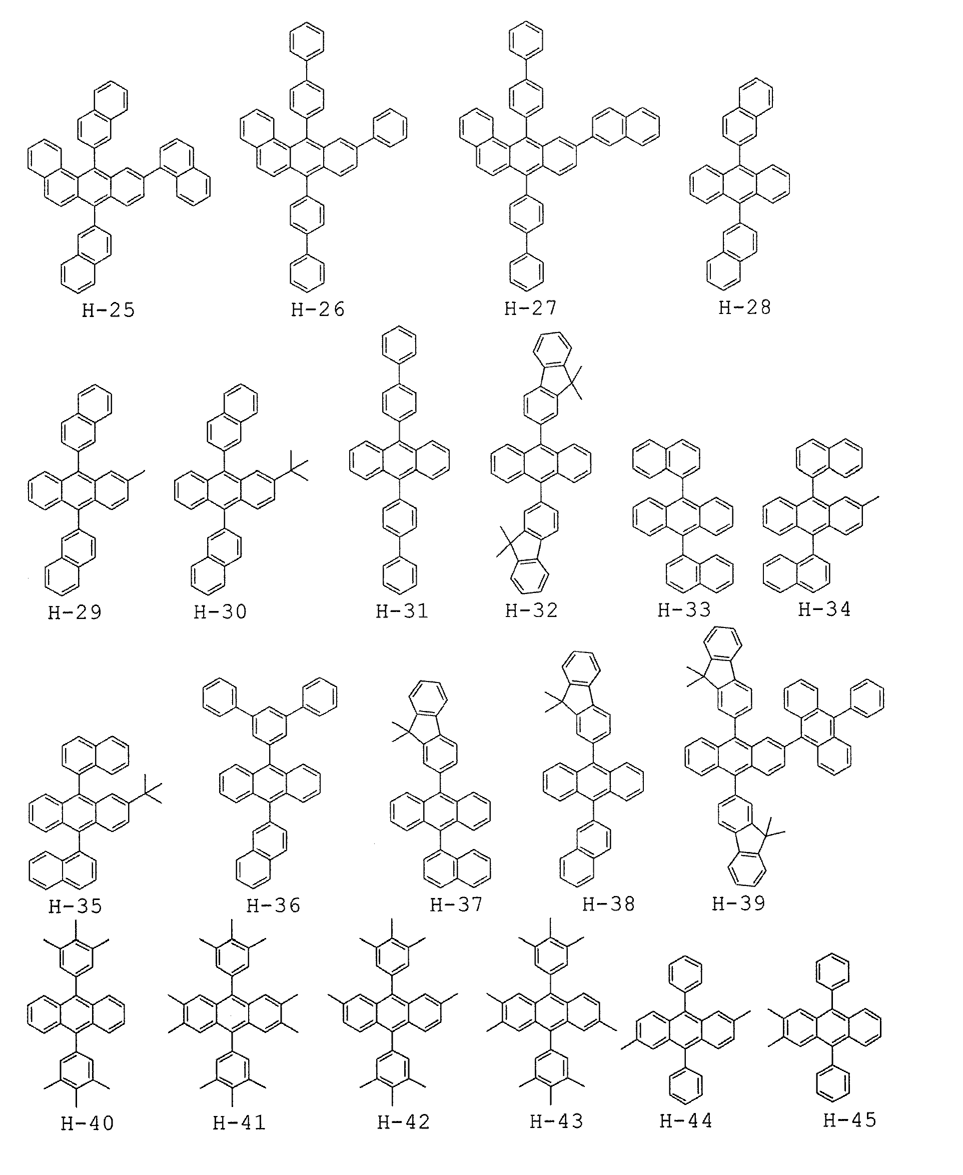

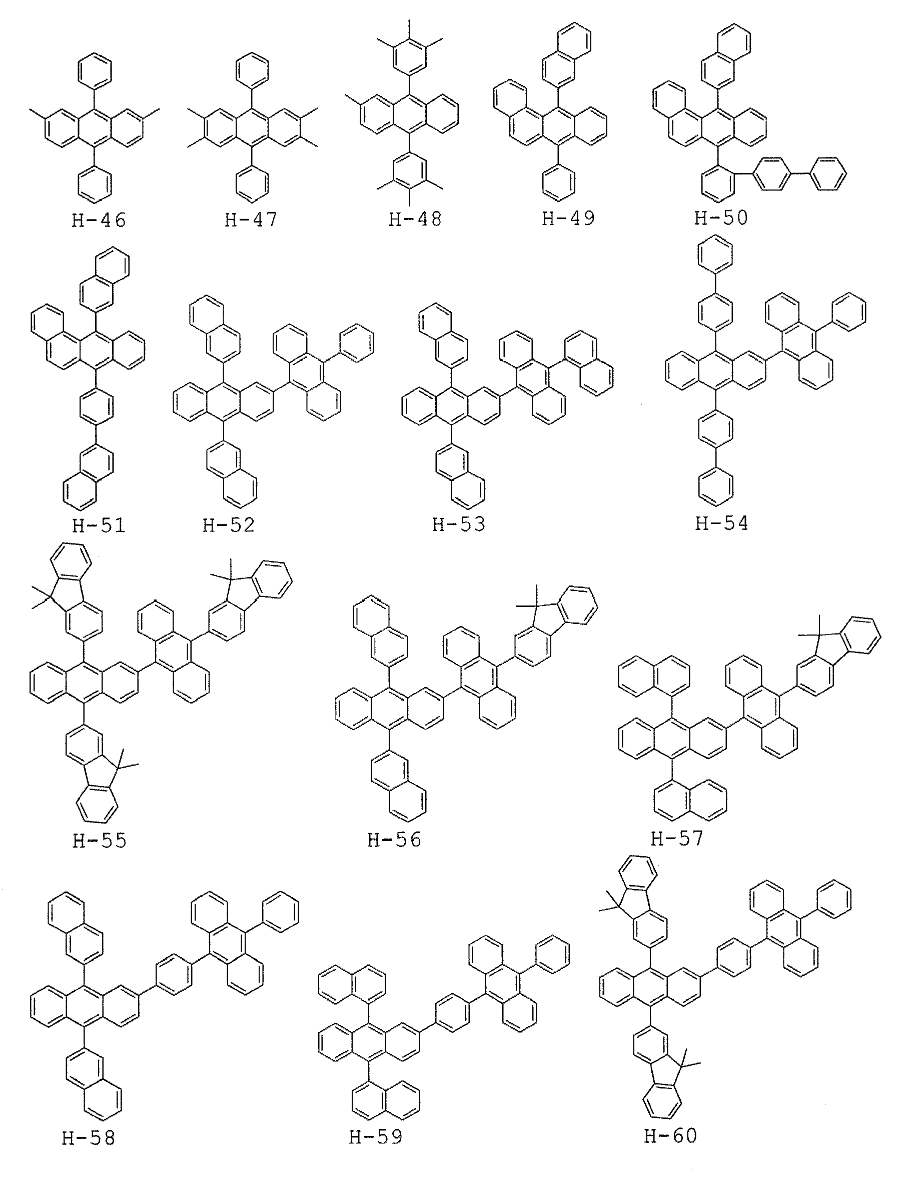

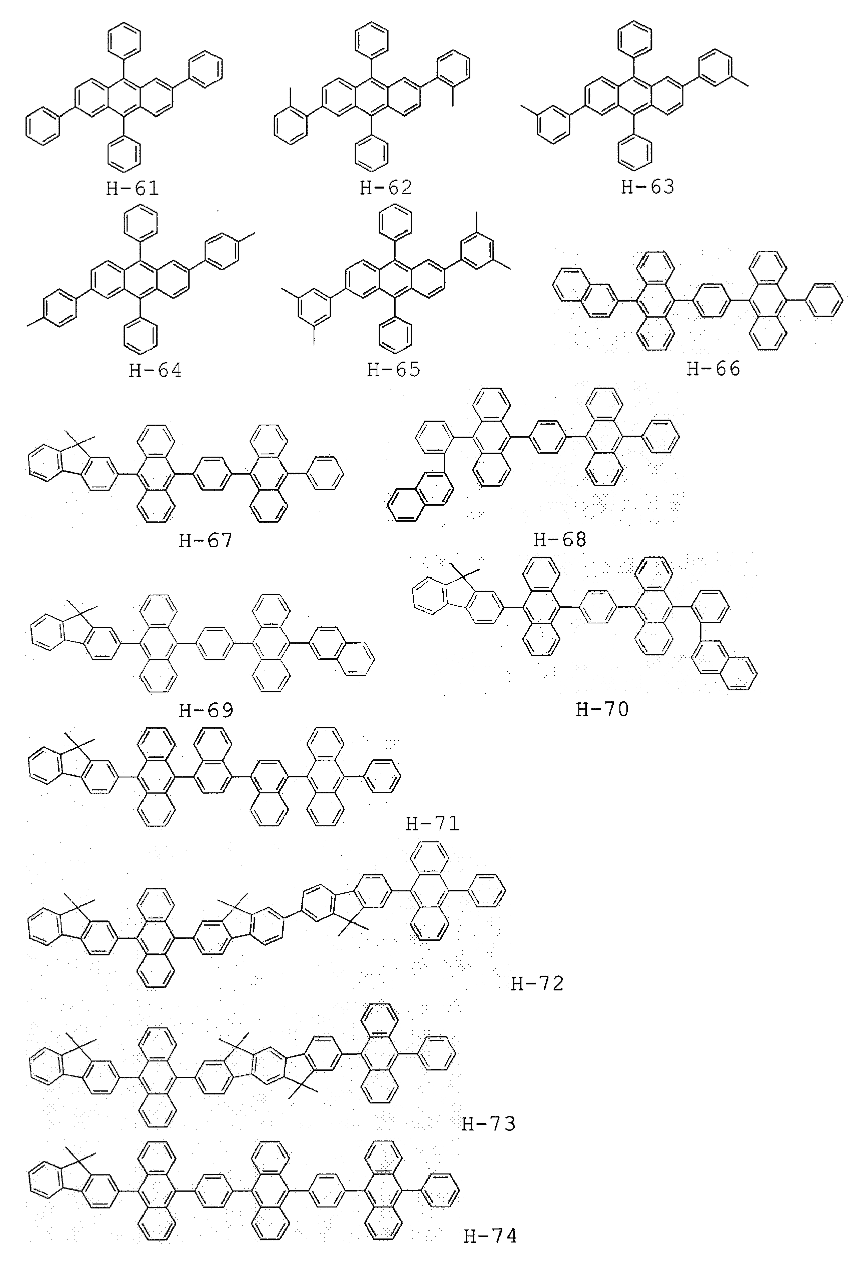

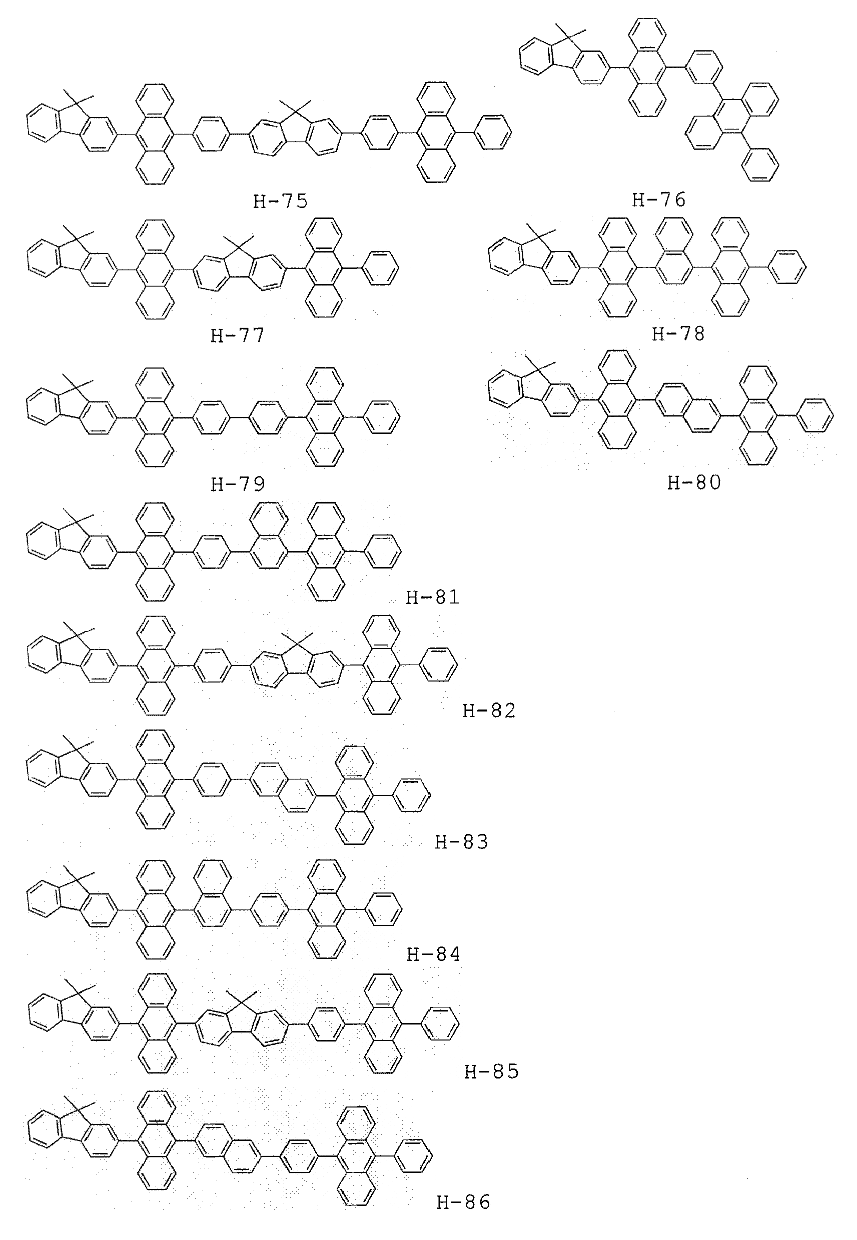

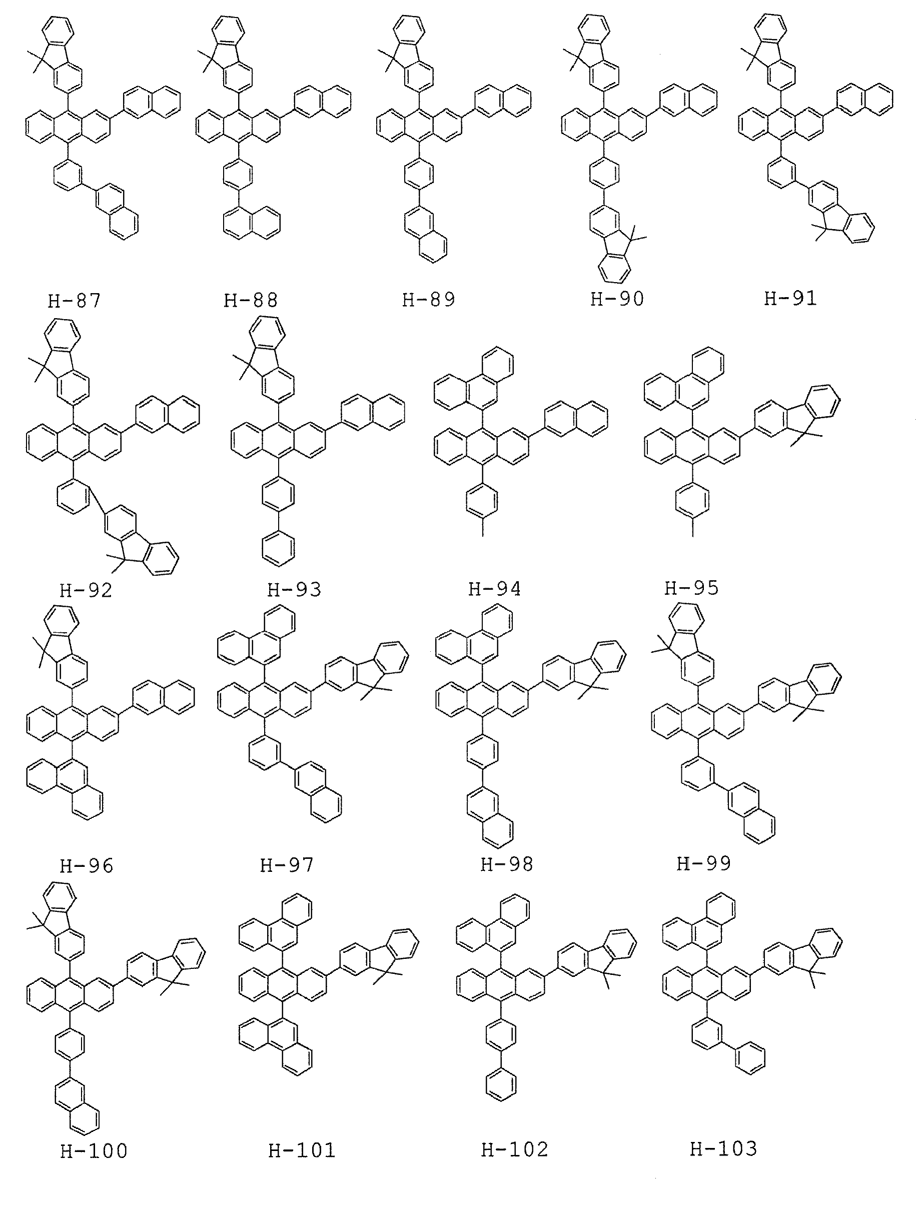

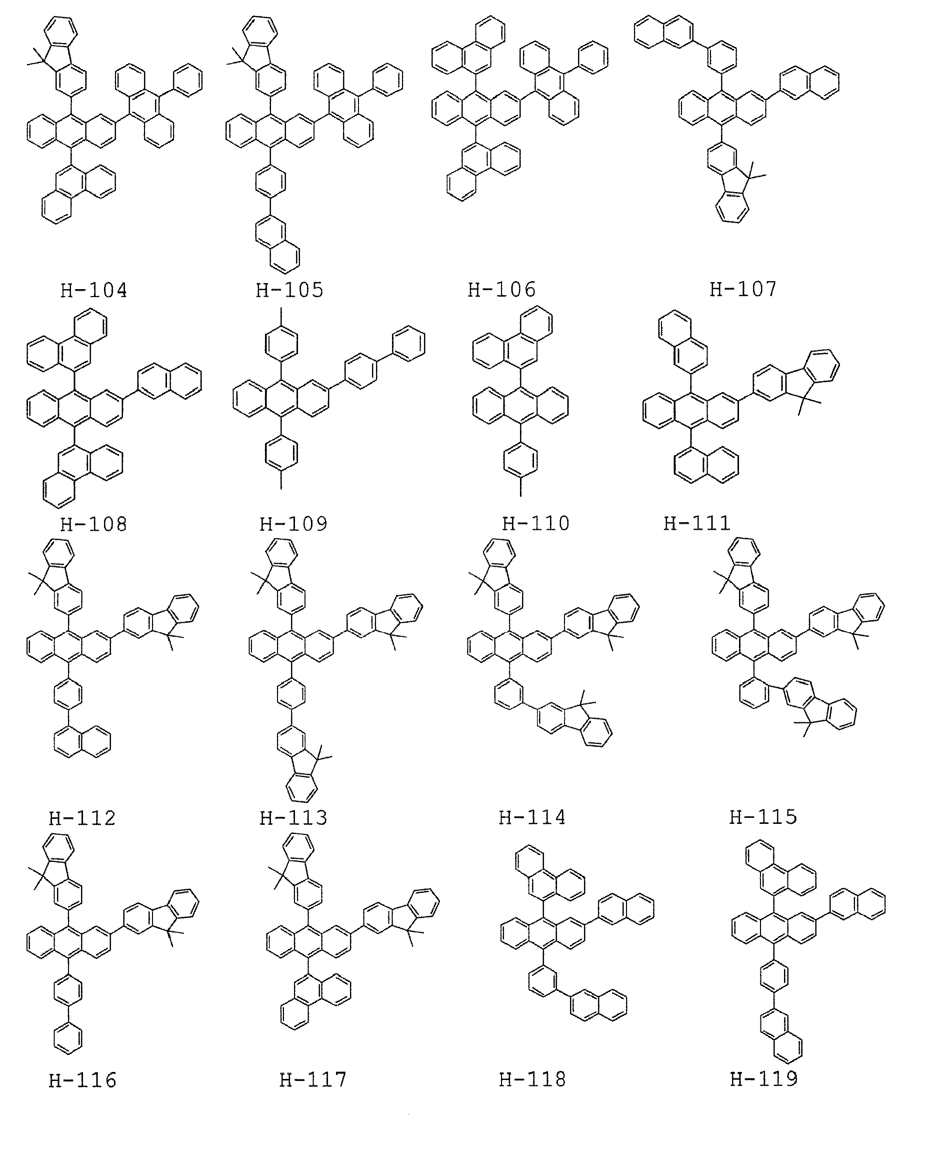

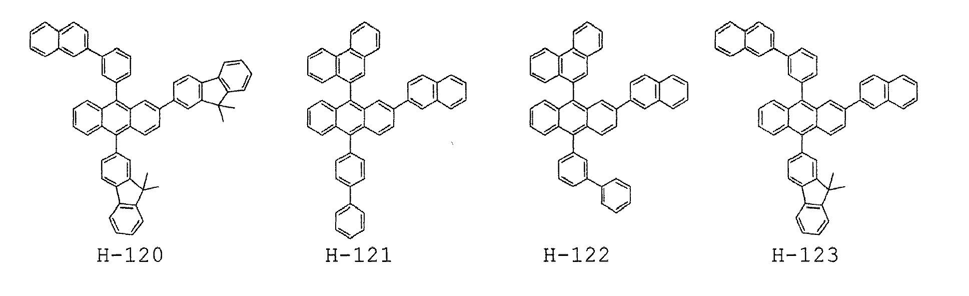

The organic electroluminescent device according to the present invention may further comprise one or more compound(s) selected from a group consisting of arylamine compounds and styrylarylamine compounds, in addition to the organic electroluminescent compound represented by Chemical Formula (1). Examples of the arylamine or styrylarylamine compounds include the compounds represented by Chemical Formula (8), but they are not restricted thereto: 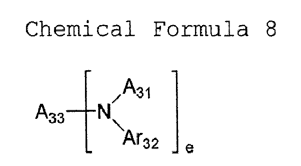 wherein, Ar₃₁ and Ar₃₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or Ar₃₁ and Ar₃₂ may be linked via (C3-C60)alkylene or (C3-C60)alkenylene with or without a fused ring to form an alicyclic ring, or a monocyclic or polycyclic aromatic ring;
when e is 1, Ar₃₃ represents (C6-C60)aryl, (C4-C60)heteroaryl or a substituent selected from the following structures: 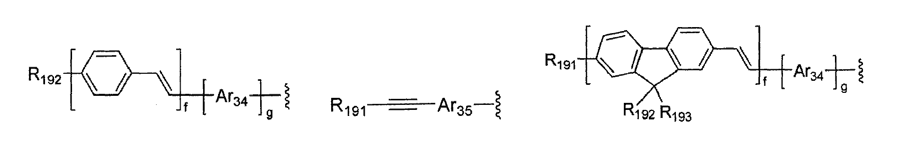 when e is 2, Ar₃₃ represents (C6-C60)arylene, (C4-C60)heteroarylene or a substituent selected from the following structures: 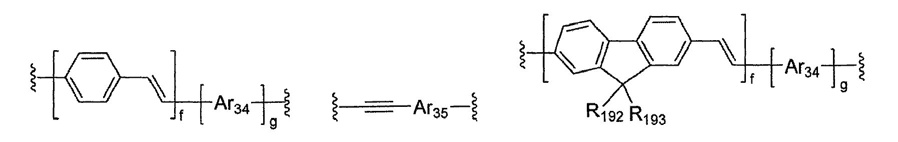 wherein, Ar₃₄ and Ar₃₅ independently represent (C6-C60)arylene or (C4-C60)heteroarylene;
R₁₉₁, R₁₉₂ and R₁₉₃ independently represent hydrogen, (C1-C60)alkyl or (C6-C60)aryl;
f is an integer from 1 to 4; g is an integer of 0 or 1; and
the alkyl, aryl, heteroaryl, arylamino, alkylamino, cycloalkyl or heterocycloalkyl of Ar₃₁ and Ar₃₂; the aryl, heteroaryl, arylene or heteroarylene of Ar₃₃; the arylene or heteroarylene of Ar₃₄ and Ar₃₅; or the alkyl or aryl of R₁₉₁ through R₁₉₃ may be further substituted by one or more substituent(s) selected from a group consisting of halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds or styrylarylamine compounds can be more specifically exemplified by the following compounds, but they are not restricted thereto.

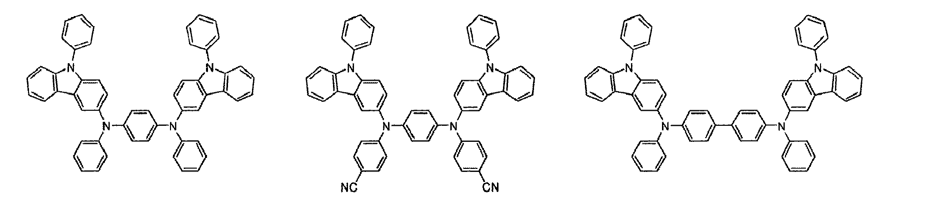

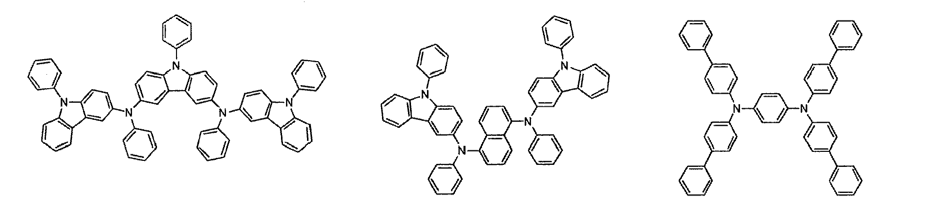

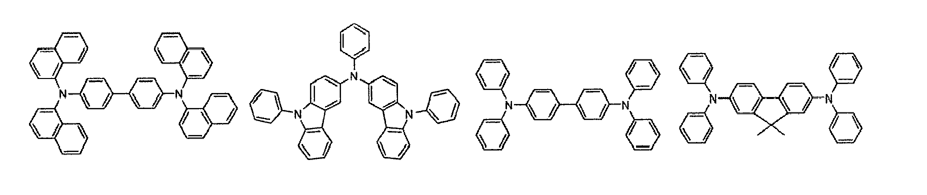

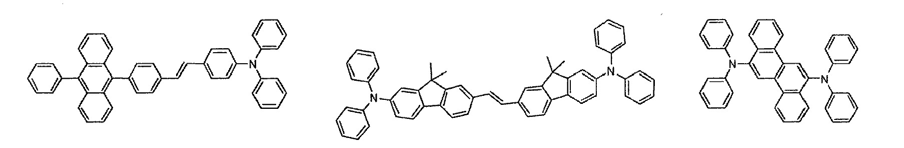

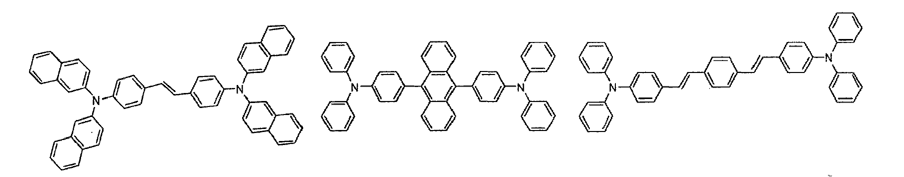

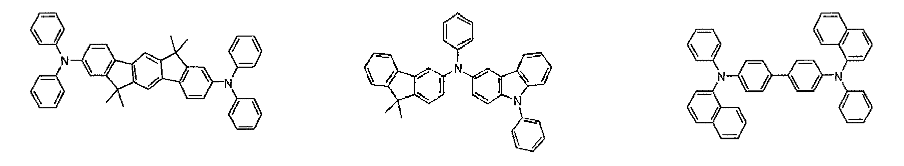

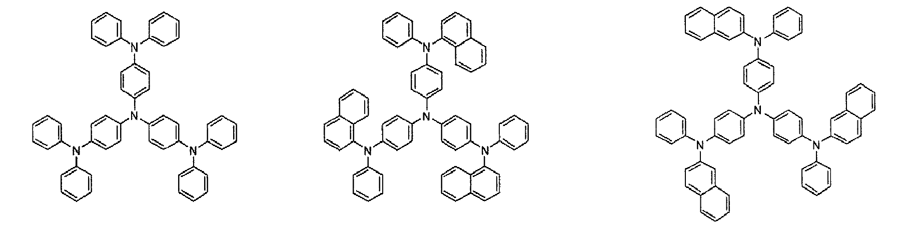

In an organic electroluminescent device according to the present invention, the organic layer may further comprise one or more metal(s) selected from a group consisting of organometals of Group 1, Group 2, 4^{th} period and 5^{th} period transition metals, lanthanide metals and d-transition elements in the Periodic Table of Elements, as well as the compound for electronic material represented by Chemical Formula (1). The organic layer may comprise an electroluminescent layer and a charge generating layer.

The present invention can realize an organic electroluminescent device having a pixel structure of independent light-emitting mode, which comprises an organic electroluminescent device containing the organic electroluminescent compound represented by Chemical Formula (1) as a sub-pixel, and one or more sub-pixel(s) comprising one or more metallic compound(s) selected from a group consisting of Ir, Pt, Pd, Rh, Re, Os, Tl, Pb, Bi, In, Sn, Sb, Te, Au and Ag, patterned in parallel at the same time.

Further, the organic layer may comprise, in addition to the organic electroluminescent compound of Chemical Formula (1), the compounds having the electroluminescent peak of wavelength of 480 to 560 nm, or those having the electroluminescent peak of wavelength of not less than 560 nm, at the same time, to form a white electroluminescent device. Those compounds can be exemplified by the compounds represented by one of Chemical Formulas (9) to (15), without restriction.

M¹L²¹L²²L²³ Chemical Formula 9

In Chemical Formula (9), M¹ is selected from metals of Group 7, 8, 9, 10, 11, 13, 14, 15 and 16 in the Periodic Table of Elements, and ligands L²¹, L²² and L²³ are independently selected from the following structures: 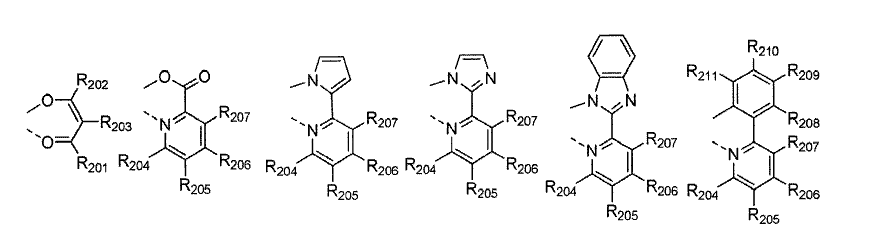 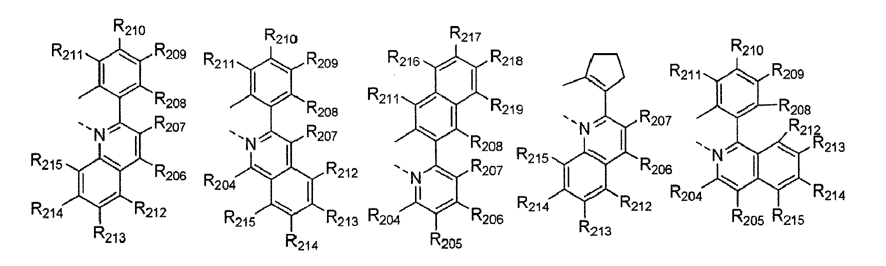 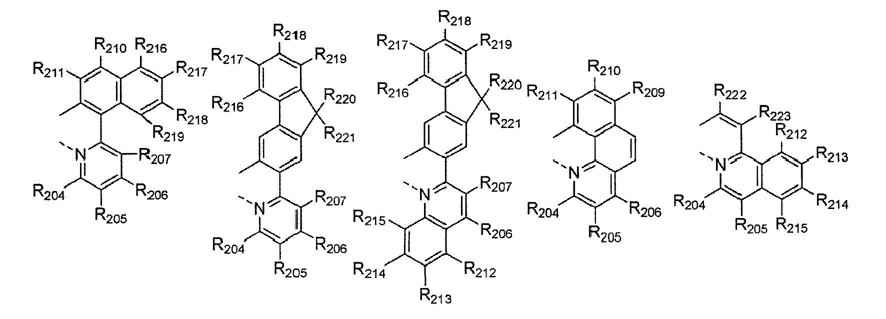 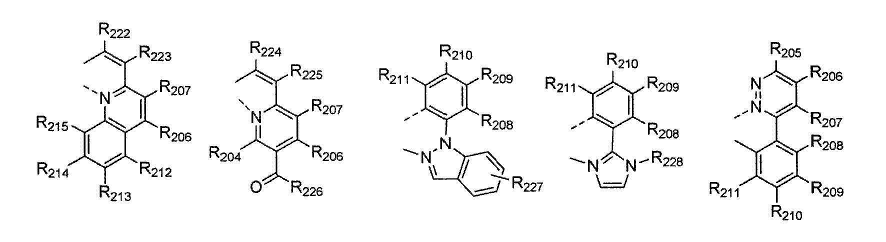 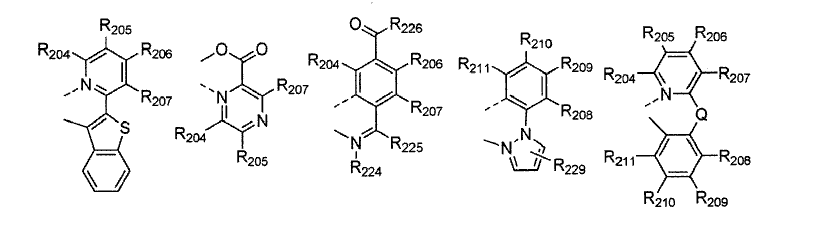 wherein, R₂₀₁ through R₂₀₃ independently represent hydrogen, (C1-C60)alkyl with or without halogen substituent(s), (C6-C60)aryl with or without (C1-C60)alkyl substituent(s), or halogen;
R₂₀₄ through R₂₁₉ independently represent hydrogen, (C1-C60)alkyl, (C1-C30)alkoxy, (C3-C60)cycloalkyl, (C2-C30)alkenyl, (C6-C60)aryl, mono or di(C1-C30)alkylamin mono or di(C6-30)arylamino, SF₅, tri(C1-C30)alkylsilyl, di(C1-C30)alkyl(C6-C30)arylsilyl, tri(C6-C30)arylsilyl, cyano or halogen; the alkyl, cycloalkyl, alkenyl or aryl of R₂₀₄ through R₂₁₉ may be further substituted by one or more substituent(s) selected from (C1-C60)alkyl, (C6-C60)aryl and halogen;
R₂₂₀ through R₂₂₃ independently represent hydrogen, (C1-C60)alkyl with or without halogen substituent(s), (C6-C60)aryl with or without (C1-C60)alkyl substituent(s);
R₂₂₄ and R₂₂₅ independently represent hydrogen, (C1-C60) alkyl, (C6-C60)aryl or halogen, or R₂₂₄ and R₂₂₅ may be linked via (C3-C12)alkylene or (C3-C12)alkenylene with or without a fused ring to form an alicyclic ring, or a monocyclic or polycyclic aromatic ring; the alkyl or aryl of R₂₂₄ and R₂₂₅, or the alicyclic ring, or the monocyclic or polycyclic aromatic ring formed therefrom via (C3-C12)alkylene or (C3-C12)alkenylene with or without a fused ring may be further substituted by one or more substituent(s) selected from (C1-C60)alkyl with or without halogen substituent(s), (C1-C30)alkoxy, halogen, tri(C1-C30)alkylsilyl, tri(C6-C30)arylsilyl and (C6-C60)aryl;
R₂₂₆ represents (C1-C60)alkyl, (C6-C60)aryl, (C5-C60)heteroaryl or halogen;
R₂₂₇ through R₂₂₉ independently represent hydrogen, (C1-C60)alkyl, (C6-C60)aryl or halogen; the alkyl or aryl of R₂₂₆ through R₂₂₉ may be further substituted by halogen or (C1-C60)alkyl;
Q represents 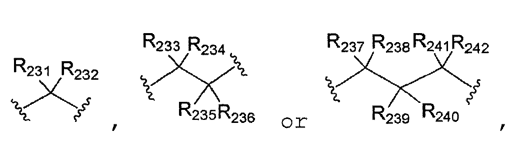 and R₂₃₁ through R₂₄₂ independently represent hydrogen, (C1-C60)alkyl with or without halogen substituent(s), (C1-C30)alkoxy, halogen, (C6-C60)aryl, cyano or (C5-C60)cycloalkyl, or each of R₂₃₁ through R₂₄₂ may be linked to an adjacent substituent via alkylene or alkenylene to form a (C5-C7) spiro-ring or a (C5-C9) fused ring, or each of them may be linked to R₂₀₇ or R₂₀₈ via alkylene or alkenylene to form a (C5-C7) fused ring.

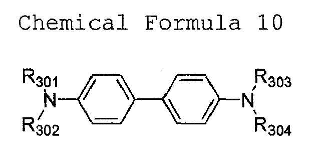

In Chemical Formula (10), R₃₀₁ through R₃₀₄ independently represent (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring; and the alkyl or aryl of R₃₀₁ through R₃₀₄, or the alicyclic ring, or the monocyclic or polycyclic aromatic ring formed therefrom by linkage via (C3-C60)alkylene or (C3-C60)alkenylene with or without a fused ring may be further substituted by one or more substituent(s) selected from (C1-C60)alkyl with or without halogen substituent(s), (C1-C60)alkoxy, halogen, tri(C1-C60)alkylsilyl, tri(C6-C60)arylsilyl and (C6-C60)aryl.

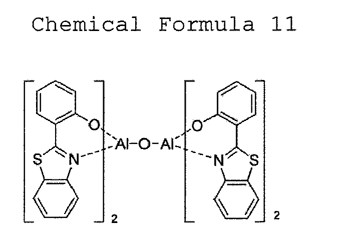

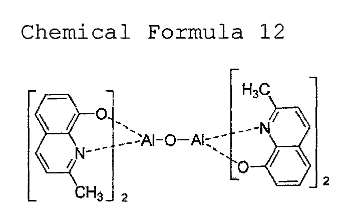

L²⁴L²⁵M²(T)ₕ Chemical Formula 13

In Chemical Formula (13), the ligands, L²⁴ and L²⁵ are independently selected from the following structures: 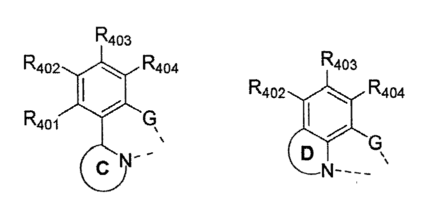 M² is a bivalent or trivalent metal;
h is 0 when M² is a bivalent metal, while h is 1 when M² is a trivalent metal;
T represents (C6-C60)aryloxy or tri(C6-C60)arylsilyl, and the aryloxy and triarylsilyl of T may be further substituted by (C1-C60)alkyl or (C6-C60)aryl;
G represents O, S or Se;
ring C represents oxazole, thiazole, imidazole, oxadiazole, thiadiazole, benzoxazole, benzothiazole, benzimidazole, pyridine or quinoline;
ring D represents pyridine or quinoline, and ring D may be further substituted by (C1-C60)alkyl, or phenyl or naphthyl with or without (C1-C60)alkyl substituent(s);
R₄₀₁ through R₄₀₄ independently represent hydrogen, (C1-C60)alkyl, halogen, tri(C1-C60)alkylsilyl, tri(C6-C60)arylsilyl or (C6-C60)aryl, or each of them may be linked to an adjacent substituent via (C3-C60)alkylene or (C3-C60)alkenylene to form a fused ring; the pyridine or quinoline may form a chemical bond with R₄₀₁ to provide a fused ring; and
ring C or the aryl group of R₄₀₁ through R₄₀₄ may be further substituted by (C1-C60)alkyl, halogen, (C1-C60)alkyl with halogen substituent(s), phenyl, naphthyl, tri(C1-C60)alkylsilyl, tri(C6-C60)arylsilyl or amino group. 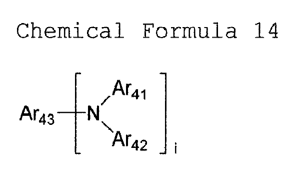 wherein, Ar₄₁ and Ar₄₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or Ar₄₁ and Ar₄₂ may be linked via (C3-C60)alkylene or (C3-C60)alkenylene with or without a fused ring to form an alicyclic ring, or a monocyclic or polycyclic aromatic ring;
when i is 1, Ar₄₃ represents (C6-C60) aryl, (C4-C60)heteroaryl or a substituent selected from the following structures: 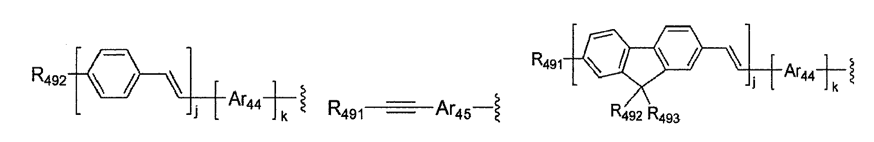 when i is 2, Ar₄₃ represents (C6-C60)arylene, (C4-C60)heteroarylene or a substituent selected from the following structures: 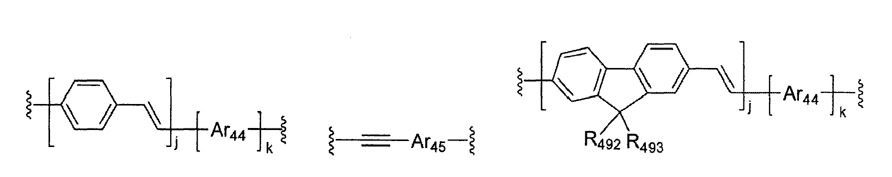 wherein, Ar₄₄ and Ar₄₅ independently represent (C6-C60)arylene or (C4-C60)heteroarylene;
R₄₉₁, R₄₉₂ and R₄₉₃ independently represent hydrogen, (C1-C60)alkyl or (C6-C60)aryl;
j is an integer from 1 to 4; k is an integer of 0 or 1; and
the alkyl, aryl, heteroaryl, arylamino, alkylamino, cycloalkyl or heterocycloalkyl of Ar₄₁ and Ar₄₂; the aryl, heteroaryl, arylene or heteroarylene of Ar₄₃; the arylene or heteroarylene of Ar₄₄ and Ar₄₅; or the alkyl or aryl of R₄₉₁ through R₄₉₃ may be further substituted by one or more substituent(s) selected from a group consisting of halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

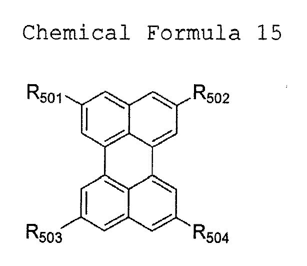

In Chemical Formula (15), R₅₀₁ through R₅₀₄ independently represent hydrogen, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₅₀₁ through R₅₀₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkylamino or arylamino of R₅₀₁ through R₅₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

The compounds having electroluminescent peak of wavelength of 480 to 560 nm, or those having electroluminescent peak of wavelength of not less than 560 nm, can be exemplified by the following compounds, but they are not restricted thereto.

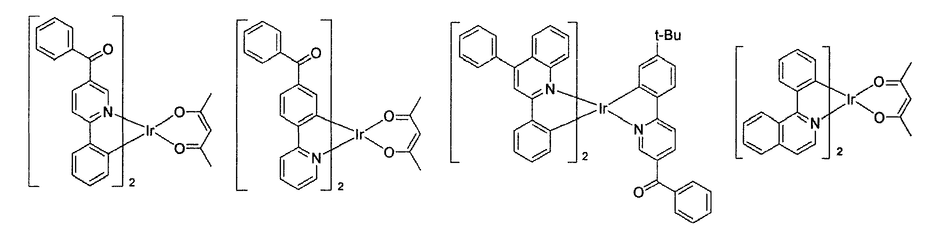

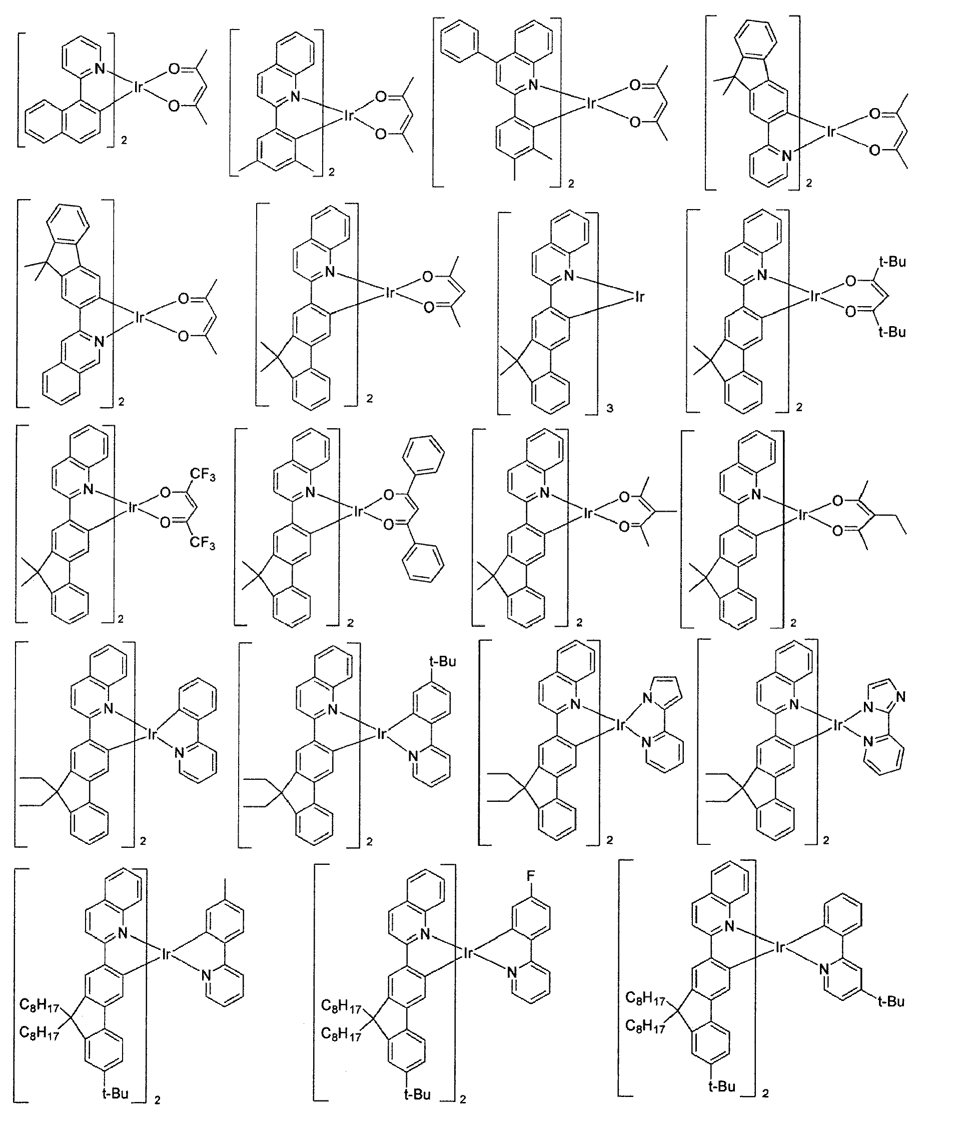

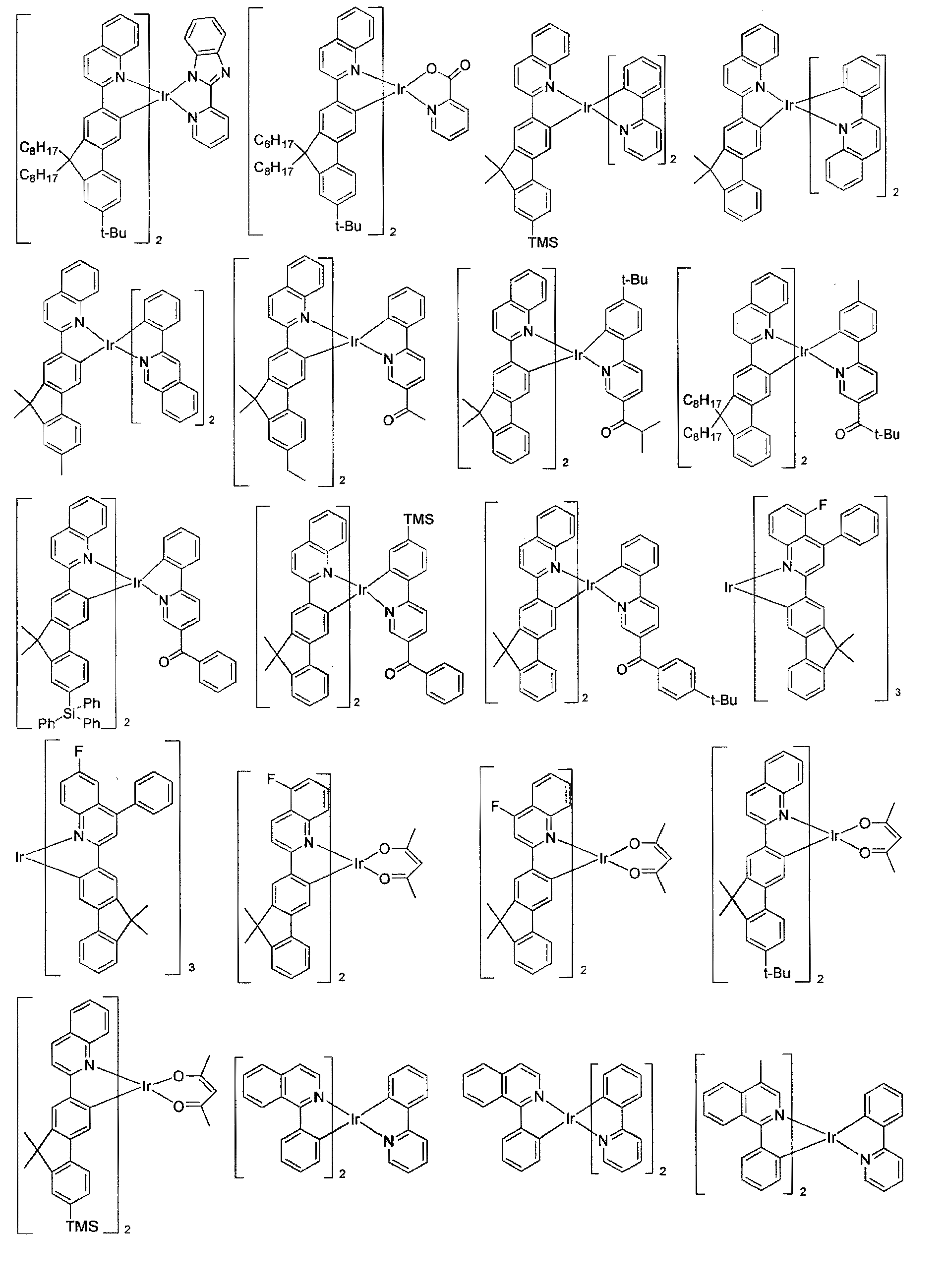

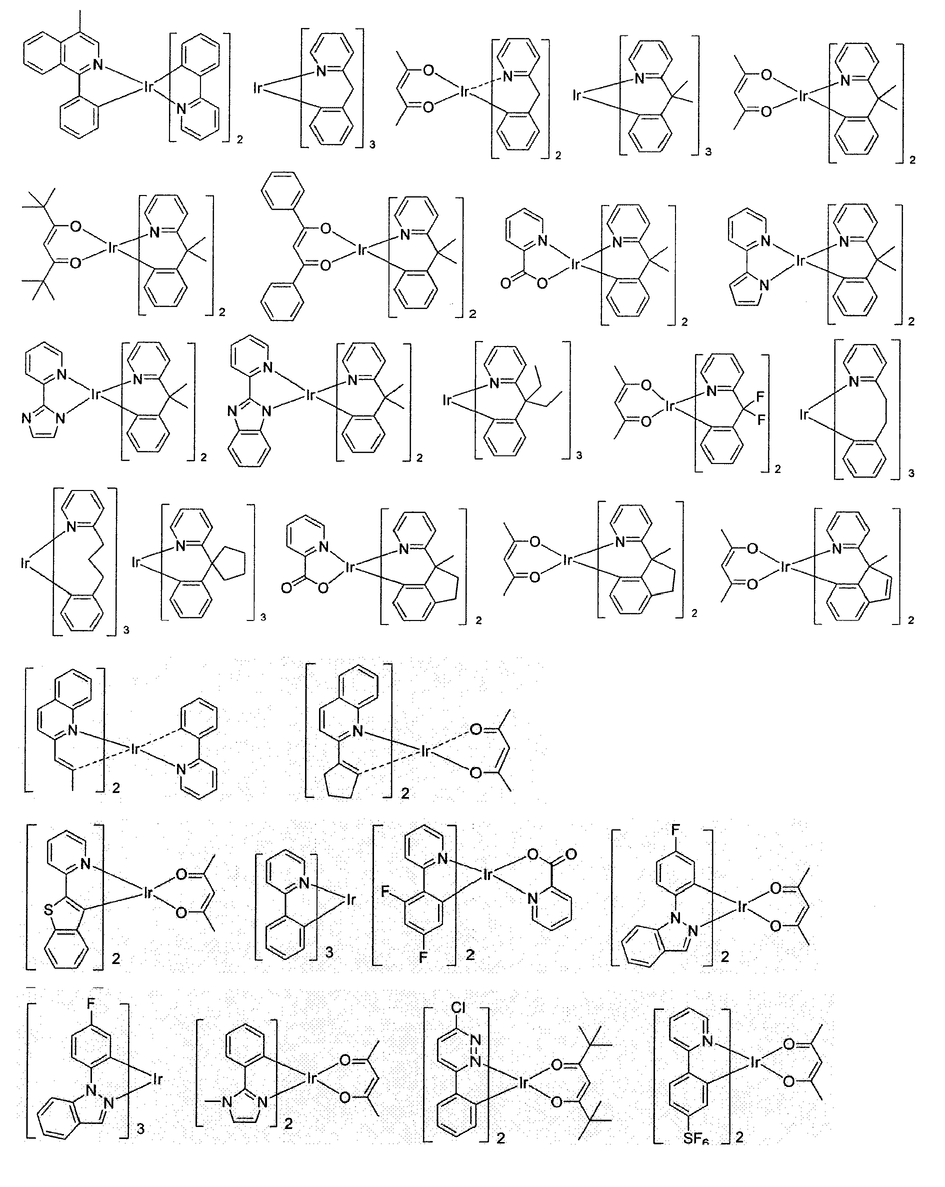

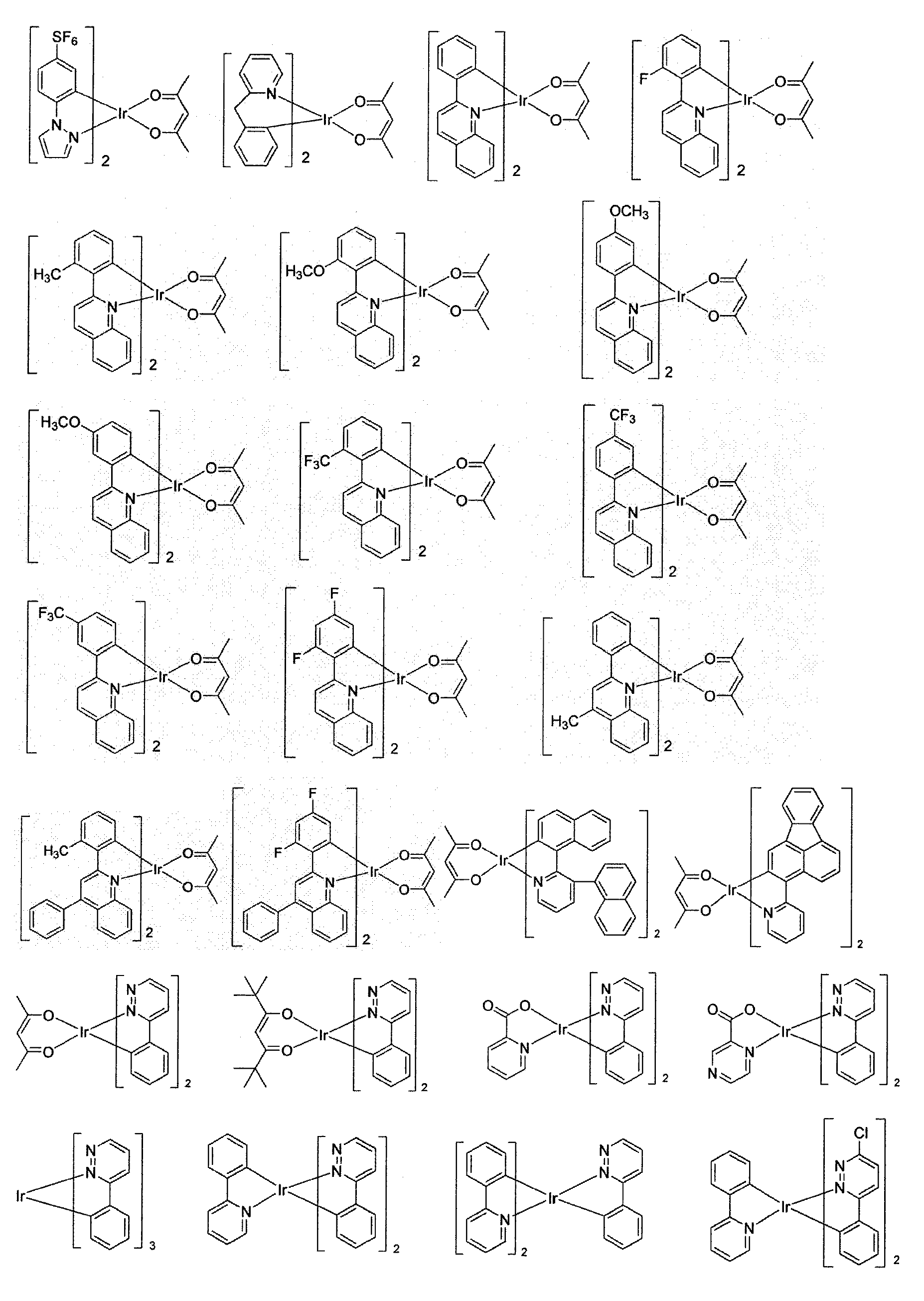

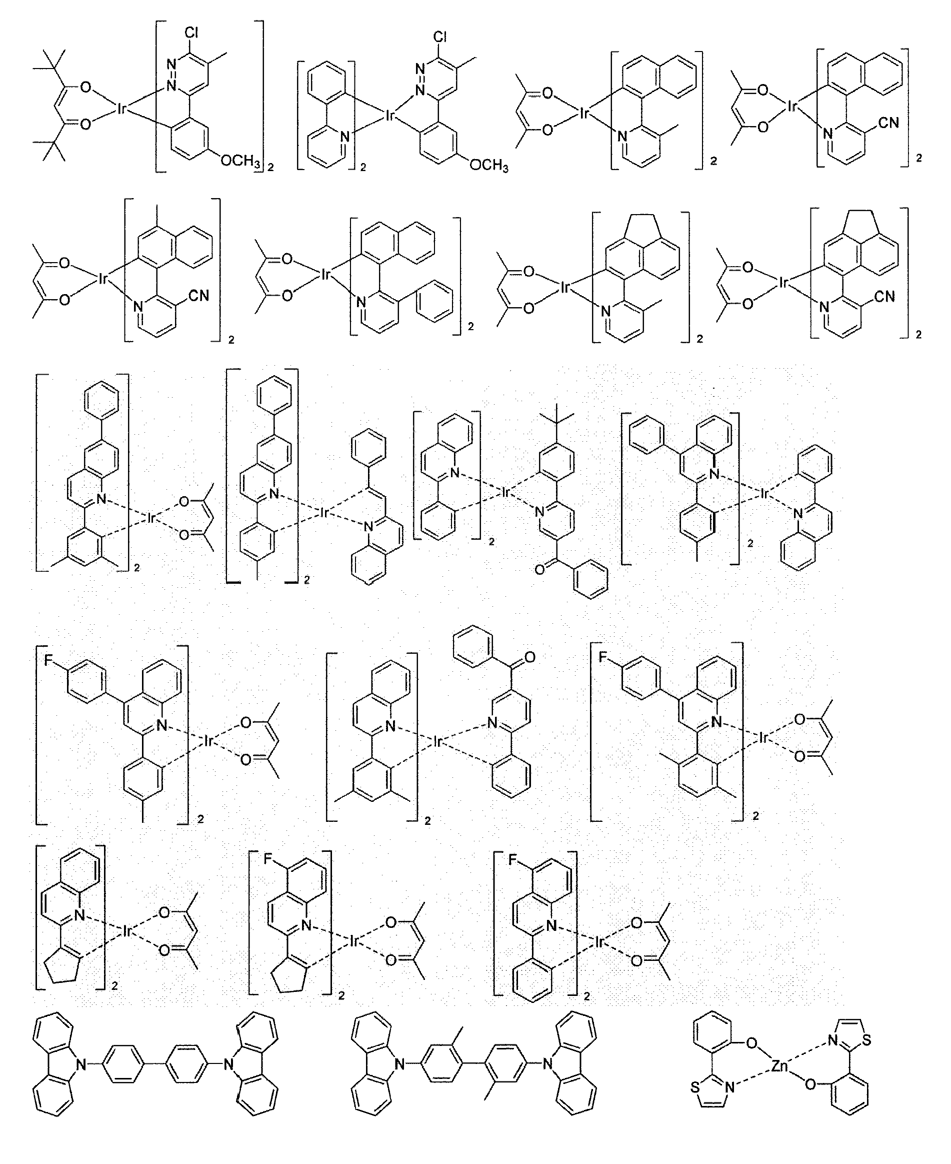

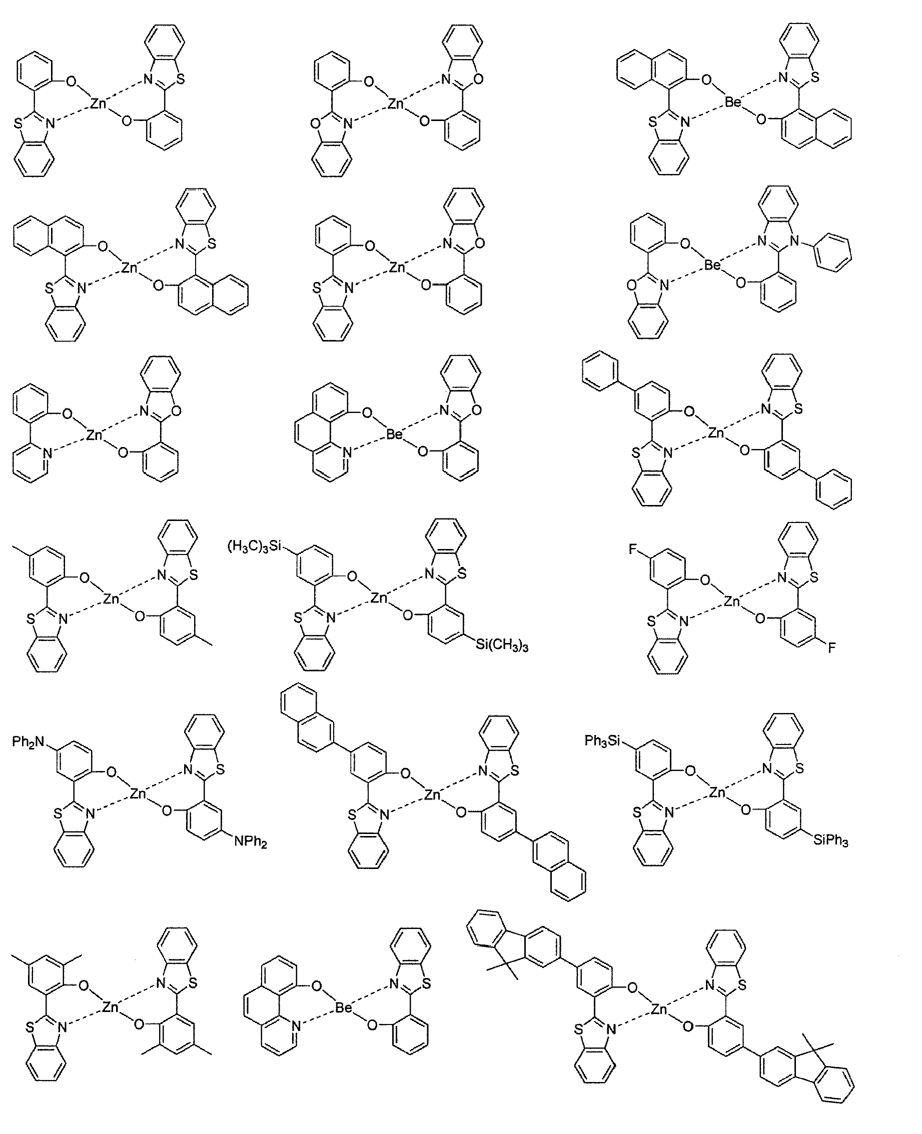

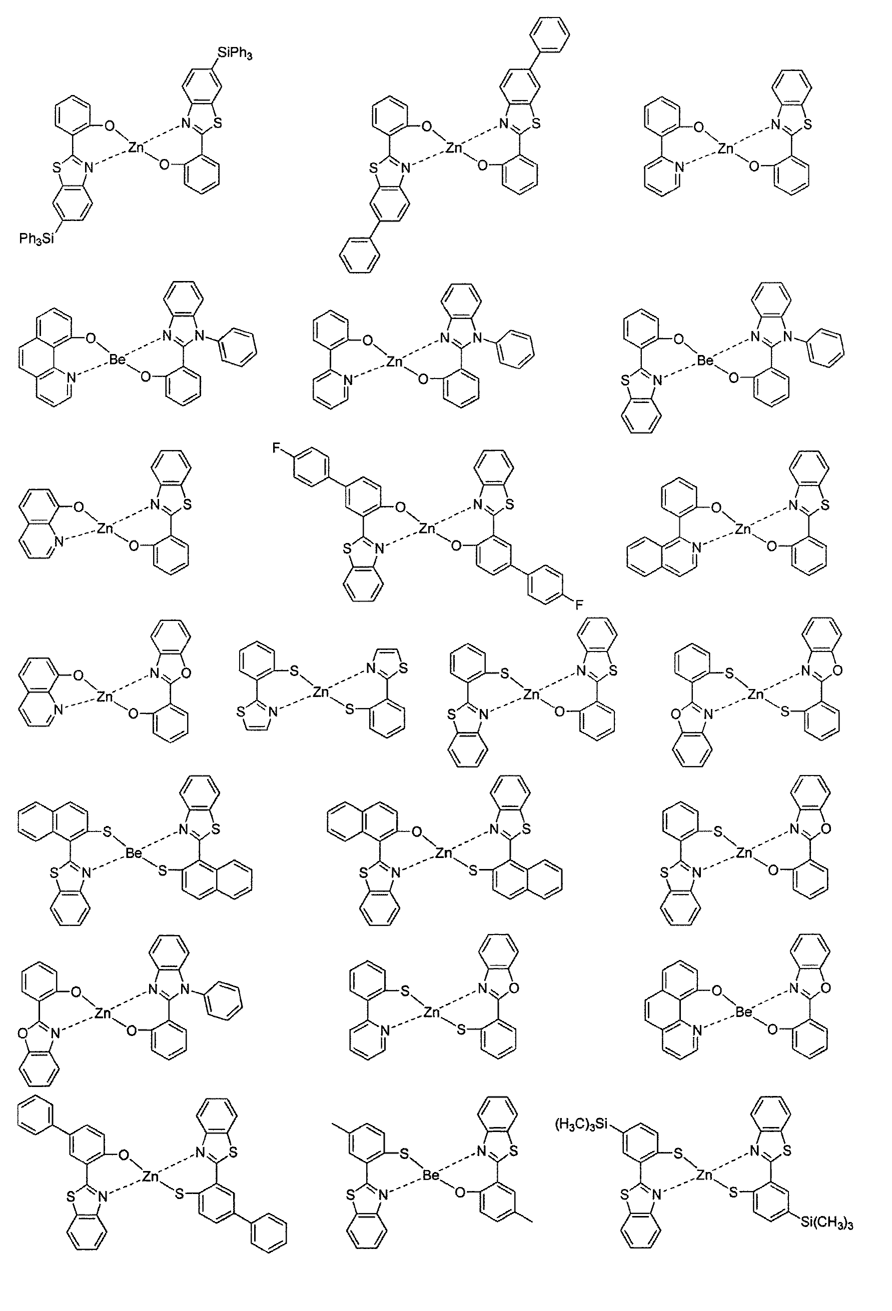

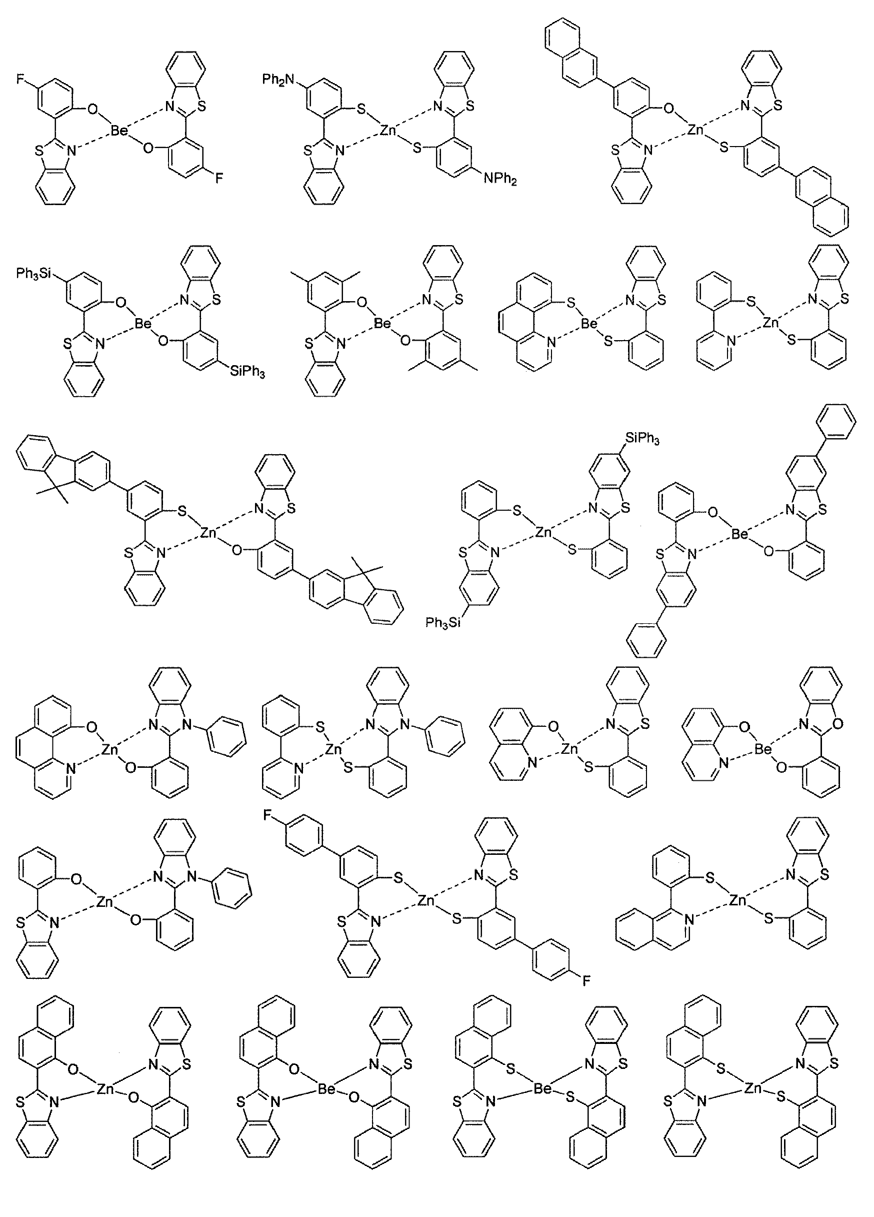

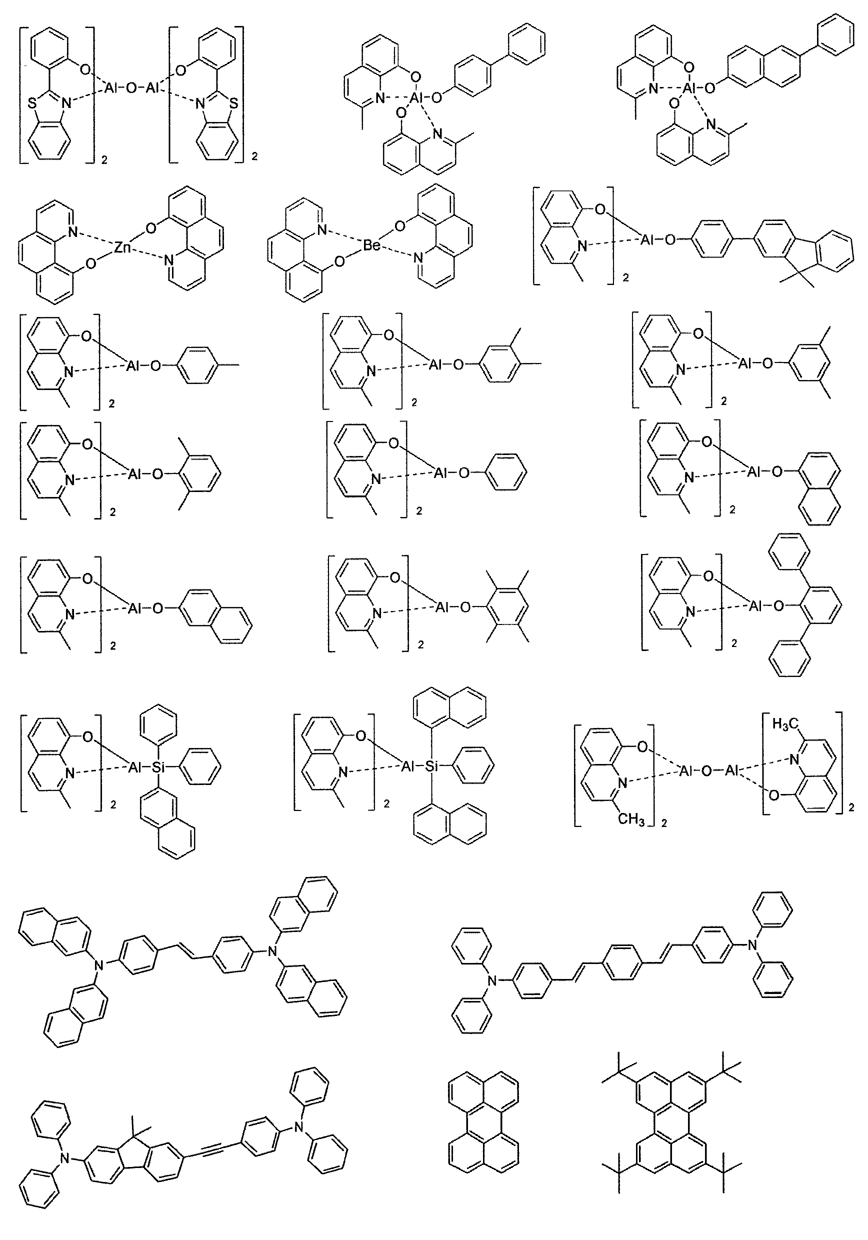

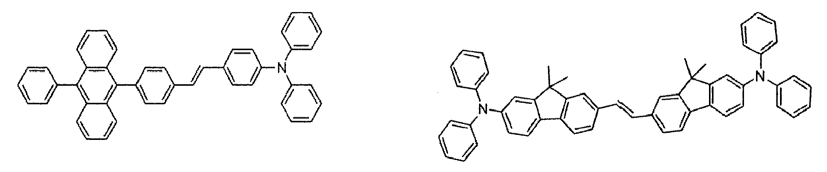

In an organic electroluminescent device according to the present invention, it is preferable to arrange one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metal or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent compounds according to the present invention, having high luminous efficiency in blue color and excellent life property of material, are advantageous in that they can be employed to manufacture organic light emitting diodes (OLED's) having very good operation life.

### Best Mode

The present invention is further described by referring to representative compounds with regard to the organic electroluminescent compounds according to the invention, preparation thereof and luminescent properties of the devices manufactured therefrom, but those examples are provided for illustration of the embodiments only, not being intended to limit the scope of the invention by any means.

### Preparation Examples

### [Preparation Example 1] Preparation of Compound (1)

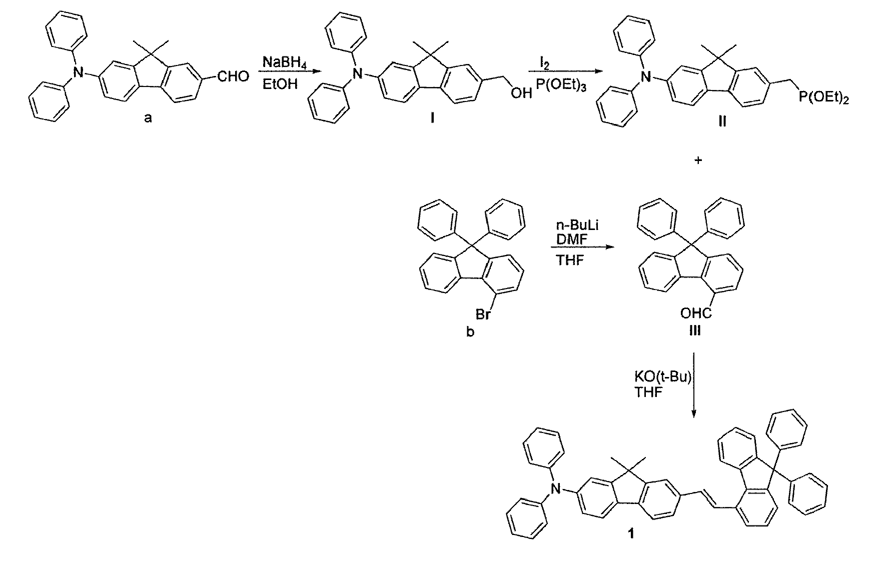

### Preparation of Compound (I)

In a round-bottomed flask, Compound (a) (6 g, 15.4 mmol) and sodium borohydride (2.3 g, 60.7 mmol) were dissolved in ethanol (156 mL), and the solution was heated under reflux for 3 hours. When the reaction was completed, the solution contained in the flask was poured into ice water, and the mixture was extracted with ether. After drying over anhydrous magnesium sulfate, the organic residue was purified via column chromatography to obtain Compound (I) (6 g, 15.3 mmol, yield: 99.5%).

### Preparation of Compound (II)

In a round-bottomed flask, Compound (I) (6 g, 15.3 mmol) was dissolved in triethylphosphite (50 mL). After cooling the solution to 0°C, iodine (I₂) (3.88 g, 15.2 mmol) was added thereto. The mixture was stirred for 30 minutes, and heated under reflux at 120°C for 12 hours. When the reaction was completed, triethylphosphite was removed by using a device for distillation, and the residue was purified via column chromatography to obtain Compound (II) (6.4 g, 12.2 mmol, yield: 80%).

### Preparation of Compound (III)

A round-bottomed flask was charged with Compound (b) (2.5 g, 6.3 mmol), dried in vacuo, and then filled with nitrogen gas. Compound (b) was dissolved by adding THF (25 mL), and the solution chilled to -78°C. After slowly adding n-butyllithium (4.7 mL, 7.5 mmol), the mixture was stirred for one hour, while maintaining the low temperature. After adding DMF (0.58 mL, 7.5 mmol) at -78°C thereto, the resultant mixture was stirred for 1 hour. When the reaction was completed, 1M HCl was added at 0°C, and the mixture was extracted with ethyl acetate. The extract was dried over anhydrous magnesium sulfate and evaporated. The residue was purified via column chromatography to obtain Compound (III) (1.7 g, 5.0 mmol, yield: 80%).

### Preparation of Compound (1)

A round-bottomed flask was charged with Compound (II) (2.5 g, 5.00 mmol) and Compound (III) (1.7 g, 5.00 mmol), dried in vacuo, and filled with nitrogen gas. The compounds were dissolved by adding THF (10 mL), and the solution cooled to 0°C. Potassium tert-butoxide (t-BuOK) (5.7 mL, 5.7 mmol) was slowly added thereto, and the mixture stirred for 10 minutes. The mixture was warmed to room temperature, and stirred for 1 hour. When the reaction was completed, the mixture was extracted with ethyl acetate, and the extract was dried over anhydrous magnesium sulfate, and evaporated. The residue was purified via column chromatography to obtain the target compound (Compound 1) (1.6 g, 2.3 mmol, yield: 50%).

### [Preparation Example 2] Preparation of Compound (29)

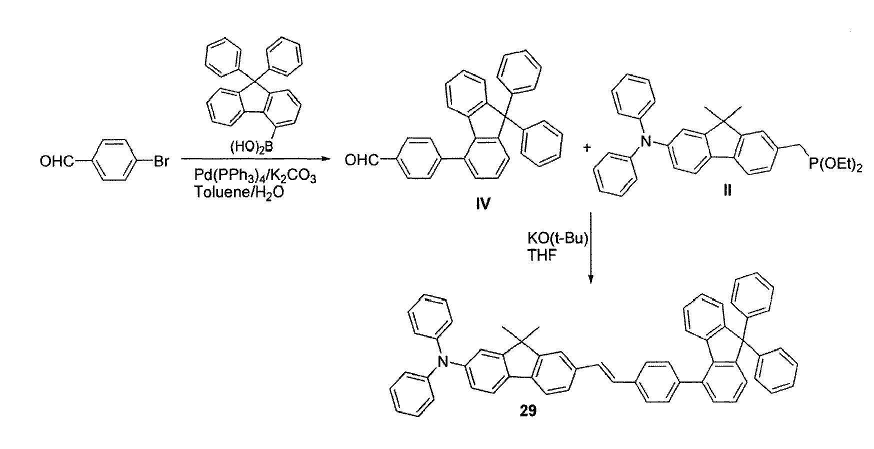

### Preparation of Compound (IV)

A round-bottomed flask was charged with 4-bromobenzaldehyde (2.5 g, 13.5 mmol), boronic acid (6.4 g, 17.6 mmol), tetrakistriphenylphosphine palladium (0.78 g, 6.8 mmol) and potassium carbonate (3.73 g, 27 mmol). Toluene (120 mL) and water (25 mL) were added thereto, and the mixture was stirred under reflux. The reaction mixture was extracted with ethyl acetate, and the extract was dried over magnesium sulfate and evaporated. The residue obtained was purified via column chromatography to obtain Compound (IV) (4.5 g, yield: 79%).

### Preparation of Compound (29)

A round-bottomed flask was charged with Compound (II) (2.5 g, 5.00 mmol) and Compound (IV) (2.1 g, 5.00 mmol) synthesized according to the same procedure as in Preparation Example (1), dried in vacuo, and filled with nitrogen gas. By adding THF (10 mL) to the flask, the compounds were dissolved, and the solution was cooled to 0°C. After slowly adding potassium tert-butoxide (5.7 mL, 5.7 mmol), the mixture was stirred for 10 minutes. The reaction mixture was warmed to room temperature, and stirred for 1 hour. When the reaction was completed, the reaction mixture was extracted with ethyl acetate, and the extract was dried over anhydrous magnesium sulfate, and evaporated. The residue was purified via column chromatography to obtain Compound (29) (1.6 g, yield: 50%).

### [Preparation Example 3] Preparation of Compound (565)

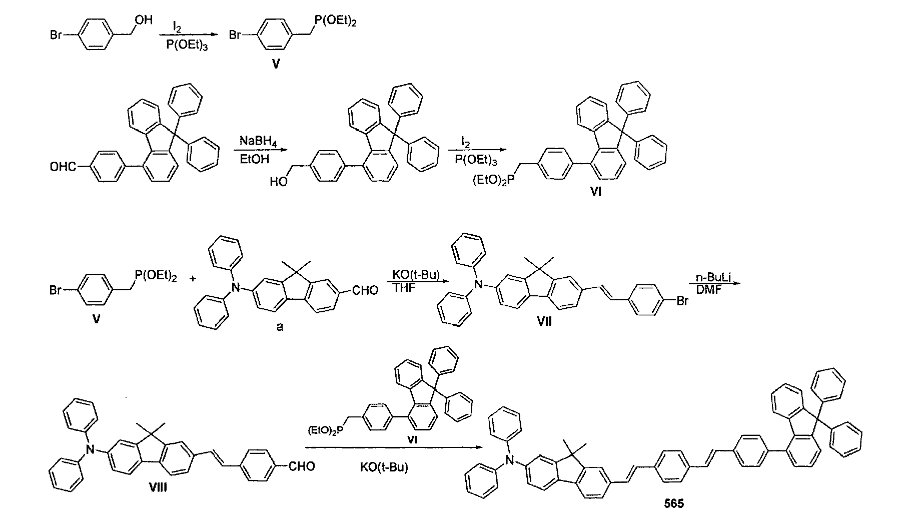

### Preparation of Compound (V)

In a round-bottomed flask, (4-bromophenyl)methanol (6 g, 32.1 mmol) as starting material was dissolved in triethylphosphite (60 mL). After cooling the solution to 0°C, iodine (I₂) (7.57 g, 32.1 mmol) was added thereto. The mixture was stirred for 30 minutes, heated under reflux at 120°C for 12 hours. When the reaction was completed, triethylphosphite was removed by using a device for distillation, and the residue was purified via column chromatography to obtain Compound (V) (8.4 g, yield: 90%).

### Preparation of Compound (VI)

In a round-bottomed flask, 4-(9,9-diphenyl-9H-fluoren-4-yl)benzaldehyde (6 g, 14.2 mmol) and sodium borohydride (2.2 g, 56.8 mmol) were dissolved in ethanol (130 mL), and the solution was heated under reflux for 3 hours. When the reaction was completed, the solution contained in the flask was poured into ice water, and extracted with ether. After drying over anhydrous magnesium sulfate, the organic residue was purified via column chromatography to obtain the intermediate alcohol compound (5.8 g, yield: 96%). In a round-bottomed flask, the intermediate alcohol compound (10 g, 23.6 mmol) was dissolved in triethylphosphite (100 mL). After cooling the solution to 0°C, iodine (5.97 g, 23.6 mmol) was added thereto. The mixture was stirred for 30 minutes, heated under reflux at 120°C for 12 hours. When the reaction was completed, triethylphosphite was removed by using a device for distillation, and the residue was purified via column chromatography to obtain Compound (VI) (12.1 g, yield: 88%).

### Preparation of Compound (VII)

A round-bottomed flask was charged with Compound (V) (2.5 g, 8.6 mmol) and aldehyde compound (a) (3.3 g, 8.6 mmol), dried in vacuo, and filled with nitrogen gas. By adding THF (10 mL) to the flask, the compounds were dissolved, and the solution was cooled to 0°C. After slowly adding potassium tert-butoxide (10 mL, 9.9 mmol), the mixture was stirred for 10 minutes. The reaction mixture was warmed to room temperature, and stirred for 1 hour. When the reaction was completed, the reaction mixture was extracted with ethyl acetate, and the extract was dried over anhydrous magnesium sulfate, and evaporated. The residue was purified via column chromatography to obtain Compound (VII) (3 g, yield: 65%).

### Preparation of Compound (VIII)

A round-bottomed flask was charged with Compound (VII) (2.5 g, 4.6 mmol), dried in vacuo, and filled with nitrogen gas. THF (25 mL) was added to the flask to dissolve the compound, and the solution was chilled to -78°C. To the flask, slowly added was butyllithium (2.2 mL, 55 mmol, 2.5 M solution), and the mixture was stirred for 1 hour, while maintaining the low temperature. After adding DMF (0.43 mL, 5.5 mmol), the mixture was stirred for 1 hour. When the reaction was completed, 1 M HCl was added at 0°C, and the resultant mixture was extracted with ethyl acetate. The extract was dried over magnesium sulfate and evaporated. The residue was purified via column chromatography to obtain Compound (VIII) (2 g, yield: 86%).

### Preparation of Compound (565)

A round-bottomed flask was charged with Compound (VI) (2.5 g, 4.7 mmol) and Compound (VIII) (2.3 g, 4.7 mmol), dried in vacuo, and filled with nitrogen gas. By adding THF (10 mL) to the flask, the compounds were dissolved, and the solution was cooled to 0°C. After slowly adding potassium tert-butoxide (6 mL, 6.1 mmol), the mixture was stirred for 10 minutes. The reaction mixture was warmed to room temperature, and stirred for 1 hour. When the reaction was completed, the reaction mixture was extracted with ethyl acetate, and the extract was dried over anhydrous magnesium sulfate, and evaporated. The residue was purified via column chromatography to obtain Compound (565) (3.3 g, yield: 79%).

The organic electroluminescent compounds (Compounds 1 to 580) were prepared according to the same procedure as in Preparation Examples 1 to 3, of which ¹H NMR and MS/FAB data are listed in Table 1.

**Table 1**

| compound | ¹H NMR(CDCl₃, 200 MHz) | MS/FAB | |
|---|---|---|---|
| | | found | calculated |
| **1** | δ = 1.72(6H, s), 6.58∼6.63(5H, m), 6.75∼6.81(4H, m), 7.11(4H, m), 7.2∼7.4(15H, m), 7.54∼7.55(3H, m), 7.62(1H, m), 7.71(1H, m), 7.87(2H, m) | 703.9 | 703.3 |
| **5** | δ = 1.72(6H, s), 6.58∼6.63(5H, m), 6.75∼6.81(3H, m), 6.95(2H, m), 7.2(4H, m), 7.41(2H, m), 7.51∼7.54(5H, m), 7.61∼7.62(2H, m), 7.71(1H, m), 7.79(4H, m), 7.87∼7.89(2H, m), 7.95∼7.96(2H, m), 8.42(1H, m) | 665.9 | 665.3 |
| **10** | δ = 1.72(6H, s), 5.19(2H, s), 6.58∼6.63(5H, m), 6.75∼6.81(3H, m), 6.95(2H, m), 7.03(4H, m), 7.15∼7.2(8H, m), 7.31∼7.35(2H, m), 7.47(1H, m), 7.54(1H, m), 7.62(1H, m), 7.71(1H, m), 7.87(1H, m) | 639.8 | 639.3 |
| **15** | δ = 0.9(6H, m), 1.91(4H, m), 6.58∼6.63(5H, m), 6.75∼6.81(4H, m), 7.11(4H, m), 7.2∼7.4(15H, m), 7.54∼7.55(3H, m), 7.62(1H, m), 7.71(1H, m), 7.87(2H, m) | 732.0 | 731.4 |
| **20** | δ = 0.9(6H, m), 1.91(4H, m), 6.58∼6.63(5H, m), 6.75∼6.81(4H, m), 7.11(4H, m), 7.2∼7.4(15H, m), 7.54∼7.55(3H, m), 7.62(1H, m), 7.71(1H, m), 7.87(2H, m) | 744.0 | 743.4 |
| **25** | δ = 0.9(6H, m), 1.91(4H, m), 6.58∼6.63(5H, m), 6.75∼6.81(3H, m), 6.95(2H, m), 7.2(4H, m), 7.41(2H, m), 7.51∼7.62(7H, m), 7.71(1H, m), 7.79∼7.8(5H, m), 7.87(1H, m), 7.95(1H, m), 8.4(2H, m) | 693.9 | 693.3 |
| **30** | δ = 1.72(6H, s), 6.58∼6.63(5H, m), 6.75∼6.81(3H, m), 6.95(2H, m), 7.16∼7.2(14H, m), 7.31∼7.41(8H, m), 7.53∼7.56(4H, m), 7.62∼7.64(3H, m), 7.71∼7.75(5H, m), 7.87(1H, m) | 942.2 | 941.4 |
| **35** | δ = 0.9(6H, m), 1.91(4H, m), 6.58∼6.63(5H, m), 6.75∼6.81(3H, m), 6.95(2H, m), 7.2(4H, m), 7.41(2H, m), 7.51∼7.56(9H, m), 7.62∼7.64(3H, m), 7.71(1H, m), 7.79∼7.88(7H, m), 8.12(2H, m), 8.32(1H, s), 8.93(2H, m) | 870.1 | 869.4 |
| **40** | δ = 0.9(6H, m), 1.91(4H, m), 6.58∼6.63(5H, m), 6.75∼6.81(3H, m), 6.95(2H, m), 7.2(4H, m), 7.41(4H, m), 7.51∼7.56(17H, m), 7.62∼7.64(3H, m), 7.71(1H, m), 7.78(1H, s), 7.79(2H, m), 7.87(1H, m) | 872.1 | 871.4 |
| **45** | δ = 6.63(4H, m), 6.81(2H, m), 6.88(1H, m), 6.95(2H, m), 7.06(1H, m), 7.2(4H, m), 7.41∼7.56(13H, m), 7.64(2H, m), 7.79∼7.8(3H, m), 7.82(1H, s), 8.02∼8.05(2H, m), 8.55(2H, m) | 731.9 | 731.3 |
| **50** | δ = 6.63(4H, m), 6.81(2H, m), 6.88(1H, m), 6.95(2H, m), 7.06(1H, m), 7.2(4H, m), 7.41∼7.64(15H, m), 7.76(1H, s), 7.79∼7.8(5H, m), 7.9(2H, m), 8.02∼8.05(2H, m) | 806.0 | 805.3 |
| **55** | δ = 6.63(4H, m), 6.81(2H, m), 6.88(1H, m), 6.95(2H, m), 7.06(1H, m), 7.2(4H, m), 7.41∼7.64(12H, m), 7.79∼7.8(5H, m), 8.01∼8.05(4H, m), 8.42(1H, m), 8.51(1H, m) | 731.9 | 731.3 |
| **60** | δ = 6.33(1H, m), 6.63(4H, m), 6.81(2H, m), 6.95(2H, m), 7.2∼7.25(8H, m), 7.41∼7.43(2H, m), 7.51∼7.64(13H, m), 7.89(1H, m), 8(2H, m), 8.4(2H, m) | 715.9 | 715.3 |
| **65** | δ = 6.33(1H, m), 6.63(4H, m), 6.81(2H, m), 6.95(2H, m), 7.11(6H, m), 7.2∼7.33(17H, m), 7.43(1H, m), 7.56∼7.64(7H, m), 7.89(1H, m) | 755.9 | 755.3 |
| **70** | δ = 6.33(1H, m), 6.63(4H, m), 6.81(2H, m), 6.95(2H, m), 7.2(4H, m), 7.41∼7.43(3H, m), 7.51∼7.64(12H, m), 7.79(4H, m), 7.89(1H, m), 8.01(2H, m), 8.42(1H, m), 8.51(1H, m) | 715.9 | 715.3 |
| **75** | δ = 1.72(6H, s), 6.58∼6.63(5H, m), 6.75∼6.81(3H, m), 6.95(2H, m), 7.2(4H, m), 7.41(2H, m), 7.51∼7.55(7H, m), 7.61∼7.62(2H, m), 7.71(1H, m), 7.79(4H, m), 7.87∼8.01(6H, m), 8.42(1H, m), 8.51∼8.55(2H, m) | 792.0 | 791.4 |
| **80** | δ = 0.9(6H, m), 1.91(4H, m), 5.19(2H, s), 6.58∼6.63(5H, m), 6.75∼6.81(3H, m), 6.95(2H, m), 7.03(4H, m), 7.15∼7.2(8H, m), 7.37∼7.41(2H, m), 7.53∼7.55(4H, m), 7.62(1H, m), 7.71(1H, m), 7.87∼7.96(4H, m), 8.55(1H, m) | 794.0 | 793.4 |
| **85** | δ = 6.63(4H, m), 6.69∼6.7(2H, m), 6.81(2H, m), 6.95(2H, m), 7.11(4H, m), 7.2∼7.38(13H, m), 7.51∼7.56(6H, m), 7.63∼7.66(2H, m), 7.79(1H, m), 7.87∼7.96(4H, m), 8.55(1H, m) | 866.9 g | 867.2 |
| **90** | δ = 6.63(4H, m), 6.69∼6.7(2H, m), 6.81(2H, m), 6.95(2H, m), 7.2(4H, m), 7.41(2H, m), 7.51∼7.56(12H, m), 7.66(1H, m), 7.79∼7.96(6H, m), 8.04(1H, m), 8.12(1H, m), 8.18(1H, m), 8.55(1H, m), 8.93(1H, m), 9.15(1H, m) | 879.0 | 879.2 |
| **95** | δ = 6.63(4H, m), 6.69∼6.7(2H, m), 6.81(2H, m), 6.95(2H, m), 7.2(4H, m), 7.41(2H, m), 7.51∼7.58(9H, m), 7.66(1H, m), 7.73∼7.79(6H, m), 7.92∼7.96(4H, m), 8.4(2H, m), 8.55(1H, m) | 828.9 | 829.2 |
| **100** | δ = 1.72(6H, s), 6.58∼6.63(5H, m), 6.75∼6.81(3H, m), 6.95(2H, m), 7.16∼7.2(14H, m), 7.31∼7.41(8H, m), 7.53∼7.62(5H, m), 7.71∼7.8(7H, m), 7.87∼7.95(3H, m) | 992.3 | 991.4 |
| **105** | δ = 1.72(6H, s), 6.58∼6.63(5H, m), 6.75∼6.81(3H, m), 6.95(2H, m), 7.2(4H, m), 7.41(2H, m), 7.51∼7.62(10H, m), 7.71(1H, m), 7.73∼7.82(11H, m), 8.12(2H, m), 8.32(1H, s), 8.93(2H, m) | 892.1 | 891.4 |
| **110** | δ = 0.9(6H, m), 1.91(4H, m), 6.58∼6.63(5H, m), 6.75∼6.81(3H, m), 6.95(2H, m), 7.2(4H, m), 7.41(4H, m), 7.51∼7.62(18H, m), 7.71∼7.73(2H, m), 7.78(1H, s), 7.79∼7.8(3H, m), 7.87∼7.95(3H, m) | 922.2 | 921.4 |
| **115** | δ = 3.82(3H, s), 6.63∼6.69(6H, m), 6.81(2H, m), 6.95(2H, m), 7.17∼7.2(5H, m), 7.33(1H, m), 7.41(2H, m), 7.51∼7.6(10H, m), 7.73∼7.8(4H, m), 7.82(1H, s), 7.92∼7.95(2H, m), 8.03∼8.05(2H, m), 8.55(2H, m) | 779.0 | 778.3 |
| **120** | δ = 3.82(3H, s), 6.63∼6.69(6H, m), 6.81(2H, m), 6.95(2H, m), 7.17∼7.2(5H, m), 7.33(1H, m), 7.41(2H, m), 7.51∼7.52(6H, m), 7.58∼7.6(4H, m), 7.73(1H, m), 7.76(1H, s), 7.79∼7.8(5H, m), 7.9∼7.95(4H, m), 8.03∼8.05(2H, m) | 853.1 | 852.4 |
| **125** | δ = 3.82(3H, s), 6.63∼6.69(6H, m), 6.81(2H, m), 6.95(2H, m), 7.17∼7.2(5H, m), 7.33(1H, m), 7.41(1H, m), 7.51∼7.52(4H, m), 7.58∼7.6(2H, m), 7.73(1H, m), 7.8∼7.95(7H, m), 8,03∼8.05(2H, m), 8.12(2H, m), 8.93(2H, m) | 752.9 | 752.3 |
| **130** | δ = 6.63∼6.69(6H, m), 6.81(2H, m), 6.95∼7(3H, m), 7.2∼7.25(8H, m), 7.41(1H, m), 7.45∼7.52(14H, m), 7.73(1H, m), 7.8(1H, m), 7.92∼8.03(5H, m), 8.4∼8.43(3H, m) | 841.0 | 840.4 |
| **135** | δ = 6.63∼6.69(6H, m), 6.81(2H, m), 6.95∼7(3H, m), 7.11(6H, m), 7.2∼7.33(17H, m), 7.45∼7.6(8H, m), 7.73(1H, m), 7.8(1H, m), 7.92∼7.95(2H, m), 8.03(1H, m), 8.43(1H, m) | 881.1 | 880.4 |
| **140** | δ = 6.63∼6.69(6H, m), 6.81(2H, m), 6.95∼7(3H, m), 7.2(4H, m), 7.41∼7.51(15H, m), 7.73∼7.8(6H, m), 7.92∼8.03(5H, m), 8.42∼8.43(2H, m), 8.51(1H, m) | 841.0 | 840.4 |
| **145** | δ = 1.51(4H, m), 2.09(4H, m), 6.58∼6.63(5H, m), 6.75∼6.81(3H, m), 6.95(2H, m), 7.2(4H, m), 7.41(2H, m), 7.51∼7.64(11H, m), 7.71(1H, m), 7.79(4H, m), 7.87(1H, m), 8.01(2H, m), 8.42(1H, m), 8.51(1H, m) | 768.0 | 767.4 |
| **150** | δ = 1.51(4H, m), 2.09(4H, m), 5.19(2H, s), 6.58∼6.63(5H, m), 6.75∼6.81(3H, m), 6.95(2H, m), 7.03(4H, m), 7.15∼7.2(8H, m), 7.37∼7.41(2H, m), 7.53∼7.56(4H, m), 7.62∼7.64(3H, m), 7.71(1H, m), 7.87(1H, m) | 742.0 | 741.3 |
| **155** | δ = 3.49(4H, s), 6.58∼6.63(5H, m), 6.75∼6.81(3H, m), 6.95(2H, m), 7.11(4H, m), 7.2∼7.38(17H, m), 7.51∼7.56(5H, m), 7.62∼7.64(4H, m), 7.71(1H, m), 7.87(2H, m) | 854.1 | 853.4 |
| **160** | δ = 3.49(4H, s), 6.58∼6.63(5H, m), 6.75∼6.81(3H, m), 6.95(2H, m), 7.2(8H, m), 7.41(2H, m), 7.51∼7.56(11H, m), 7.62∼7.64(3H, m), 7.71(1H, m), 7.82∼7.88(3H, m), 8.04(1H, m), 8.12(1H, m), 8.18(1H, m), 8.93(1H, m), 9.15(1H, m) | 866.1 | 865.4 |
| **165** | δ = 3.49(4H, s), 6.58∼6.63(5H, m), 6.75∼6.81(3H, m), 6.95(2H, m), 7.2(8H, m), 7.41(2H, m), 7.51∼7.64(11H, m), 7.71∼7.79(6H, m), 7.87∼7.92(2H, m), 8.4(2H, m) | 816.0 | 815.4 |
| **170** | δ = 1.48(6H, m), 2.02(4H, m), 6.58∼6.63(5H, m), 6.75∼6.81(3H, m), 6.95(2H, m), 7.16∼7.2(14H, m), 7.31∼7.41(8H, m), 7.53∼7.62(5H, m), 7.71∼7.8(7H, m), 7.87∼7.95(3H, m) | 1032.3 | 1031.4 |
| **175** | δ = 1.48(6H, m), 2.02(4H, m), 6.58∼6.63(5H, m), 6.75∼6.81(3H, m), 6.95(2H, m), 7.2(4H, m), 7.41(2H, m), 7.51∼7.62(10H, m), 7.71(1H, m), 7.73∼7.82(11H, m), 8.12(2H, m), 8.32(1H, s), 8.93(2H, m) | 932.2 | 931.4 |
| **180** | δ = 1.48(6H, m), 2.02(4H, m), 6.58∼6.63(5H, m), 6.75∼6.81(3H, m), 6.95(2H, m), 7.2(4H, m), 7.41(4H, m), 7.51∼7.62(18H, m), 7.71∼7.73(2H, m), 7.78(1H, s), 7.79∼7.8(3H, m), 7.87∼7.95(3H, m) | 934.2 | 933.4 |
| **185** | δ = 0.66(6H, s), 6.63(4H, m), 6.79∼6.81(4H, m), 6.95(2H, m), 7.2(4H, m), 7.41(2H, m), 7.51∼7.56(10H, m), 7.64∼7.66(4H, m), 7.76∼7.79(3H, m), 7.82(1H, s), 7.89(1H, m), 8.55(2H, m) | 758.0 | 757.3 |
| **190** | δ = 0.66(6H, s), 6.63(4H, m), 6.79∼6.81(4H, m), 6.95(2H, m), 7.2(4H, m), 7.41(2H, m), 7.51∼7.66(14H, m), 7.76(2H, m), 7.79(4H, m), 7.89∼7.9(3H, m) | 832.1 | 831.3 |
| **195** | δ = 0.66(6H, s), 6.63(4H, m), 6.79∼6.81(4H, m), 6.95(2H, m), 7.2(4H, m), 7.41(1H, m), 7.51∼7.56(6H, m), 7.64∼7.66(4H, m), 7.76(1H, m), 7.82∼7.89(5H, m), 8.12(2H, m), 8.93(2H, m) | 732.0 | 731.3 |
| **200** | δ = 0.25(18H, s), 0.9(6H, m), 1.91(4H, m), 6.58∼6.61(5H, m), 6.75∼6.78(2H, m), 7.11∼7.15(8H, m), 7.22∼7.4(11H, m), 7.54∼7.55(3H, m), 7.62(1H, m), 7.71(1H, m), 7.87(2H, m) | 876.3 | 875.4 |
| **205** | δ = 0.9(6H, m), 1.91(4H, m), 2.34(12H, s), 6.36(4H, m), 6.58(1H, m), 6.71∼6.78(4H, m), 7.11(4H, m), 7.22∼7.4(11H, m), 7.54∼7.55(3H, m), 7.62(1H, m), 7.71(1H, m), 7.87(2H, m) | 788.1 | 787.4 |
| **210** | δ = 0.9(6H, m), 1.91(4H, m), 2.12(6H, s), 2.34(6H, s), 6.39(2H, m), 6.58(1H, m), 6.75∼6.85(6H, m), 7.11(4H, m), 7.22∼7.4(11H, m), 7.54∼7.55(3H, m), 7.62(1H, m), 7.71(1H, m), 7.87(2H, m) | 788.1 | 787.4 |
| **215** | δ = 0.9(6H, m), 1.91(4H, m), 2.88(4H, m), 6.58(3H, m), 6.75∼6.78(4H, m), 7.02∼7.04(4H, m), 7.11(4H, m), 7.22∼7.4(11H, m), 7.54∼7.55(3H, m), 7.62(1H, m), 7.71(1H, m), 7.87(2H, m) | 758.0 | 757.4 |
| **220** | δ = 0.9(6H, m), 1.72(6H, s), 1.91(4H, m), 6.55∼6.58(3H, m), 6.73∼6.78(4H, m), 7.02∼7.05(4H, m), 7.11(4H, m), 7.22∼7.4(11H, m), 7.54∼7.55(3H, m), 7.62(1H, m), 7.71(1H, m), 7.87(2H, m) | 772.0 | 771.4 |
| **225** | δ = 0.9(6H, m), 1.91(4H, m), 6.58∼6.63(3H, m), 6.75∼6.81(3H, m), 7.11(4H, m), 7.2∼7.28(14H, m), 7.49∼7.55(5H, m), 7.62(1H, m), 7.71∼7.77(3H, m), 7.84∼7.88(4H, m) | 782.0 | 781.4 |
| **230** | δ = 0.9(6H, m), 1.91(4H, m), 2.12(3H, s), 6.51(1H, m), 6.58∼6.63(3H, m), 6.69∼6.81(4H, m), 7.01(1H, m), 7.11(4H, m), 7.15∼7.26(14H, m), 7.54∼7.55(3H, m), 7.62(1H, m), 7.71(1H, m), 7.87(2H, m) | 746.0 | 745.4 |
| **235** | δ = 0.9(6H, m), 1.91(4H, m), 2.12(3H, s), 2.34(3H, s), 6.39(1H, m), 6.58∼6.63(3H, m), 6.75∼6.85(5H, m), 7.11(4H, m), 7.2∼7.4(13H, m), 7.54∼7.55(3H, m), 7.62(1H, m), 7.71(1H, m), 7.87(2H, m) | 760.0 | 759.4 |
| **240** | δ = 0.9(6H, m), 1.91(4H, m), 6.58∼6.63(3H, m), 6.75∼6.81(3H, m), 6.91(1H, m), 7.11(4H, m), 7.2∼7.4(13H, m), 7.54~7.55(3H, m), 7.62(1H, m), 7.71(1H, m), 7.82~7.88(6H, m), 8.12(2H, m), 8.93(2H, m) | 832.1 | 831.4 |
| **245** | δ = 0.9(6H, m), 1.91(4H, m), 6.58~6.63(3H, m), 6.69~6.81(5H, m), 7.11(4H, m), 7.2(2H, m), 7.22~7.28(16H, m), 7.51∼7.55(9H, m), 7.62(1H, m), 7.71(1H, m), 7.87(2H, m) | 884.2 | 883.4 |
| **250** | δ = 0.9(6H, m), 1.91(4H, m), 6.58~6.63(4H, m), 6.75~6.81(3H, m), 6.88~6.89(2H, m), 7.11(4H, m), 7.2~7.28(14H, m), 7.54∼7.62(7H, m), 7.71∼7.73(2H. m), 7.87~7.92(3H, m), 8(2H, m) | 858.1 | 857.4 |
| **255** | δ = 0.9(6H, m), 1.91(4H, m), 6.58∼6.63(3H, m), 6.75∼6.81(3H, m), 7.02(1H, m), 7.11(4H, m), 7.2~7.4(13H, m), 7.54~7.55(3H, m), 7.62(1H, m), 7.71(5H, m), 7.82~7.88(5H, m), 8.12(1H, m) | 856.1 | 855.4 |
| **260** | δ = 0.9(6H, m), 1.91(4H, m), 3.49(4H, s), 6.58∼6.63(4H, m), 6.75∼6.81(4H, m), 7.11(4H, m), 7.2∼7.4(19H, m), 7.54~7.55(4H, m), 7.62(2H, m), 7.71(1H, m), 7.87(3H, m) | 922.2 | 921.4 |
| **265** | δ = 6.39(1H, m), 6.55(1H, m), 6.63(4H, m), 6.78∼6.81(3H, m), 7.11(4H, m), 7.2∼7.28(20H, m), 7.5~7.55(6H, m), 7.75(1H, m), 7.87(3H, m) | 826.0 | 825.3 |
| **270** | δ = 2.88(4H, m), 5.72(1H, m), 5.94(1H, m), 6.51(1H, m), 6.63(6H, m), 6.78∼6.81(5H, m), 7.04(1H, m), 7.11~7.14(5H, m), 7.2~7.4(17H, m), 7.54∼7.55(2H, m), 7.87(1H, m) | 781.0 | 780.4 |
| **275** | δ = 0.9(6H, m), 1.91(4H, m), 6.58(1H, m), 6.75∼6.78(2H, m), 7.11(4H, m), 7.22∼7.4(13H, m), 7.49∼7.55(7H, m), 7.62(1H, m), 7.71∼7.77(5H, m), 7.84∼7.88(6H, m) | 832.1 | 831.4 |
| **280** | δ = 5.85(1H, m), 6.6(1H, m), 6.69(2H, m), 6.78(1H, m), 6.87(2H, m), 7.08(4H, m), 7.11(4H, m), 7.16(2H, m), 7.22(1H, m), 7.26(2H, m), 7.28(2H, m), 7.33(4H, m), 7.38(1H, m), 7.4(1H, m), 7.41(2H, m), 7.45∼7.54(15H, m), 7.87(1H, m), 8.12(1H, m), 8.18(1H, m) | 905.1 | 904.4 |
| **285** | δ = 0.9(6H, m), 1.91(4H, m), 6.95(2H, m), 7.11∼7.17(7H, m), 7.25∼7.34(18H, m), 7.5∼7.56(4H, m), 7.63∼7.64(3H, m), 7.87(2H, m), 7.94(1H, m), 8.12(1H, m), 8.55(1H, m) | 808.1 | 807.4 |
| **289** | δ = 0.9(6H, m), 1.91(4H, m), 6.95(2H, m), 7.17(1H, m), 7.25∼7.34(5H, m), 7.41(2H, m), 7.5∼7.56(10H, m), 7.63∼7.64(3H, m), 7.79∼7.88(8H, m), 7.94(1H, m), 8.12(3H, m), 8.32(1H, s), 8.55(1H, m), 8.93(2H, m) | 868.1 | 867.4 |
| **294** | δ = 0.9(6H, m), 1.91(4H, m), 6.95(2H, m), 7.17(1H, m), 7.25∼7.34(5H, m), 7.41(4H, m), 7.5∼7.55(18H, m), 7.63(1H, m), 7.78(1H, s), 7.79(2H, m), 7.87∼7.96(6H, m), 8.12(1H, m), 8.55(2H, m) | 920.2 | 919.4 |
| **299** | δ = 3.49(4H, s), 6.58∼6.63(5H, m), 6.75∼6.81(3H, m), 6.95(2H, m), 7.2∼7.25(12H, m), 7.41(1H, m), 7.51∼7.62(10H, m), 7.71∼7.73(2H, m), 7.8(1H, m), 7.87∼8(5H, m), 8.4(2H, m) | 866.1 | 865.4 |
| **304** | δ = 0.9(6H, m), 1.91(4H, m), 5.19(2H, s), 6.95∼7.03(6H, m), 7.15(4H, m), 7.17(1H, m), 7.21∼7.33(8H, m), 7.5∼7.53(2H, m), 7.63(1H, m), 7.82∼7.87(2H, m), 7.94(1H, m), 8.12(1H, m), 8.55(1H, m), 9.37(2H, m) | 743.9 | 743.3 |
| **309** | δ = 0.9(6H, m), 1.91(4H, m), 6.95∼6.99(2H, m), 7.11(6H, m), 7.17(1H, m), 7.21∼7.29(18H, m), 7.5(1H, m), 7.63∼7.67(3H, m), 7.82∼7.94(4H, m), 8.12(1H, m), 8.55(1H, m) | 814.1 | 813.3 |
| **314** | δ = 0.9(6H, m), 1.91(4H, m), 6.95∼6.99(2H, m), 7.16(4H, m), 7.17(1H, m), 7.19(6H, m), 7.21(1H, m), 7.25(1H, m), 7.29∼7.34(12H, m), 7.5∼7.53(2H, m), 7.63(1H, m), 7.75(4H, m), 7.82∼7.87(2H, m), 7.94(1H, m), 8.12(1H, m), 8.55(1H, m) | 976.2 | 975.4 |
| **319** | δ = 0.9(6H, m), 1.91(4H, m), 6.95∼6.99(2H, m), 7.17∼7.29(9H, m), 7.5∼7.52(7H, m), 7.63(1H, m), 7.79∼7.88(8H, m), 7.94(1H, m), 8.12(3H, m), 8.32(1H, s), 8.55(1H, m), 8.93(2H, m) | 876.1 | 875.3 |
| **324** | δ = 0.9(6H, m), 1.91(4H, m), 6.95∼6.99(2H, m), 7.17∼7.29(11H, m), 7.5∼7.52(15H, m), 7.63(1H, m), 7.78(1H, s), 7.79∼7.87(4H, m), 7.94(1H, m), 8.12(1H, m), 8.55(1H, m) | 862.1 | 861.4 |
| **329** | δ 0.9(6H, m), 1.91(4H, m), 7.17(1H, m), 7.2∼7.29(12H, m), 7.49∼7.63(10H, m), 7.82∼7.87(3H, m), 7.94∼8(3H, m), 8.12(1H, m), 8.4(2H, m), 8.55(1H, m), 8.85(1H, m) | 769.0 | 768.4 |
| **334** | δ = 0.9(6H, m), 1.91(4H, m), 5.19(2H, s), 6.95(2H, m), 7.03(4H, m), 7.15(4H, m), 7.17∼7.29(8H, m), 7.49∼7.5(2H, m), 7.63(1H, m), 7.82∼7.97(5H, m), 8.04(1H, m), 8.12(1H, m), 8.33(1H, m), 8.55(1H, m) | 742.9 | 742.3 |
| **339** | δ = 1.72(6H, s), 6.58(1H, m), 6.75∼6.78(2H, m), 7.06(2H, m), 7.16∼7.22(3H, m), 7.41(2H, m), 7.51∼7.54(5H, m), 7.62(1H, m), 7.71(1H, m), 7.79∼7.88(7H, m), 8.12(2H, m), 8.26(1H, s), 8.93(2H, m), 9.18(2H, m), 9.26(2H, m) | 769.9 | 769.3 |
| **344** | δ = 0.9(6H, m), 1.91(4H, m), 6.58(1H, m), 6.75∼6.78(2H, m), 7.22∼7.25(5H, m), 7.41(1H, m), 7.51∼7.62(10H, m), 7.71(1H, m), 7.83∼7.87(5H, m), 8∼8.01(3H, m), 8.16(2H, m), 8.34(1H, m), 9.43(2H, m) | 798.0 | 797.4 |
| **349** | δ = 0.9(6H, m), 1.91(4H, m), 6.58(1H, m), 6.75(1H, m), 6.91(1H, s), 6.95(2H, m), 7.02(1H, m), 7.41(2H, m), 7.51∼7.63(8H, m), 7.71(3H, m), 7.79∼7.88(14H, m), 7.95(1H, m), 8.12(3H, m), 8.29(1H, m), 8.4(2H, m), 8.93(5H, m) | 994.3 | 993.4 |
| **354** | δ = 1.72(6H, s), 6.58∼6.63(3H, m), 6.75∼6.81(2H, m), 6.95(2H, m), 7.11(6H, m), 7.2∼7.26(7H, m), 7.33(6H, m), 7.54(1H, m), 7.62(1H, m), 7.71(3H, m), 7.87(1H, m), 8.35∼8.4(3H, m) | 707.9 | 707.3 |
| **359** | δ = 0.9(6H, m), 1.91(4H, m), 4.12(4H, s), 6.58∼6.64(4H, m), 6.75∼6.81(4H, m), 7.11(4H, m), 7.2∼7.4(15H, m), 7.54∼7.55(4H, m), 7.62(1H, m), 7.65(1H, s), 7.7(1H, s), 7.71(1H, m), 7.84∼7.87(4H, m) | 908.2 | 907.4 |
| **364** | δ = 0.9(6H, m), 1.91(4H, m), 5.19(2H, s), 6.39(1H, m), 6.51(1H, m), 6.58∼6.63(3H, m), 6.75∼6.81(2H, m), 6.95(2H, m), 7.03∼7.06(SH, m), 7.15∼7.2(6H, m), 7.41(2H, m), 7.51∼7.55(6H, m), 7.62(1H, m), 7.71(1H, m), 7.79(4H, m), 7.87∼7.9(2H, m), 8.01(2H, m), 8.4(1H, m) | 870.1 | 869.4 |
| **369** | δ = 1.51(4H, m), 2.09(4H, m), 6.58∼6.63(5H, m), 6.75∼6.81(3H, m), 6.95(2H, m), 7.2∼7.25(9H, m), 7.41∼7.44(5H, m), 7.51∼7.63(12H, m), 7.82(1H, m), 8(2H, m), 8.4(3H, m) | 871.1 | 870.4 |
| **374** | δ = 1.51(4H, m), 2.09(4H, m), 6.58∼6.63(5H, m), 6.75∼6.81(3H, m), 6.95∼6.99(4H, m), 7.08(2H, m), 7.2(4H, m), 7.35(1H, m), 7.41∼7.42(3H, m), 7.51∼7.52(6H, m), 7.58∼7.62(4H. m), 7.76(1H, s), 7.79∼7.82(5H, m), 7.89∼7.9(3H, m) | 956.3 | 955.3 |
| **379** | δ = 0.9(6H, m), 1.91(4H, m), 5.19(2H, s), 5.67(1H, m), 6.79(1H, m), 7.03(4H, m), 7.15∼7.25(11H, m), 7.5∼7.55(2H, m), 7.63(1H, m), 7.82∼7.87(3H, m), 7.94∼7.95(2H, m), 8.12(1H, m), 8.55(1H, m) | 796.9 | 797.2 |
| **384** | δ = 0.9(6H, m), 1.91(4H, m), 2.59(3H, s), 6.58∼6.63(5H, m), 6.75∼6.81(3H, m), 6.95(2H, m), 7.06(1H, m), 7.2(4H, m), 7.41(1H, m), 7.51∼7.56(7H, m), 7.62∼7.64(3H, m), 7.71∼7.73(2H, m), 7.85∼7.87(2H, m) | 657.9 | 657.3 |
| **389** | δ = 0.9(6H, m), 1.91(4H, m), 2.59(6H, s), 6.58∼6.63(5H, m), 6.75∼6.81(3H, m), 6.95(2H, m), 7.2(4H, m), 7.41(1H, m), 7.51∼7.56(7H, m), 7.62∼7.64(3H, m), 7.71(1H, m), 7.73(2H, s), 7.87(1H, m) | 671.9 | 671.4 |
| **394** | δ = 0.9(6H, m), 1.35(9H, s), 1.91(4H, m), 6.58∼6.63(5H, m), 6.75∼6.81(3H, m), 6.95(2H, m), 7.05(1H, m), 7.2(4H, m), 7.41(1H, m), 7.51∼7.56(7H, m), 7.62∼7.64(3H, m), 7.71∼7.77(2H, m), 7.87(1H, m), 8.08(1H, m) | 700.0 | 699.4 |
| **399** | δ = 0.9(6H, m), 1.91(4H, m), 6.58∼6.63(5H, m), 6.75∼6.81(3H, m), 6.95(2H, m), 7.2∼7.21(5H, m), 7.41(2H, m), 7.51∼7.56(7H, m), 7.62∼7.64(3H, m), 7.71∼7.79(6H, m), 7.87∼7.91(2H, m) | 720.0 | 719.4 |
| **404** | δ = 0.9(6H, m), 1.91(4H, m), 2.32(3H, s), 6.58∼6.63(5H, m), 6.75∼6.81(3H, m), 6.95(2H, m), 7.2(4H, m), 7.29∼7.35(2H, m), 7.41(1H, m), 7.51∼7.64(11H, m), 7.71(1H, m), 7.87(1H, m) | 657.9 | 657.3 |
| **409** | δ = 0.9(6H, m), 1.91(4H, m), 2.34(3H, s), 2.69(3H, s), 6.58∼6.63(5H, m), 6.75∼6.81(3H, m), 6.95(2H, m), 7.13(1H, m), 7.2(4H, m), 7.41(1H, m), 7.51∼7.56(6H, m), 7.62∼7.64(3H, m), 7.71(1H, m), 7.79(2H, m), 7.87(1H, m) | 671.9 | 671.4 |
| **414** | δ = 0.9(6H, m), 1.91(4H, m), 6.58∼6.63(5H, m), 6.75∼6.81(3H, m), 6.95(2H, m), 7.2∼7.21(5H, m), 7.41(2H, m), 7.51∼7.56(9H, m), 7.62∼7.64(3H, m), 7.71∼7.79(4H, m), 7.87∼7.91(2H, m) | 720.0 | 719.4 |
| **419** | δ = 0.9(6H, m), 1.91(4H, m), 2.34(3H, s), 6.58∼6.63(5H, m), 6.75∼6.81(3H, m), 6.95(2H, m), 7.2∼7.25(5H, m), 7.41(1H, m), 7.51∼7.56(5H, m), 7.62∼7.64(3H, m), 7.71∼7.87(6H, m) | 657.9 | 657.3 |
| **414** | δ = 0.9(6H, m), 1.91(4H, m), 2.59(6H, s), 6.58∼6.63(5H, m), 6.75∼6.81(3H, m), 6.95(2H, m), 7.13(2H, m), 7.2(4H, m), 7.41(1H, m), 7.51∼7.56(7H, m), 7.62∼7.64(3H, m), 7.71(1H, m), 7.87(1H, m) | 671.9 | 671.4 |
| **429** | δ = 0.9(6H, m), 1.91(4H, m), 6.58∼6.63(5H, m), 6.75∼6.81(3H, m), 6.95(2H, m), 7.2(4H, m), 7.41(2H, m), 7.51∼7.56(8H, m), 7.62∼7.64(3H, m), 7.71(1H, m), 7.79∼7.81(6H, m), 7.87(1H, m) | 720.0 | 719.4 |
| **434** | δ = 0.9(6H, m), 1.35(9H, s), 1.91(4H, m), 6.58∼6.63(5H, m), 6.75∼6.81(3H, m), 6.95(2H, m), 7.2∼7.21(5H, m), 7.37∼7.41(5H, m), 7.51∼7.56(7H, m), 7.62∼7.64(3H, m), 7.71∼7.76(2H, m), 7.87∼7.91(2H, m) | 776.1 | 775.4 |
| **439** | δ = 0.9(6H, m), 1.91(4H, m), 6.58∼6.63(5H, m), 6.75∼6.81(3H, m), 6.95(2H, m), 7.2(4H, m), 7.41(3H, m), 7.51∼7.56(13H, m), 7.62∼7.64(3H, m), 7.71(1H, m), 7.79(2H, m), 7.87(3H, m) | 796.0 | 795.4 |
| **444** | δ = 0.9(6H, m), 1.91(4H, m), 6.58∼6.63(5H, m), 6.75∼6.81(3H, m), 6.95∼7(3H, m), 7.2∼7.27(6H, m), 7.41(1H, m), 7.51∼7.56(8H, m), 7.62∼7.64(3H, m), 7.71(1H, m), 7.87(1H, m), 7.94(1H, m), 8.27(1H, m), 8.5(1H, m) | 720.9 | 720.4 |
| **449** | δ = 0.9(6H, m), 1.91(4H, m), 6.58∼6.63(5H, m), 6.75∼6.81(3H, m), 6.95(2H, m), 7.2(4H, m), 7.27(1H, m), 7.41∼7.42(2H, m), 7.49∼7.56(8H, m), 7.62∼7.71(6H, m), 7.87∼7.94(3H, m), 8.27(1H, m), 8.88(1H, m) | 771.0 | 770.4 |
| **454** | δ = 0.9(6H, m), 1.91(4H, m), 6.58∼6.63(5H, m), 6.75∼6.81(3H, m), 6.95(2H, m), 7.2∼7.25(9H, m), 7.41(2H, m), 7.51∼7.56(11H, m), 7.62∼7.64(3H, m), 7.71∼7.76(2H, m), 7.87∼7.91(2H, m) | 796.0 | 795.4 |
| **459** | δ = 0.9(6H, m), 1.91(4H, m), 6.58∼6.63(5H, m), 6.75∼6.81(3H, m), 6.95(2H, m), 7.2∼7.21(5H, m), 7.41(1H, m), 7.51∼7.56(13H, m), 7.71∼7.76(3H, m), 7.87∼7.92(3H, m), 8(2H, m) | 770.0 | 769.4 |
| **464** | δ = 0.9(6H, m), 1.91(4H, m), 6.58∼6.63(5H, m), 6.75∼6.81(3H, m), 6.95(2H. m), 7.2∼7.21(5H, m), 7.41(1H, m), 7.51∼7.56(7H, m), 7.62∼7.64(3H, m), 7.71∼7.77(3H, m), 7.87∼7.91(2H, m), 9.3(1H, m). 9.46(1H, m) | 721.9 | 721.3 |
| **469** | δ = 0.9(6H, m), 1.91(4H, m), 3.18(4H, m), 3.65(4H, m), 6.58∼6.63(5H, m), 6.75∼6.81(4H, m), 6.95(2H, m), 7.08(1H, m), 7.2(4H, m), 7.41(1H, m), 7.51∼7.56(5H, m), 7.62∼7.71(5H, m), 7.79(2H, m), 7.87(1H, m) | 729.0 | 728.4 |
| **474** | δ = 0.9(6H, m), 1.91(4H, m), 6.58∼6.63(5H, m), 6.75∼6.81(3H, m), 6.95(2H, m), 7.2(4H, m), 7.41∼7.56(12H, m), 7.62∼7.64(3H, m), 7.71(1H, m), 7.79∼7.87(9H, m) | 796.0 | 795.4 |
| **479** | δ = 0.9(6H, m), 1.91(4H, m), 6.58∼6.63(5H, m), 6.75∼6.81(3H, m), 6.95(2H, m), 7.2(4H, m), 7.37(6H, m), 7.41(1H, m), 7.46(6H, m), 7.48∼7.55(13H, m), 7.71(1H, m), 7.79(2H, m), 7.87(1H, m), 7.95(1H, m) | 902.2 | 901.4 |
| **484** | δ = 0.9(6H, m), 1.91(4H, m), 6.58∼6.63(5H, m), 6.75∼6.81(3H, m), 6.95(2H, m), 7.1(1H, m), 7.2(4H, m), 7.41∼7.42(2H, m), 7.49∼7.56(7H, m), 7.62∼7.64(4H, m), 7.71(1H, m), 7.79(2H, m), 7.87∼7.92(3H, m), 8.32(1H, m), 8.42(1H, m) | 771.0 | 770.4 |
| **490** | δ = 0.9(6H, m), 1.91(4H, m), 6.58∼6.63(5H, m), 6.75∼6.81(3H, m), 6.95(2H, m), 7.14(1H, m), 7.2∼7.21(5H, m), 7.32∼7.41(3H, m), 7.51∼7.56(7H, m), 7.62∼7.76(6H, m), 7.87∼7.91(3H, m) | 760.0 | 759.4 |
| **494** | δ = 0.9(6H, m), 1.91(4H, m), 6.58∼6.63(5H, m), 6.75∼6.81(3H, m), 6.95(2H, m), 7.2∼7.33(7H, m), 7.41(1H, m), 7.5∼7.56(8H, m), 7.62∼7.64(4H, m), 7.71∼7.75(3H, m), 7.87∼7.88(2H, m), 7.94(1H, m), 8.12(1H, m), 8.55(1H, m) | 809.0 | 808.4 |
| **499** | δ = 0.9(6H, m), 1.51(4H, m), 1.91(4H, m), 2.09(4H, m), 6.58∼6.63(5H, m), 6.75∼6.81(3H, m), 6.95(2H, m), 7.2∼7.21(5H, m), 7.28(1H, m), 7.38∼7.41(2H, m), 7.51∼7.56(8H, m), 7.62∼7.64(4H, m), 7.71∼7.77(3H, m), 7.87∼7.93(4H, m) | 862.1 | 861.4 |
| **514** | δ = 0.9(6H, m), 1.91(4H, m), 6.58~6.63(5H, m), 6.75~6.81(3H, m), 6.95(2H, m), 7.2~7.24(5H, m), 7.35(1H, m), 7.41(1H, m), 7.51~7.64(11H, m), 7.71(1H, m), 7.79~7.81(2H, m), 7.87(1H, m), 8.06~8.1(2H, m), 8.38~8.42(2H, m), 8.83(1H, m) | 822.0 | 821.4 |
| **509** | δ = 0.9(6H, m), 1.91(4H, m), 6.58~6.63(5H, m), 6.75∼6.81(3H, m), 6.95(2H, m), 7.2~7.21(5H, m), 7.41(1H, m), 7.5∼7.56(9H, m), 7.62∼7.64(3H, m), 7.7~7.79(4H, m), 7.87∼7.91(2H, m), 7.98(1H, m) | 776.0 | 775.3 |
| **514** | δ = 0.9(6H, m), 1.91(4H, m), 6.58~6.63(5H, m), 6.75∼6.81(3H, m), 6.95(2H, m), 7.2∼7.21(5H, m), 7.41(1H, m), 7.51∼7.64(11H, m), 7.71∼7.8(4H, m), 7.87∼7.96(4H, m), 8.1(2H, m), 8.42(2H, m) | 844.1 | 843.4 |
| **519** | δ = 0.9(6H, m), 1.91(4H, m), 3.49(4H, s), 6.58∼6.63(5H, m), 6.75∼6.81(3H, m), 6.95(2H, m), 7.2~7.21(9H, m), 7.28(1H, m), 7.38~7.41(2H, m), 7.51∼7.56(8H, m), 7.62∼7.64(4H, m), 7.71∼7.77(3H, m), 7.87∼7.93(4H, m) | 910.2 | 909.4 |
| **524** | δ = 0.9(6H, m), 1.91(4H, m), 6.58∼6.63(5H, m), 6.75∼6.81(3H, m), 6.95(2H, m), 7.11(4H, m), 7.2∼7.41(13H, m), 7.51∼7.56(7H, m), 7.62∼7.64(4H, m), 7.71∼7.81(6H, m), 7.87∼7.93(3H, m) | 960.3 | 959.4 |
| **529** | δ = 0.9(6H, m), 1.91(4H, m), 3.52(4H, m), 6.58∼6.63(5H, m), 6.75∼6.81(3H, m), 6.95(2H, m), 7.2∼7.21(5H, m), 7.31(1H, m), 7.4∼7.51(12H, m), 7.62~7.64(3H, m), 7.71~7.76(2H, m), 7.87∼7.91(2H, m) | 796.0 | 795.4 |
| **534** | δ = 0.9(6H, m), 1.91(4H, m), 2.88(4H, m), 6.58∼6.63(8H, m), 6.75∼6.81(5H, m), 6.95(3H, m), 7.02~7.04 (4H, m), 7.2(4H, m), 7.41(1H, m), 7.51∼7.64(11H, m), 7.71(1H, m), 7.87(1H, m) | 837.1 | 836.4 |
| **539** | δ = 0.9(6H, m), 1.91(4H, m), 6.58~6.63(5H, m), 6.75∼6.81(3H, m), 6.95(2H, m), 7.2∼7.21(5H, m), 7.39∼7.41(7H, m), 7.51∼7.64(11H, m), 7.71∼7.76(2H, m), 7.87∼7.97(6H, m) | 894.1 | 893.4 |
| **544** | δ = 0.9(6H, m), 1.91(4H, m), 3.81(2H, s), 6.51(2H, m), 6.58∼6.63(5H, m), 6.69∼6.81(6H, m), 6.95∼7.01(6H, m), 7.2(4H, m), 7.41∼7.56(10H, m), 7.62∼7.64(3H, m), 7.71(1H, m), 7.87(1H, m) | 823.1 | 822.4 |
| **549** | δ = 0.9(6H, m), 1.91(4H, m), 6.58∼6.63(7H, m), 6.75∼6.81(6H, m), 6.89∼6.95(6H, m), 7.2(4H, m), 7.41∼7.56(10H, m), 7.62∼7.64(3H, m), 7.71(1H, m), 7.87(1H, m) | 825.0 | 824.4 |
| **554** | δ = 0.9(6H, m), 1.91(4H, m), 3.52(4H, m), 6.58∼6.63(5H, m), 6.75∼6.81(3H, m), 6.95(2H, m), 7.2(4H, m), 7.31(1H, m), 7.4∼7.56(11H, m), 7.62∼7.64(3H, m), 7.71(1H, m), 7.79∼7.81(4H, m), 7.87(1H, m) | 796.0 | 795.4 |
| **559** | δ = 0.9(6H, m), 1.91(4H, m), 2.88(4H, m), 6.58∼6.65(8H, m), 6.75∼6.81(5H, m), 6.95(2H, m), 7.02∼7.04(4H, m), 7.2∼7.21(5H, m), 7.4∼7.41(2H, m), 7.51∼7.56(5H, m), 7.62∼7.64(3H, m), 7.71(1H m), 7.79(2H, m), 7.87(1H, m) | 837.1 | 836.4 |
| **563** | δ = 0.9(6H, m), 1.91(4H, m), 6.58∼6.65(6H, m), 6.75∼6.81(3H, m), 6.95∼6.97(4H, m), 7.16∼7.21(11H, m), 7.4∼7.41(2H, m), 7.51∼7.56(5H, m), 7.62∼7.64(3H, m), 7.71(1H, m), 7.79(2H, m), 7.87(1H, m) | 841.1 | 840.4 |

### [Example 1] Manufacture of OLED by using the organic electroluminescent compound of the invention

An OLED device was manufactured by using an electroluminescent material according to the invention.

First, a transparent electrode ITO thin film (15 Ω/□) (2) prepared from glass for OLED (1) (manufactured by Samsung-Corning) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) (of which the structure is shown below) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injecting layer (3) having 60 nm of thickness on the ITO substrate.

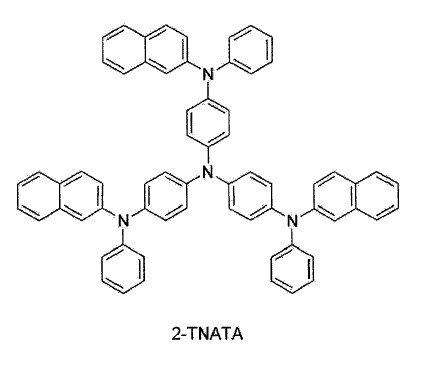

Then, to another cell of the vacuum vapor-deposit device, charged was N,N'-bis(α-naphthyl)-N,N'-diphenyl-4,4'-diamine (NPB) (of which the structure is shown below), and electric current was applied to the cell to evaporate NPB, thereby providing vapor-deposit of a hole transport layer (4) with 20 nm of thickness on the hole injecting layer.

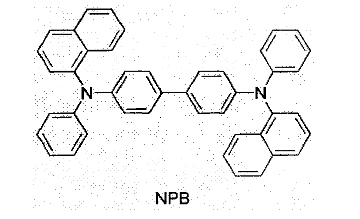

After forming the hole injecting layer and the hole transport layer, an electroluminescent layer was vapor-deposited as follows. To one cell of a vacuum vapor-deposit device, charged was dinaphthylanthracene (DNA) (of which the structure is shown below) as host, and a compound according to the invention (Compound 436) was charged to another cell as dopant. An electroluminescent layer (5) was vapor-deposited with a thickness of 30 nm on the hole transport layer at the vapor-deposition rate of 100:1.

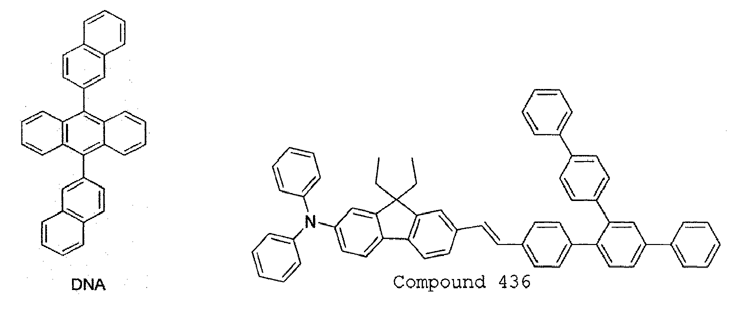

Then, tris(8-hydroxyquinoline)aluminum (III) (Alq) (of which the structure is shown below) was vapor-deposited as an electron transport layer (6) with a thickness of 20 nm, and lithium quinolate (Liq) (of which the structure shown below) was vapor-deposited as an electron injecting layer (7) with a thickness of 1 to 2 nm. Thereafter, an Al cathode (8) was vapor-deposited with a thickness of 150 nm by using another vacuum vapor-deposit device to manufacture an OLED.

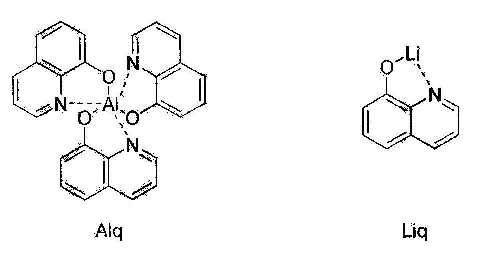

Each material employed for manufacturing an OLED was used as the electroluminescent material after purifying via vacuum sublimation at 10⁻⁶ torr.

### [Comparative Example 1] Manufacture of an OLED by using conventional electroluminescent compound

After forming a hole injecting layer and a hole transport layer according to the same procedure as described in Example 1, dinaphthylanthracene (DNA) was charged to another cell of said vacuum vapor-deposit device as blue electroluminescent material, while Compound (A) (of which the structure is shown below) was charged to still another cell as blue electroluminescent material. An electroluminescent layer was vapor-deposited with a thickness of 30 nm on the hole transport layer, at the vapor-deposition rate of 100:1.

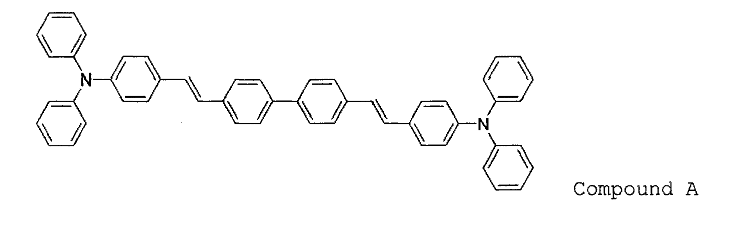

Then, an electron transport layer and an electron injecting layer were vapor-deposited according to the same procedures as in Example 1, and Al cathode was vapor-deposited by using another vacuum vapor-deposit device with a thickness of 150 nm, to manufacture an OLED.

### [Comparative Example 2] Manufacture of an OLED by using conventional electroluminescent compound

After forming a hole injecting layer and a hole transport layer according to the same procedure as described in Example 1, dinaphthylanthracene (DNA) was charged to another cell of said vacuum vapor-deposit device as blue electroluminescent material, while Compound (B) (of which the structure is shown below) was charged to still another cell as blue electroluminescent material. An electroluminescent layer was vapor-deposited with a thickness of 30 nm on the hole transport layer, at the vapor-deposition rate of 100:1.

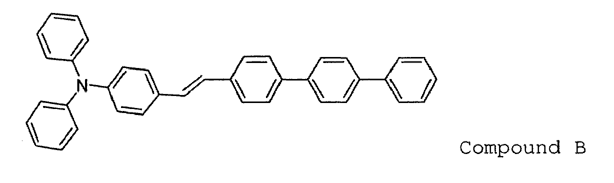

Then, an electron transport layer and an electron injecting layer were vapor-deposited according to the same procedures as in Example 1, and Al cathode was vapor-deposited by using another vacuum vapor-deposit device with a thickness of 150 nm, to manufacture an OLED.

### [Example 2] Electroluminescent properties of OLED's manufactured

The luminous efficiencies of the OLED's comprising the organic electroluminescent compounds according to the present invention (Example 1) or conventional electroluminescent compound (Comparative Examples 1 and 2) were measured at 1,000 cd/m², respectively, and the results are shown in Table 2.

**Table 2**

| No. | EL material 1 | EL material 2 | Luminous efficiency (cd/A) | Color |
|---|---|---|---|---|
| 1 | DNA | Compound **10** | 6.0 | Blue |
| 2 | DNA | Compound **23** | 6.7 | Blue |
| 3 | DNA | Compound **213** | 5.8 | Blue |
| 4 | DNA | Compound **436** | 7.3 | Blue |
| 5 | H-33 | Compound **49** | 6.4 | Blue |
| 6 | H-33 | Compound **60** | 6.1 | Blue |
| 7 | H-33 | Compound **139** | 5.7 | Blue |
| 8 | H-56 | Compound **25** | 6.5 | Blue |
| 9 | H-56 | Compound **55** | 6.6 | Blue |
| 10 | H-56 | Compound **335** | 7.2 | Blue |
| 11 | H-56 | Compound **558** | 7.1 | Blue |
| 12 | H-65 | Compound **12** | 6.3 | Blue |
| 13 | H-65 | Compound **220** | 6.2 | Blue |
| 14 | H-65 | Compound **429** | 5.9 | Blue |
| Comp.1 | DNA | Compound A | 5.3 | Jade green |
| Comp.2 | DNA | Compound B | 5.0 | Jade green |

As can be seen from Table 2, the organic electroluminescent compounds according to the present invention are able to realize higher efficiency and better color purity as compared to conventional electroluminescent compounds. Particularly, Compound (437) showed at least 20% improvement as compared to conventional electroluminescent compounds. It is described that a bulky substituent (preferably a substituent having steric hindrance on the middle phenyl of the terphenyl) bonded to fluorene through a double bond provides effect of shortening the conjugation length between phenyls, so that the electroluminescent color shifts to more pure blue while maintaining the luminous efficiency of the device. In particular, this effect can be further weighted by introducing substituent(s) on the middle phenyl of the terphenyl.

Accordingly, the organic electroluminescent compounds according to the present invention can be used as blue electroluminescent material of high efficiency with noticeable advantages in view of luminance, power consumption and device life as compared to conventional full-colored OLED's.

## Claims

1. An organic electroluminescent compound represented by Chemical Formula (1): 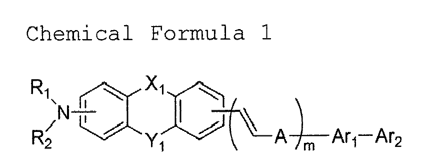 wherein,
A represents a chemical bond, (C6-C60)arylene or (C2-C60)heteroarylene;
Ar₁ represents (C6-C40)arylene, (C2-C40)heteroarylene or 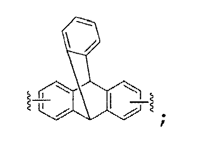 Ar₂ represents hydrogen, (C1-C20)alkyl, (C6-C20)aryl, (C2-C20)heteroaryl, (C2-C20)alkenyl, (C2-C20)alkynyl, (C3-C20)cycloalkyl or 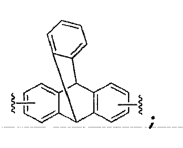 R₁ and R₂ independently represent (C1-C60)alkyl, (C6-C60)aryl, (C2-C60)heteroaryl, morpholino, thiomorpholino, piperidino, 5- or 6-membered heterocycloalkyl containing one or more heteroatom(s) selected from N, O and S, (C3-C60)cycloalkyl or adamantyl, or they may be linked via (C3-C60)alkylene or (C3-C60)alkenylene with or without a fused ring to form a fused ring, and the carbon atom of the alkylene may be substituted by O, S or NR₃;
R₃ represents hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, (C1-C60)trialkylsilyl, di(C1-C60)alkyl(C6-C60)arylsilyl or tri(C6-C60)arylsilyl;
X₁ and Y₁ independently represent a chemical bond, -(CR₄R₅)ₙ-, -N(R₆)-, -Si(R₇)(R₈) -O-, -S-, -Se- or -(R₉)C=C(R₁₀)-;
R₄ through R₁₀ independently represent hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, tri(C1-C60)alkylsilyl, di(C1-C60)alkyl(C6-C60)arylsilyl or tri(C6-C60)arylsilyl, or R₄ and R₅, R₇ and R₈, and R₉ and R₁₀ are linked via (C3-C12) alkylene or (C3-C12)alkenylene with or without a fused ring to form a fused ring;
the arylene or heteroarylene of A and Ar₁; the alkyl, aryl, heteroaryl, alkenyl, alkynyl, cycloalkyl of Ar₂; or the alkyl, aryl, heteroaryl, heterocycloalkyl, cycloalkyl or adamantyl of R₁ through R₁₀ may be further substituted by one or more substituent(s) selected from (C1-C60)alkyl, halo(C1-C60)alkyl, (C1-C60)alkoxy, piperidino, morpholino, thiomorpholino, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, (C1-C60)alkyl(C6-C60)aryl, tri(C1-C60)alkylsilyl, di(C1-C60)alkyl(C6-C60)arylsilyl, tri(C6-C60)arylsilyl, and substituent(s) represented by one of the following structural formulas: 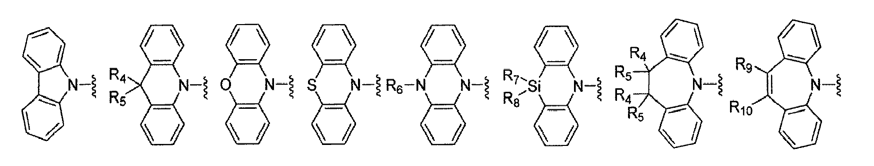 m is an integer from 1 to 3; and
n is an integer from 1 to 4;
provided that total number of carbon atoms in 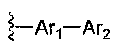 is from 19 to 60.

2. The organic electroluminescent compound according to claim 1, which is represented by Chemical Formula (2): 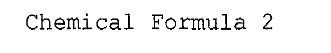 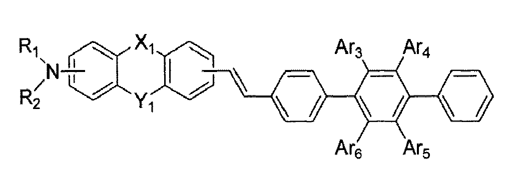 wherein, R₁, R₂, X₁ and Y₁ are defined as in claim 1; and
Ar₃ through Ar₆ independently represent hydrogen, (C1-C60) alkyl, halo(C1-C60)alkyl, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, (C1-C60)alkyl(C6-C60)aryl, tri(C1-C60)alkylsilyl, di(C1-C60)alkyl(C6-C60)arylsilyl or tri(C6-C60)arylsilyl, or a substituent selected from the following structures, excluding the case wherein Ar₃ through Ar₆ are hydrogen all at the same time: 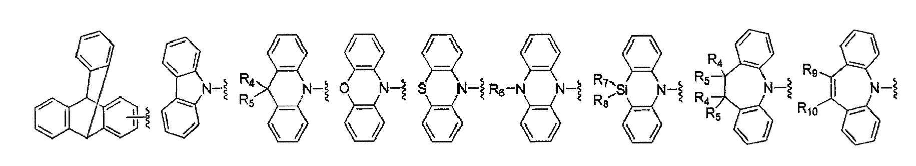 wherein, R₄ through R₁₀ are defined as in claim 1.

3. The organic electroluminescent compound according to claim 1, wherein A represents a chemical bond, or arylene or heteroarylene selected from the following structures: 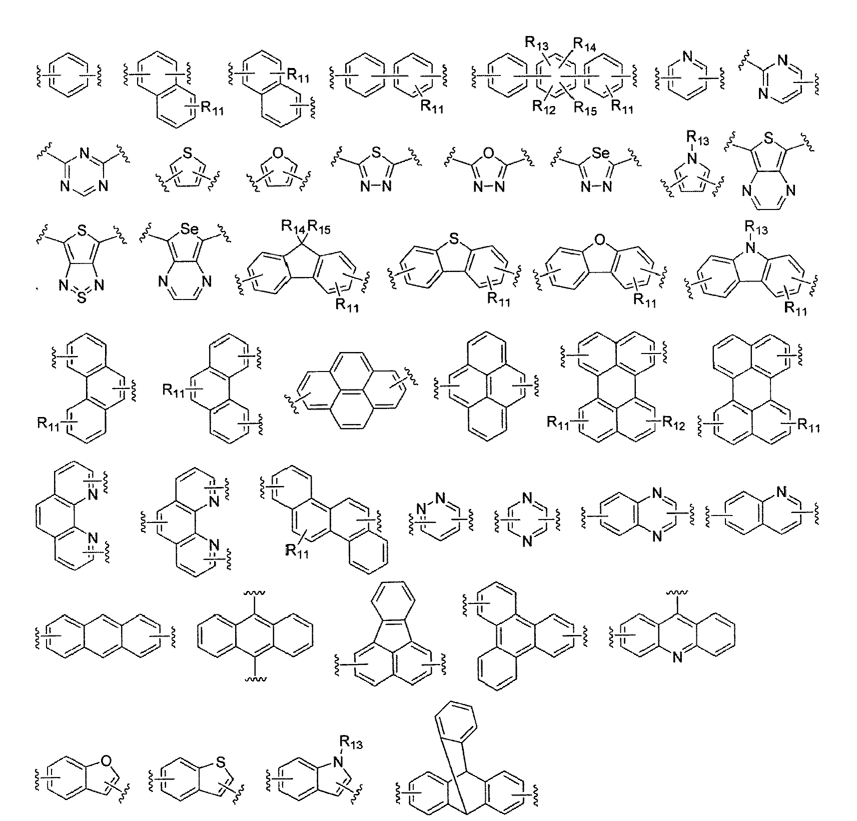 wherein, R₁₁ through R₁₅ independently represent hydrogen, (C1-C60)alkyl, halo(C1-C60)alkyl, (C1-C60)alkoxy, piperidino, morpholino, thiomorpholino, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(Cl-C60)alkyl, tri(C1-C60)alkylsilyl, di(C1-C60)alkyl(C6-C60)arylsilyl or tri(C6-C60)arylsilyl, or a substituent selected from the following structures, 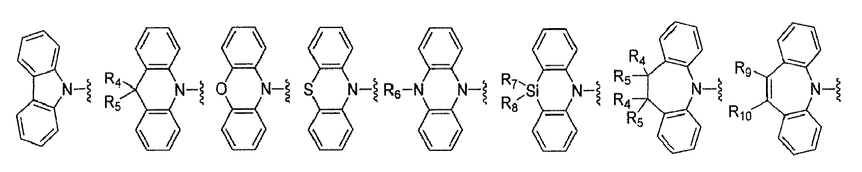 wherein, R₄ through R₁₀ are defined as in claim 1.

4. The organic electroluminescent compound according to claim 1, wherein the group 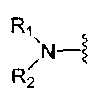 is selected from the following structures: 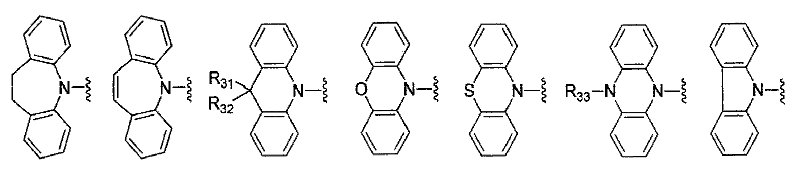 wherein, R₃₁ through R₃₃ independently represent hydrogen, (C1-C60)alkyl or (C6-C60)aryl, or R₃₁ and R₃₂ may be linked via (C3-C12)alkylene or (C3-C12)alkenylene with or without a fused ring to form a fused ring.

5. An organic electroluminescent device which is comprised of a first electrode; a second electrode; and at least one organic layer(s) interposed between the first electrode and the second electrode; wherein the organic layer comprises an organic electroluminescent compound represented by Chemical Formula (1): 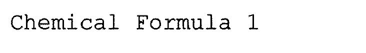 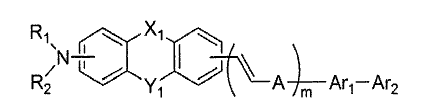 wherein,
A represents a chemical bond, (C6-C60)arylene or (C2-C60)heteroarylene;
Ar₁ represents (C6-C40)arylene, (C2-C40)heteroarylene or 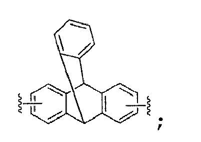 Ar₂ represents hydrogen, (C1-C20)alkyl, (C6-C20)aryl, (C2-C20)heteroaryl, (C2-C20)alkenyl, (C2-C20)alkynyl, (C3-C20)cycloalkyl or 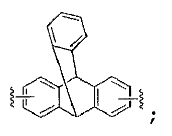 R₁ and R₂ independently represent (C1-C60)alkyl, (C6-C60)aryl, (C2-C60)heteroaryl, morpholino, thiomorpholino, piperidino, 5- or 6-membered heterocycloalkyl containing one or more heteroatom(s) selected from N, O and S, (C3-C60)cycloalkyl or adamantyl, or they may be linked via (C3-C60)alkylene or (C3-C60)alkenylene with or without a fused ring to form a fused ring, and the carbon atom of the alkylene may be substituted by O, S or NR₃;
R₃ represents hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, (C1-C60)trialkylsilyl, di(C1-C60)alkyl(C6-C60)arylsilyl or tri(C6-C60)arylsilyl;
X₁ and Y₁ independently represent a chemical bond, - (CR₄R₅)n-, -N(R₆)-, -Si(R₇)(R₈)-, -0-, -S-, -Se- or - (R₉)C=C(R₁₀)-;
R₄ through R₁₀ independently represent hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, tri(C1-C60)alkylsilyl, di(C1-C60)alkyl(C6-C60)arylsilyl or tri(C6-C60)arylsilyl, or R₄ and R₅, R₇ and R₈, and R₉ and R₁₀ are linked via (C3-C12)alkylene or (C3-C12)alkenylene with or without a fused ring to form a fused ring;
the arylene or heteroarylene of A and Ar₁; the alkyl, aryl, heteroaryl, alkenyl, alkynyl, cycloalkyl of Ar₂; or the alkyl, aryl, heteroaryl, heterocycloalkyl, cycloalkyl or adamantyl of R₁ through R₁₀ may be further substituted by one or more substituent(s) selected from (C1-C60)alkyl, halo(C1-C60)alkyl, (C1-C60)alkoxy, piperidino, morpholino, thiomorpholino, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, (C1-C60)alkyl(C6-C60)aryl, tri(C1-C60)alkylsilyl, di(C1-C60)alkyl(C6-C60)arylsilyl, tri(C6-C60)arylsilyl, and substituent(s) represented by one of the following structural formulas: 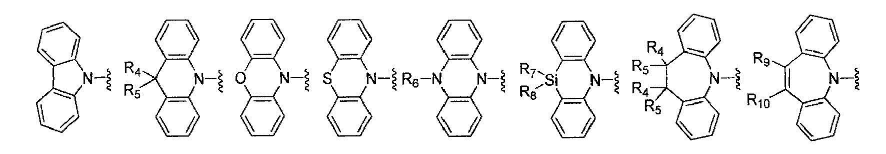 m is an integer from 1 to 3; and
n is an integer from 1 to 4;
provided that total number of carbon atoms in 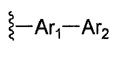 is from 19 to 60 and one or more host(s) selected from the compounds represented by Chemical Formula (3) or (4):
(Ar₁₁)ₐ-L₁-(Ar₁₂)_{b} Chemical Formula 3
(Ar₁₃)_{c}-L₂-(Ar₁₄)_{d} Chemical Formula 4
wherein, L₁ represents (C6-C60)arylene or (C4-C60)heteroarylene;
L₂ represents anthracenylene;
Ar₁₁ through Ar₁₄ are independently selected from hydrogen, (C1-C60)alkyl, (C1-C60)alkoxy, halogen, (C4-C60)heteroaryl, (C5-C60)cycloalkyl and (C6-C60)aryl; the cycloalkyl, aryl or heteroaryl of Ar₁₁ through Ar₁₄ may be further substituted by one or more substituent(s) selected from a group consisting of (C6-C60)aryl or (C4-C60)heteroaryl with or without one or more substituent(s) selected from a group consisting of (C1-C60)alkyl, halo(C1-C60)alkyl, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
a, b, c and d independently represent an integer from 0 to 4.

6. The organic electroluminescent device according to claim 5, wherein the organic layer further comprises one or more compound(s) selected from a group consisting of arylamine compounds and styrylarylamine compounds; or one or more metal(s) selected from a group consisting of organometals of Group 1, Group 2, 4^{th} period and 5^{th} period transition metals, lanthanide metals and d-transition elements in the Periodic Table of Elements.

7. The organic electroluminescent device according to claim 5, wherein the organic layer comprises an electroluminescent layer and a charge generating layer.

8. A white electroluminescent device comprising an organic electroluminescent compound represented by Chemical Formula (1) : 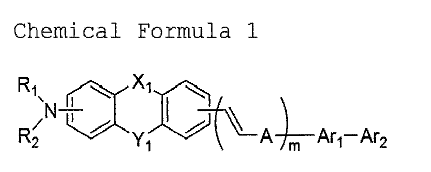 wherein,
A represents a chemical bond, (C6-C60)arylene or (C2-C60)heteroarylene;
Ar₁ represents (C6-C40)arylene, (C2-C40)heteroarylene or 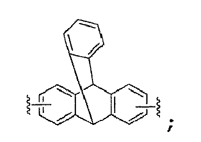 Ar₂ represents hydrogen, (C1-C20)alkyl, (C6-C20)aryl, (C2-C20)heteroaryl, (C2-C20)alkenyl, (C2-C20)alkynyl, (C3-C20)cycloalkyl or 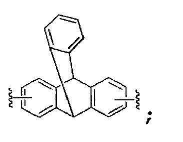 R₁ and R₂ independently represent (C1-C60)alkyl, (C6-C60)aryl, (C2-C60)heteroaryl, morpholino, thiomorpholino, piperidino, 5- or 6-membered heterocycloalkyl containing one or more heteroatom(s) selected from N, O and S, (C3-C60)cycloalkyl or adamantyl, or they may be linked via (C3-C60)alkylene or (C3-C60)alkenylene with or without a fused ring to form a fused ring, and the carbon atom of the alkylene may be substituted by O, S or NR₃;
R₃ represents hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, (C1-C60)trialkylsilyl, di(C1-C60)alkyl(C6-C60)arylsilyl or tri(C6-C60)arylsilyl;
X₁ and Y₁ independently represent a chemical bond, -(CR₄R₅)ₙ-, -N(R₆)-, -Si(R₇)(R₈) -O-, -S-, -Se- or -(R₉)C=C(R₁₀)-;
R₄ through R₁₀ independently represent hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, tri(C1-C60)alkylsilyl, di(C1-C60)alkyl(C6-C60)arylsilyl or tri(C6-C60)arylsilyl, or R₄ and R₅, R₇ and R₈, and R₉ and R₁₀ are linked via (C3-C12) alkylene or (C3-C12)alkenylene with or without a fused ring to form a fused ring;
the arylene or heteroarylene of A and Ar₁; the alkyl, aryl, heteroaryl, alkenyl, alkynyl, cycloalkyl of Ar₂; or the alkyl, aryl, heteroaryl, heterocycloalkyl, cycloalkyl or adamantyl of R₁ through R₁₀ may be further substituted by one or more substituent(s) selected from (C1-C60)alkyl, halo(C1-C60)alkyl, (C1-C60)alkoxy, piperidino, morpholino, thiomorpholino, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, (C1-C60)alkyl(C6-C60)aryl, tri(C1-C60)alkylsilyl, di(C1-C60)alkyl(C6-C60)arylsilyl, tri(C6-C60)arylsilyl, and substituent(s) represented by one of the following structural formulas: 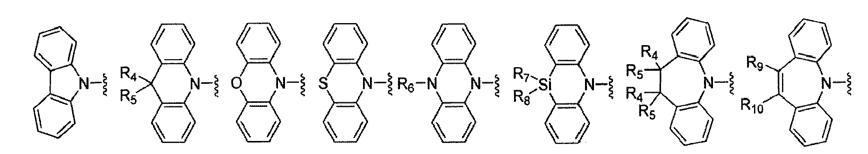 m is an integer from 1 to 3; and
n is an integer from 1 to 4;
provided that total number of carbon atoms in 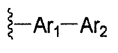 is from 19 to 60.

9. An organic solar cell which comprises an organic electroluminescent compound represented by Chemical Formula (1): 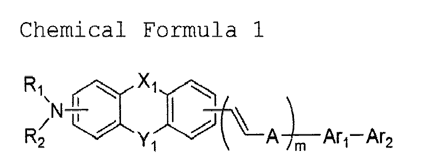 wherein,
A represents a chemical bond, (C6-C60)arylene or (C2-C60)heteroarylene;
Ar₁ represents (C6-C40)arylene, (C2-C40)heteroarylene or 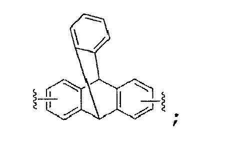 Ar₂ represents hydrogen, (C1-C20)alkyl, (C6-C20) aryl, (C2-C20)heteroaryl, (C2-C20)alkenyl, (C2-C20)alkynyl, (C3-C20)cycloalkyl or 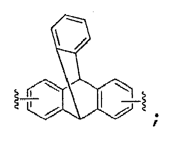 R₁ and R₂ independently represent (C1-C60)alkyl, (C6-C60)aryl, (C2-C60)heteroaryl, morpholino, thiomorpholino, piperidino, 5- or 6-membered heterocycloalkyl containing one or more heteroatom(s) selected from N, O and S, (C3-C60)cycloalkyl or adamantyl, or they may be linked via (C3-C60)alkylene or (C3-C60)alkenylene with or without a fused ring to form a fused ring, and the carbon atom of the alkylene may be substituted by O, S or NR₃;
R₃ represents hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, (C1-C60)trialkylsilyl, di(C1-C60)alkyl(C6-C60)arylsilyl or tri(C6-C60)arylsilyl;
X₁ and Y₁ independently represent a chemical bond, -(CR₄R₅)ₙ-, -N(R₆)-, -Si(R₇)(R₈)-, -O-, -S-, -Se- or -(R₉)C=C(R₁₀)-;
R₄ through R₁₀ independently represent hydrogen, (C1-C60)alkyl, halo(C1-C60)alkyl, (C1-C60)alkoxy, morpholino, thiomorpholino, piperidino, 5- or 6-membered heterocycloalkyl containing one or more heteroatom(s) selected from N, O and S, (C3-C60)cycloalkyl, adamantyl, halogen, cyano, (C6-C60)aryl, (C2-C60)heteroaryl, tri(C1-C60)alkylsilyl, di(C1-C60)alkyl(C6-C60)arylsilyl or tri(C6-C60)arylsilyl, or R₄ and R₅, R₇ and R₈, and R₉ and R₁₀ are linked via (C3-C12)alkylene or (C3-C12)alkenylene with or without a fused ring to form a fused ring;
the arylene or heteroarylene of A and Ar₁; the alkyl, aryl, heteroaryl, alkenyl, alkynyl, cycloalkyl of Ar₂; or the alkyl, aryl, heteroaryl, heterocycloalkyl, cycloalkyl or adamantyl of R₁ through R₁₀ may be further substituted by one or more substituent(s) selected from (C1-C60)alkyl, halo(C1-C60)alkyl, (C1-C60)alkoxy, piperidino, morpholino, thiomorpholino, 5- or 6-membered heterocycloalkyl containing one or more heteroatom(s) selected from N, O and S, (C3-C60)cycloalkyl, halogen, cyano, (C6-C60)aryl, (C2-C60)heteroaryl, (C6-C60)ar(C1-C60)alkyl, (C1-C60)alkyl(C6-C60)aryl, tri(C1-C60)alkylsilyl, di(C1-C60)alkyl(C6-C60)arylsilyl, tri(C6-C60)arylsilyl, and substituent(s) represented by one of the following structural formulas: 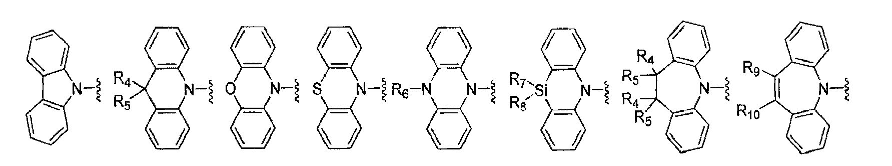 m is an integer from 1 to 3; and
n is an integer from 1 to 4;
provided that total number of carbon atoms in 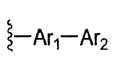 is
from 19 to 60.
